# EUROPEAN PATENT SPECIFICATION

(11) **EP 4 274 402 B1**
(45) Date of publication and mention of the grant of the patent: **02.04.2025**
(21) Application number: 23170790.2
(22) Date of filing: 28.04.2023
(51) Int. Cl.: H10K 50/125

(54) **LIGHT-EMITTING DEVICE AND ELECTRONIC APPARATUS INCLUDING THE SAME**
LICHTEMITTIERENDE VORRICHTUNG UND ELEKTRONISCHE VORRICHTUNG DAMIT
DISPOSITIF ÉLECTROLUMINESCENT ET APPAREIL ÉLECTRONIQUE LE COMPRENANT

(30) Priority: 02.05.2022 KR 20220054438
(43) Date of publication of application: 08.11.2023
(73) Proprietor: Samsung Display Co., Ltd., Yongin-si, Gyeonggi-do 17113 (KR)
(72) Inventor: KIM, Hyerim, Yongin-si, Gyeonggi-do 17113 (KR); KIM, Mikyung, Yongin-si, Gyeonggi-do 17113 (KR); SEO, Jihyun, Yongin-si, Gyeonggi-do 17113 (KR); SHIN, Hyunsu, Yongin-si, Gyeonggi-do 17113 (KR); JANG, Hanbyul, Yongin-si, Gyeonggi-do 17113 (KR)
(74) Representative: Gulde & Partner

(56) References cited:
- WO-A1-2013/112557
- US-A1- 2009 295 278
- US-A1- 2010 314 612
- US-A1- 2013 175 510
- US-A1- 2015 076 483
- US-A1- 2019 031 673
- US-A1- 2019 036 055
- US-B1- 8 692 242

## Description

### BACKGROUND

### 1. Field

One or more embodiments of the present disclosure relate to a light-emitting device and an electronic apparatus including the light-emitting device.

### 2. Description of the Related Art

From among light-emitting devices, organic light-emitting devices are self-emissive devices that have wide viewing angles, high contrast ratios, short response times, and excellent characteristics in terms of luminance, driving voltage, and response speed.

In an example, an organic light-emitting device may have a structure in which a first electrode is on a substrate, and a hole transport region, an emission layer, an electron transport region, and a second electrode are sequentially formed on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition from an excited state to a ground state, thereby generating light. For example, US 2010/314612 A1 discloses a white organic light-emitting device including an anode, a hole transport layer, a first light-emitting layer, a second light-emitting layer, a third light-emitting layer, an electron transport layer and a cathode, wherein the second light-emitting layer is formed between the first and the third light-emitting layers, the emission wavelength of the second light-emitting layer is longer than that of the first and third light-emitting layers, and the host material of the first and third light-emitting layer are different. US 2009/295278 A1 describes an organic light-emitting laminate for use in an organic electroluminescent device, comprising a first light-emitting layer, including a first main light-emitting material and a first phosphorescent material, a second light-emitting layer, including a second main light-emitting material and a second phosphorescent material, formed on the first light-emitting layer, and a carrier-transporting material, which is included in at least one of the first light-emitting layer and the second light-emitting layer. US 8,692,242 B1 relates to a candlelight-like light organic light-emitting device, comprising: a first conductive layer, a hole injection layer, a hole transport layer, a first host light-emitting layer, a second host light-emitting layer, an electron transport layer, an electron injection layer, and a second conductive layer. US 2019/0031673 A1 discloses organic compounds which have a furopyrazine skeleton, including naphthofuropyrazine, which can be used in an EL layer of a light-emitting element. US 2013/0175510 A1 describes triphenylene containing benzo-fused thiophene compounds and triphenylene containing benzo-fused furan compounds which are useful in organic light emitting devices, particularly as hosts in the emissive layer of such devices. WO 2013/112557 A1 discloses an OLED including an emissive layer disposed between a cathode and an anode where the emissive layer includes a multicomponent host material and a phosphorescent emitter material.

### SUMMARY

The invention is defined in the appended claims. One or more embodiments include a light-emitting device having improved efficiency and lifespan and an electronic apparatus including the light-emitting device.

Additional aspects will be set forth in part in the description which follows and, in part, will be apparent from the description, or may be learned by practice of the presented embodiments of the disclosure.

According an aspect of the present invention, there is provided a light-emitting device including:
a first electrode,
a second electrode facing the first electrode, and
an interlayer between the first electrode and the second electrode and including an emission layer,
wherein the emission layer may include i) a first compound, a second compound, and a third compound, and
ii) a first organometallic compound and a second organometallic compound,
the first compound to the third compound may be different from each other,
the first organometallic compound and the second organometallic compound may each independently include at least one transition metal,
the first organometallic compound and the second organometallic compound may be different from each other,
the first compound, the second compound, the third compound, the first organometallic compound and the second organometallic compound are codeposited;and
a difference between an absolute value of a highest occupied molecular orbital (HOMO) energy level (eV) of the second compound and an absolute value of a HOMO energy level (eV) of the third compound may be 0.1 eV or more.

The HOMO energy level (eV) the HOMO energy level is evaluated by a density functional theory (DFT) method using a B3LYP approach with a 6-31G* basis set.

According to another aspect of the invention, there is provided an electronic apparatus including the above the light-emitting device.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic view of a light-emitting device according to an embodiment;
FIG. 2 is a schematic view of an electronic apparatus according to an embodiment;
FIG. 3 is a schematic view of an electronic apparatus according to another embodiment;
FIG. 4 is a schematic perspective view of an electronic apparatus including a light-emitting device, according to an embodiment;
FIG. 5 is a schematic view showing an exterior of a vehicle as an electronic apparatus including a light-emitting device, according to an embodiment; and
FIGS. 6A to 6C are each a schematic view showing an interior of a vehicle, according to various embodiments.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

It will be understood that although the terms "first," "second," and the like used herein may be used to describe various components, these components should not be limited by these terms. These terms are only used to distinguish one component from another.

As used herein, an expression used in the singular encompasses the expression of the plural, unless it has a clearly different meaning in the context.

It will be further understood that the terms such as "including", "having", and "comprising" used herein specify the presence of stated features or components, but do not preclude the presence or addition of one or more other features or components. For example, unless otherwise limited, terms such as "including" or "having" may refer to either consisting of features or components described in the specification only or further including other components.

As described herein, highest occupied molecular orbital (HOMO) energy levels (eV) and lowest unoccupied molecular orbital (LUMO) energy levels (eV) of a first compound to a third compound, a first organometallic compound, and a second organometallic compound and T1 energy levels (eV) of the first organometallic compound and the second organometallic compound may refer to values evaluated by (e.g., calculated utilizing) a density functional theory (DFT) method using a Becke-3-Lee Yang Parr (B3LYP) hybrid approach with a 6-31G* basis set. The DFT method may be performed utilizing the Gaussian program that is structurally optimized at a level of B3LYP, 6-31G(d,p). For example, the energy levels described herein may be obtained by performing structural optimization for the corresponding compound utilizing the DFT method where the hybrid functional B3LYP and 6-31G(d,p) basis set are utilized. The relevant calculations for the structural optimization may be performed utilizing any suitable software (e.g., any suitable computational chemistry software package) such as, for example, Gaussian software (e.g., Gaussian 03, Gaussian 09, or Gaussian 16). The Gaussian software is available from Gaussian, Inc., Wallingford, CT.

A light-emitting device includes: a first electrode; a second electrode facing the first electrode; and an interlayer between the first electrode and the second electrode and including an emission layer,
wherein the emission layer includes: i) a first compound, a second compound, and a third compound; and ii) a first organometallic compound and a second organometallic compound.

### First compound to third compound

The first compound to the third compound are different from each other.

A difference between an absolute value of the HOMO energy level (eV) of the second compound and an absolute value of the HOMO energy level (eV) of the third compound is 0.1 eV or more, preferably 0.15 eV or more, 0.2 eV or more, 0.25 eV or more, or 0.3 eV or more (e.g., 0.1 eV to 1.0 eV, 0.15 eV to 1.0 eV, 0.2 eV to 1.0 eV, 0.25 eV to 1.0 eV, or 0.3 eV to 1.0 eV).

In an embodiment, a band gap energy of the third compound may be greater than band gap energies of the first compound and the second compound. In this regard, term "band gap energy" refers to the difference between the HOMO energy level and the LUMO energy level of the compound. For example, the band gap energy of the first compound may refer to an energy difference between the HOMO energy level of the first compound and the LUMO energy level of the first compound.

In an embodiment, the band gap energy of the third compound may be 4.3 eV or more (e.g., 4.3 eV to 5.0 eV).

In an embodiment, the absolute value of the HOMO energy level (eV) of the first compound may be smaller than the absolute value of the HOMO energy level (eV) of the second compound.

In an embodiment, the absolute value of the HOMO energy level (eV) of the third compound may be i) greater than the absolute value of the HOMO energy level (eV) of the first compound and ii) greater than the absolute value of the HOMO energy level (eV) of the second compound.

In an embodiment, the absolute value of the HOMO energy level (eV) of the third compound may be greater than the absolute value of the HOMO energy levels (eV) of each of the first compound and the second compound.

In an embodiment, based on weight, an amount of the first compound may be greater than an amount of the second compound, and the amount of the second compound may be greater than an amount of the third compound.

In an embodiment, the amount of the first compound may be greater than each of the amounts of the second compound and the third compound, based on weight. In some embodiments, the amount of the first compound may be greater than a sum of the amounts of the second compound and the third compound, based on weight.

### First compound

In an embodiment, the first compound may include a group represented by Formula 3: 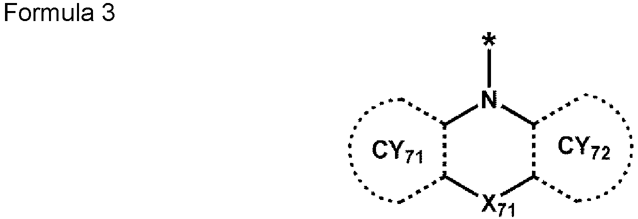
wherein, in Formula 3, ring CY₇₁ and ring CY₇₂ may each independently be a π electron-rich C₃-C₆₀ cyclic group or a pyridine group,
X₇₁ in Formula 3 may be a single bond or a linking group including O, S, N, B, C, Si, or any combination thereof, and
* in Formula 3 indicates a binding site to a neighboring atom in the first compound (e.g., a neighboring atom of a remaining portion of the first compound).

In an embodiment, the following compounds may be excluded from the first compound:

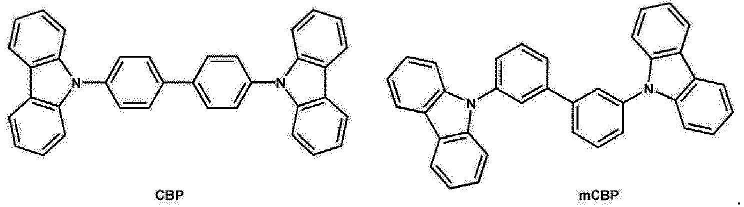

In an embodiment, the first compound may include a compound represented by Formula 3-1, a compound represented by Formula 3-2, a compound represented by Formula 3-3, a compound represented by Formula 3-4, a compound represented by Formula 3-5, or any combination thereof: 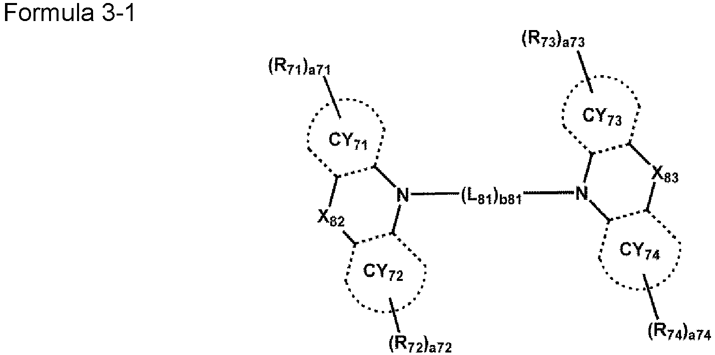 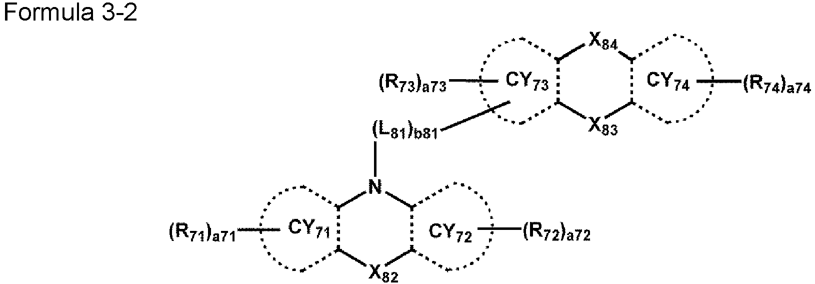 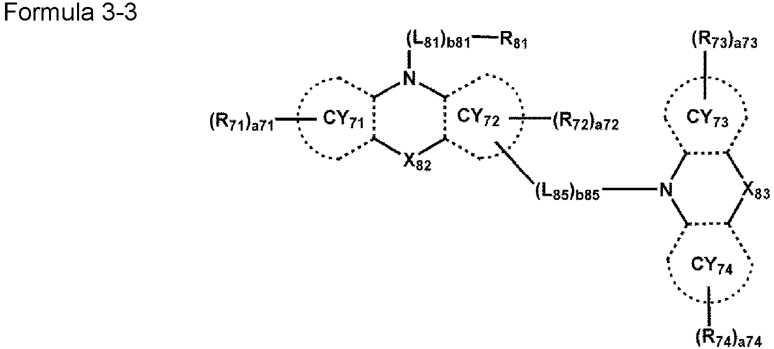 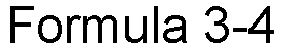 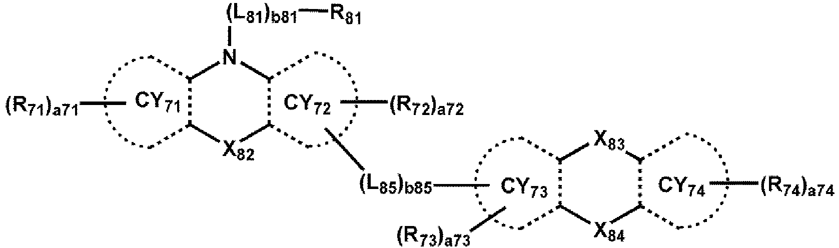 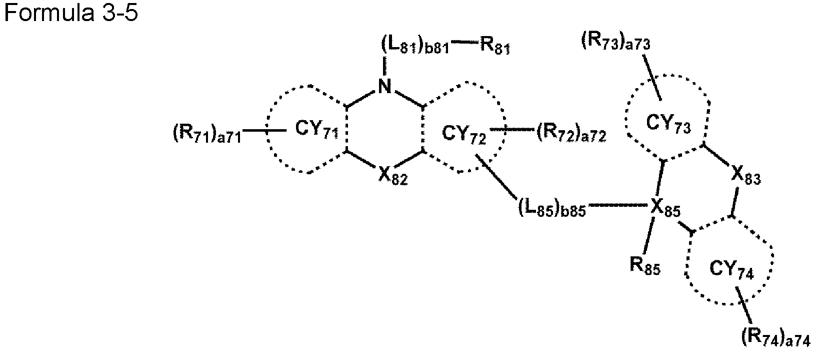 wherein, in Formulae 3-1 to 3-5,
ring CY₇₁ to ring CY₇₄ may each independently be a π electron-rich C₃-C₆₀ cyclic group or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R83a)(R83b),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each be the same as described in connection with Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a71 to a74 may each independently be an integer from 0 to 20, and
R₁₀ₐ may be the same as described herein.

In an embodiment, L₈₁ to L₈₅ in Formulae 3-1 to 3-5 may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof, and
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In an embodiment, R₇₁ to R₇₄, R₈₁ to R₈₅, R₈₂ₐ, R_{82b}, R₈₃ₐ, R_{83b}, R₈₄ₐ, and R_{84b} may each independently be: hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), - N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 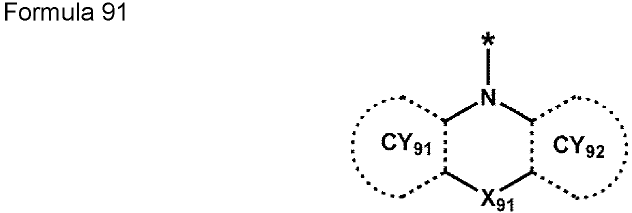
wherein, in Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R91a)(R91b),
R₉₁, R₉₁ₐ, and R_{91b} may respectively be the same as described in connection with R₈₂, R₈₂ₐ, and R_{82b},
R₁₀ₐ may be the same as described herein, and
* indicates a binding site to a neighboring atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be: hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, a cyano group, a nitro group, -CH₃, -CD₃, -CD₂H, -CDH₂, -CF₃, -CF₂H, -CFH₂, a group represented by one selected from Formulae 9-1 to 9-19, a group represented by one selected from Formulae 10-1 to 10-249, -C(Q₁)(Q₂)(Q₃), -Si(Q₁)(Q₂)(Q₃), -N(Q₁)(Q₂), or-P(=O)(Q₁)(Q₂). Q₁ to Q₃ may each be the same as described herein.

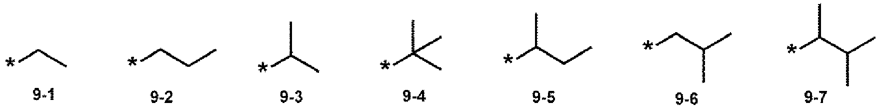

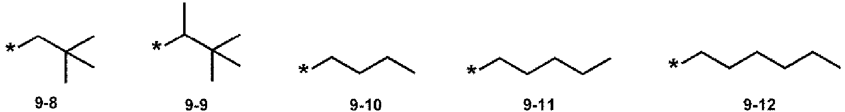

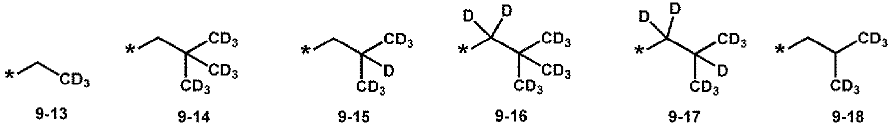

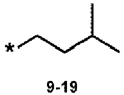

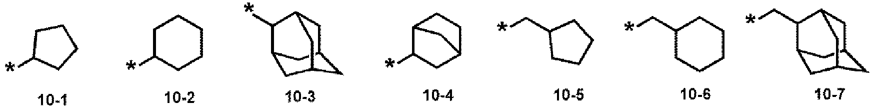

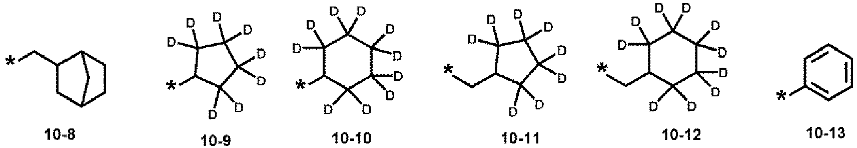

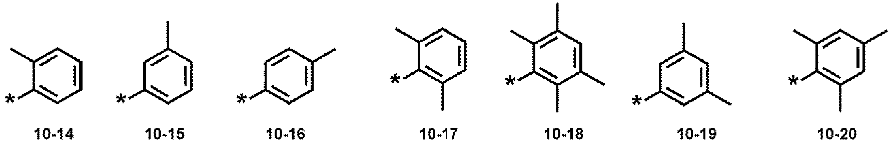

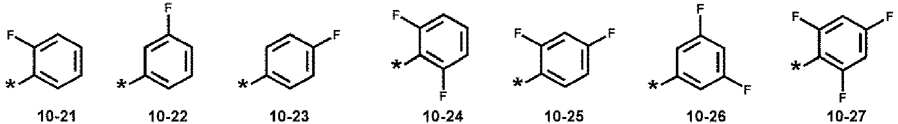

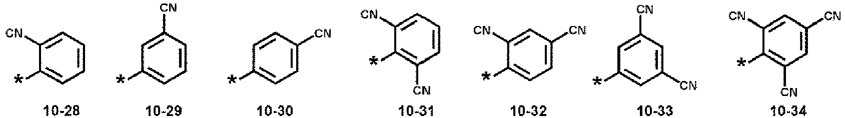

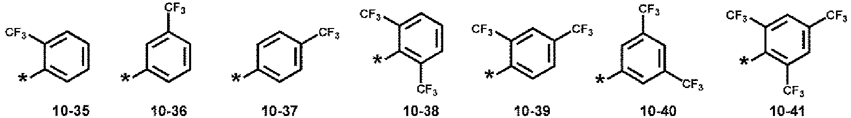

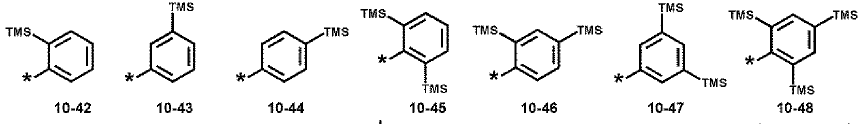

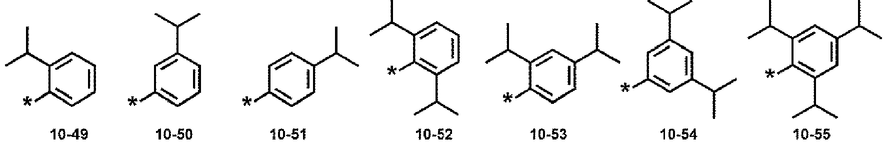

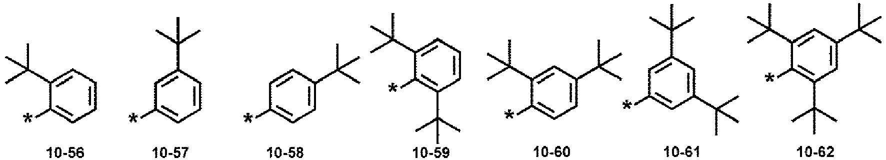

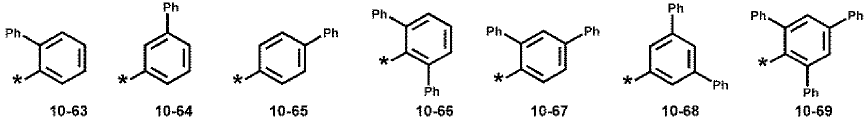

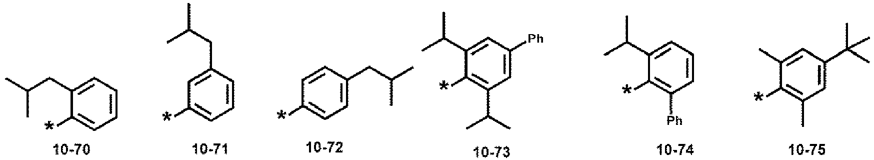

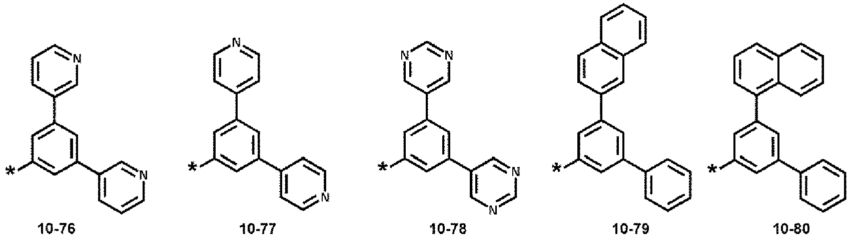

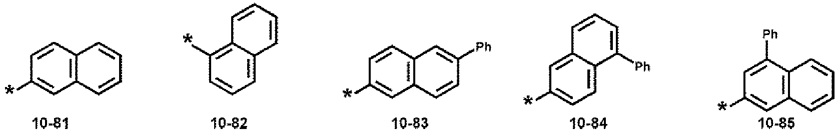

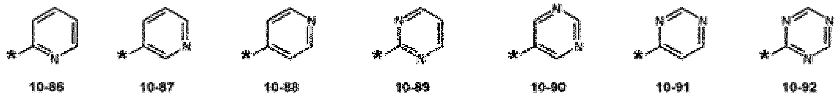

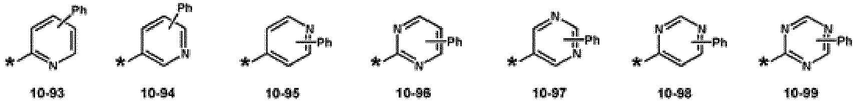

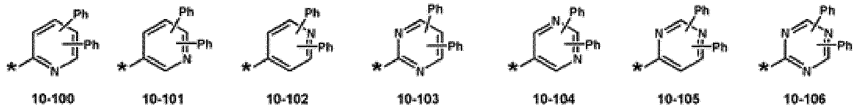

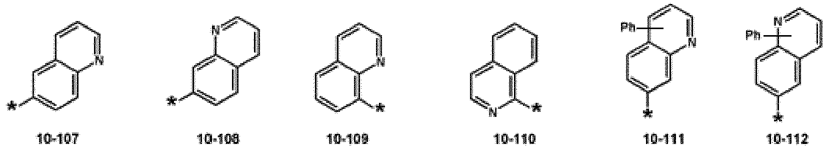

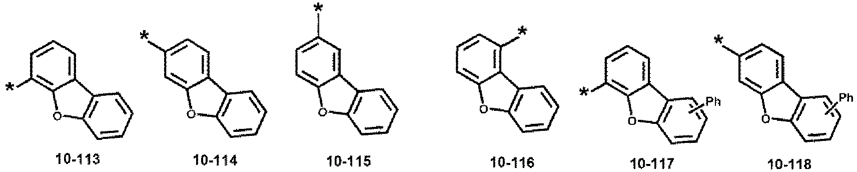

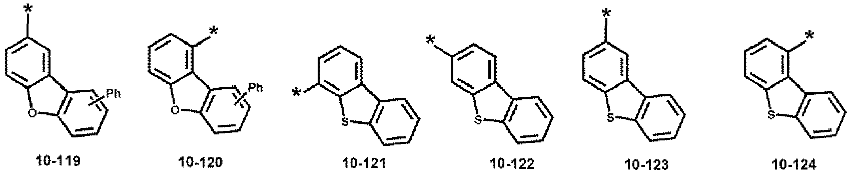

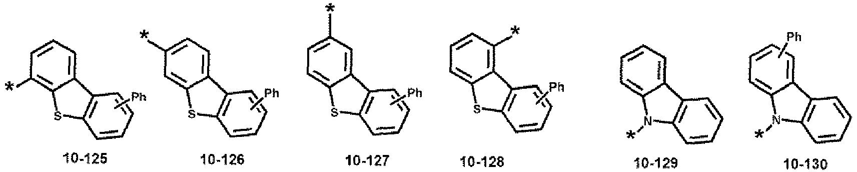

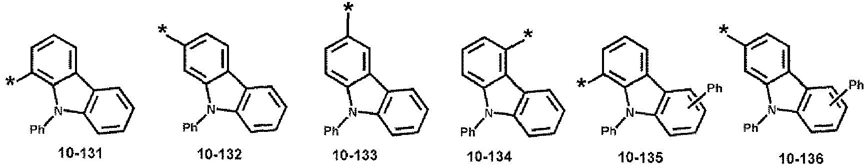

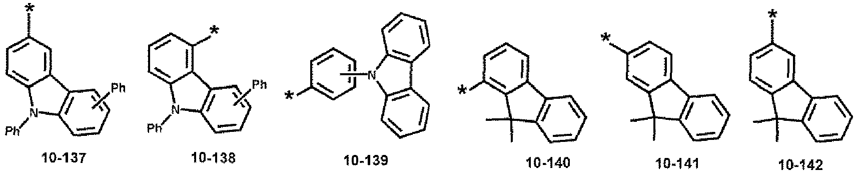

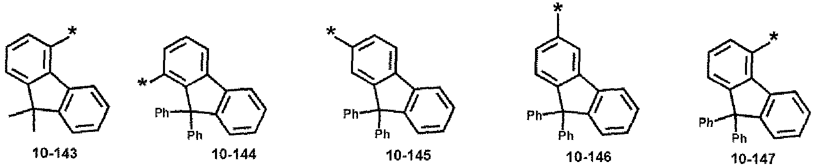

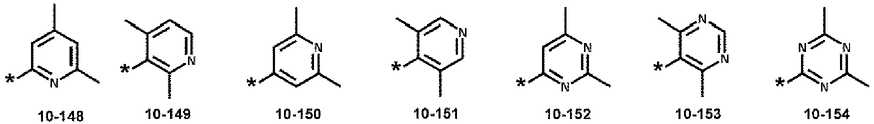

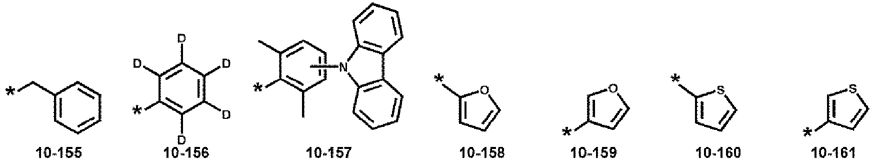

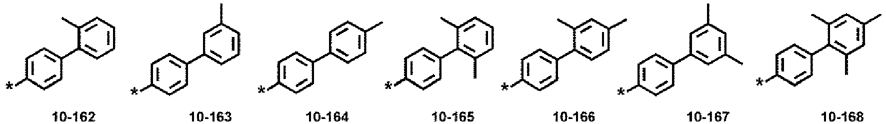

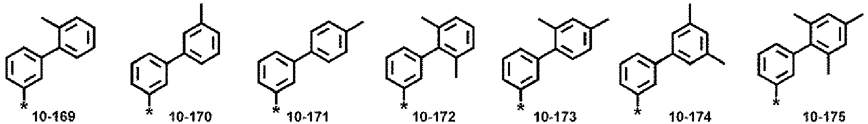

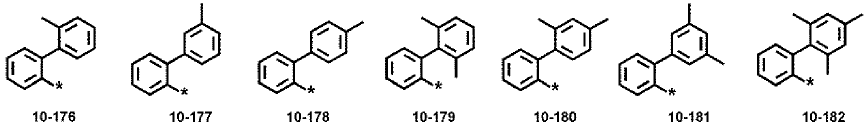

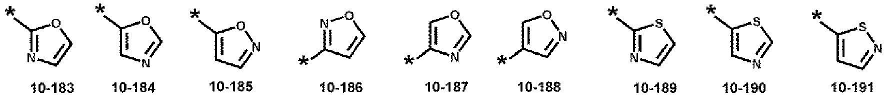

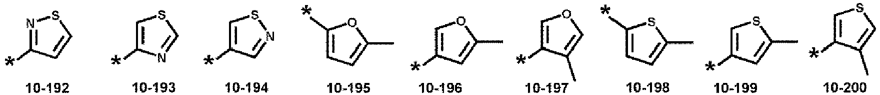

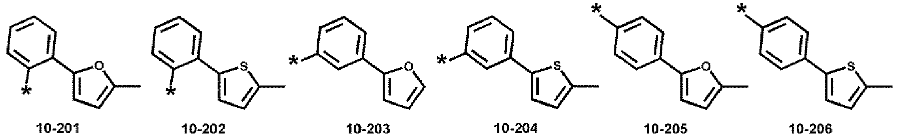

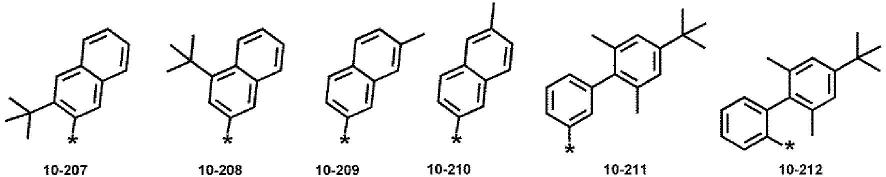

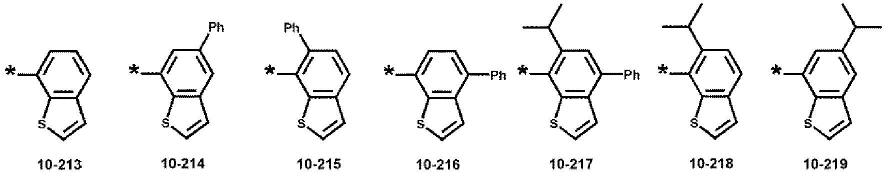

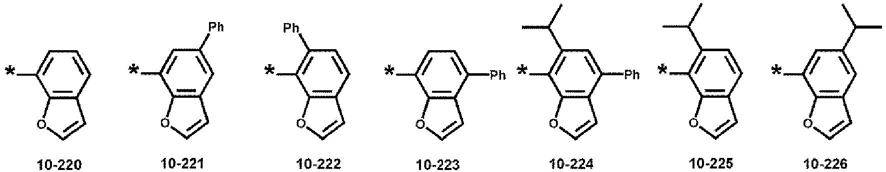

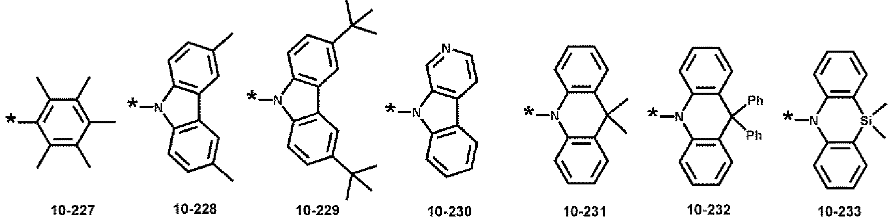

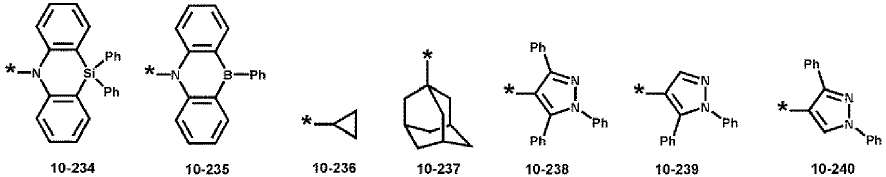

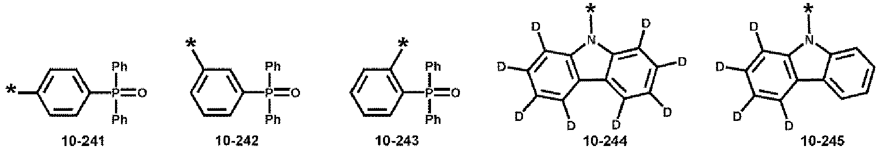

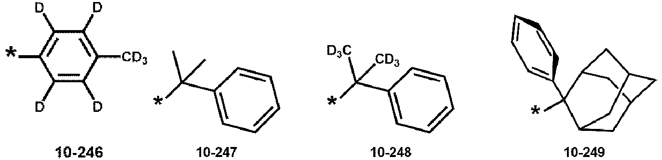

In Formulae 9-1 to 9-19 and 10-1 to 10-249, * indicates a binding site to a neighboring atom, "Ph" represents a phenyl group, and "TMS" represents a trimethylsilyl group.

In Formulae 3-1 to 3-5, a71 to a74 may respectively indicate the number of R₇₁(s) to the number of R₇₄(s), wherein, when a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other.

In an embodiment, a71 to a74 may each independently be an integer from 0 to 8.

In an embodiment, a group represented by 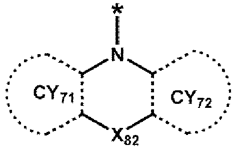 in Formulae 3-1 and 3-2 may be a group represented by one selected from Formulae CY71-1(1) to CY71-1(8),
a group represented by 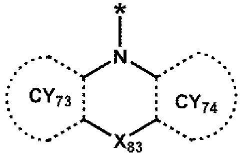 in Formulae 3-1 and 3-3 may be a group represented by one selected from Formulae CY71-2(1) to CY71-2(8),
a group represented by 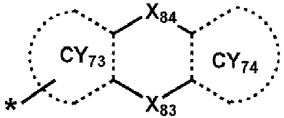 in Formulae 3-2 and 3-4 may be a group represented by one selected from Formulae CY71-3(1) to CY71-3(32),
a group represented by 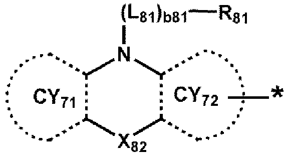 in Formulae 3-3 to 3-5 may be represented by one selected from Formulae CY71-4(1) to CY71-4(32), and/or
a group represented by 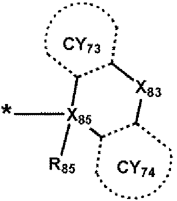 in Formula 3-5 may be represented by one selected from Formulae CY71-5(1) to CY71-5(8): 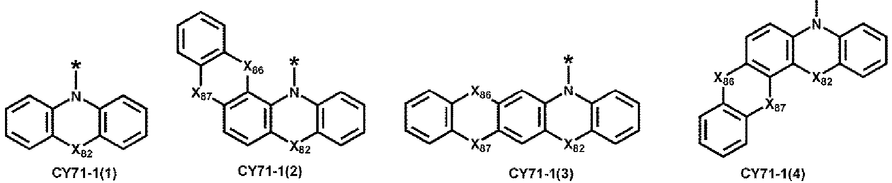 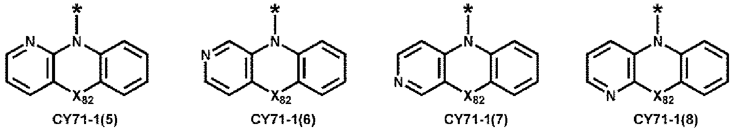 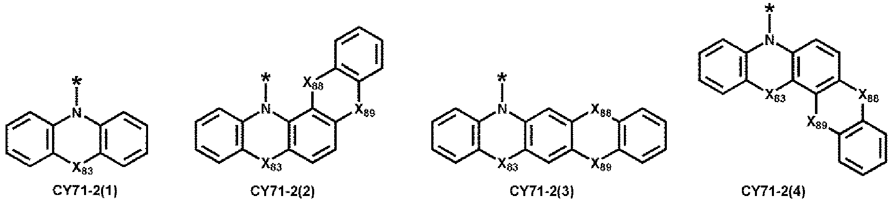 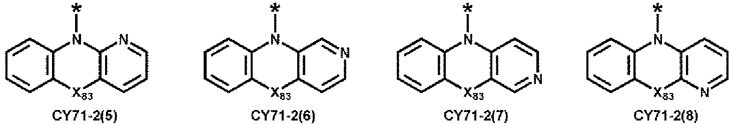 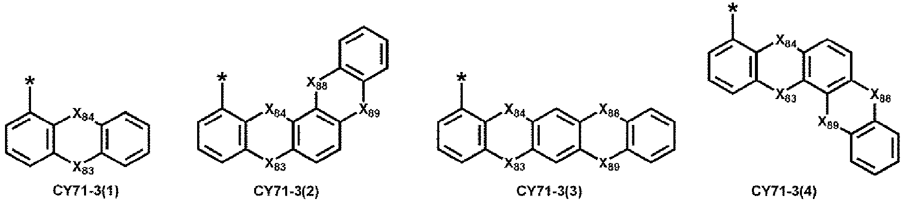 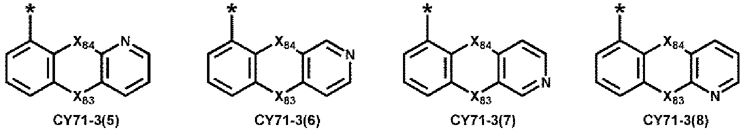 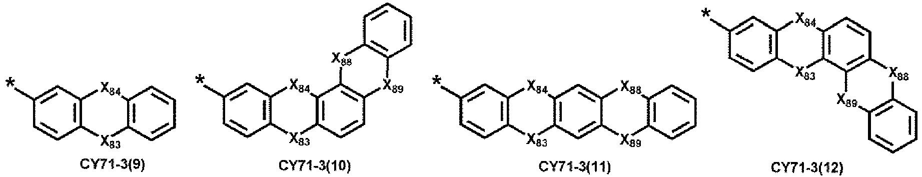 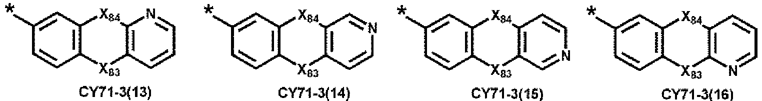 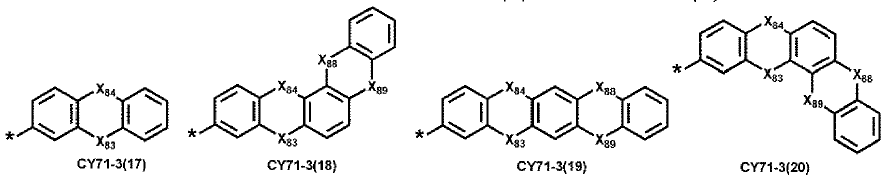 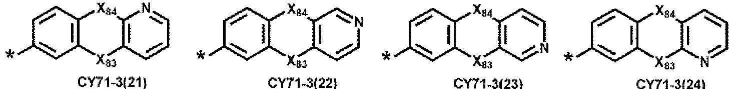 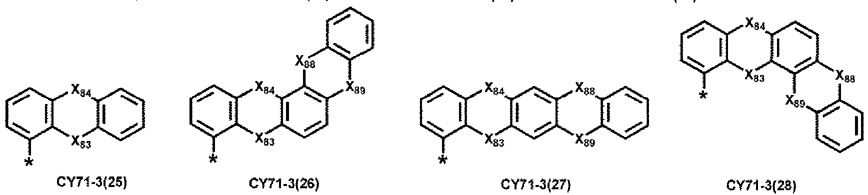 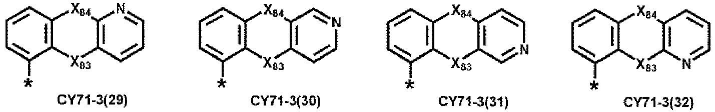 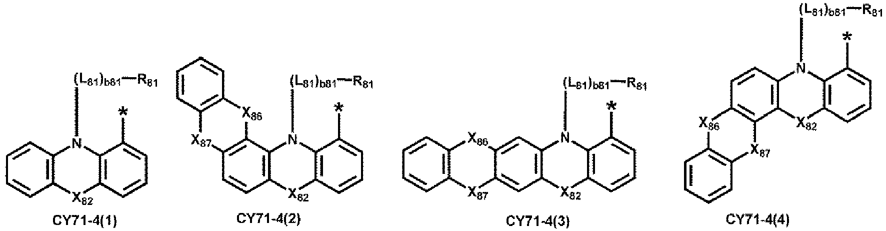 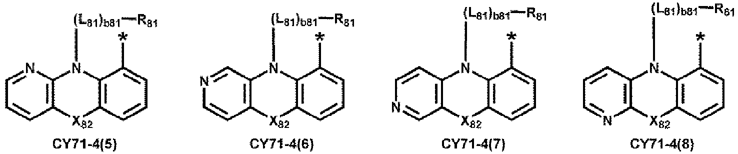 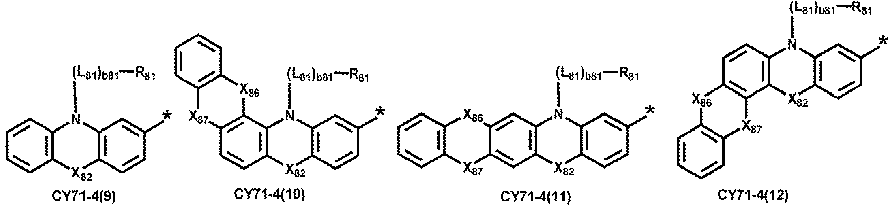 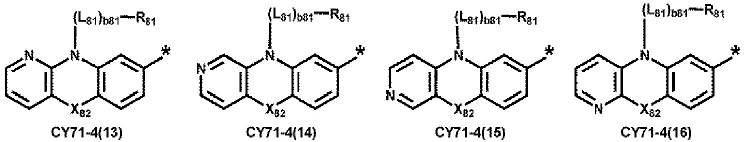 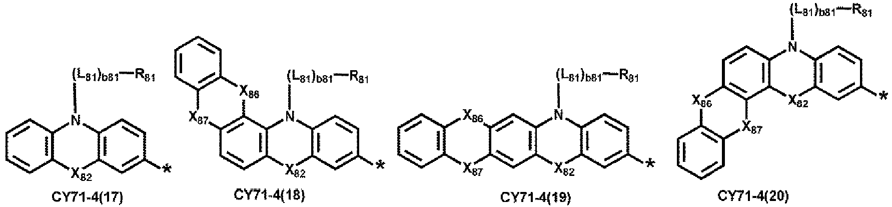 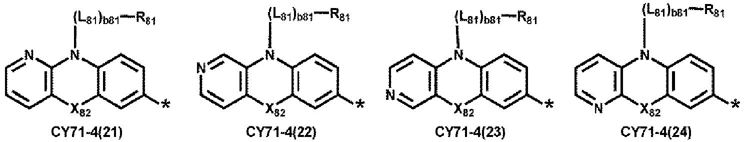 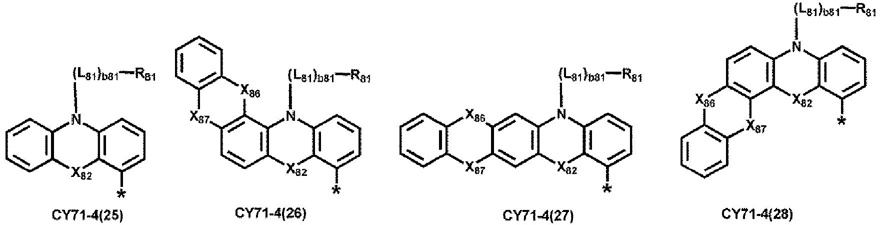 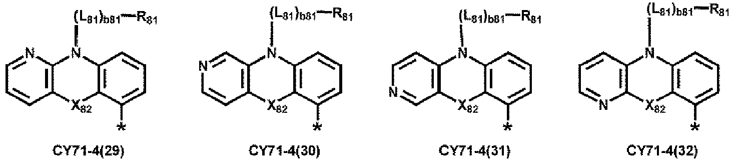 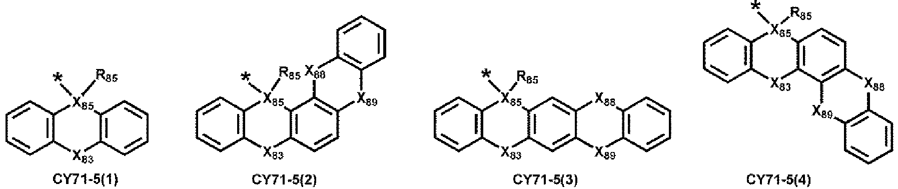 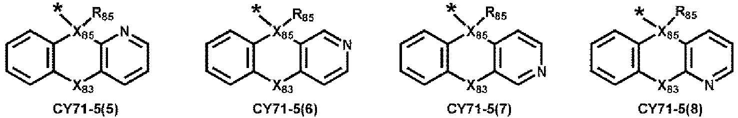
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R87a)(R87b),
in Formulae CY71-1(1) to CY71-1(8) and CY71-4(1) to CY71-4(32), each of X₈₆ and X₈₇ may not be a single bond at the same time,
X₈₈ may be a single bond, O, S, N(R₈₈), B(R₈₈), C(R₈₈ₐ)(R_{88b}), or Si(R₈₆ₐ)(R_{86b}),
X₈₉ may be a single bond, O, S, N(R₈₉), B(R₈₉), C(R₈₉ₐ)(R_{89b}), or Si(R89a)(R89b),
in Formulae CY71-2(1) to CY71-2(8), CY71-3(1) to CY71-3(32), and CY71-5(1) to CY71-5(8), each of X₈₈ and X₈₉ may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be the same as described in connection with R₈₁.

In an embodiment, the first compound may include at least one selected from Compounds HTH1 to HTH53: 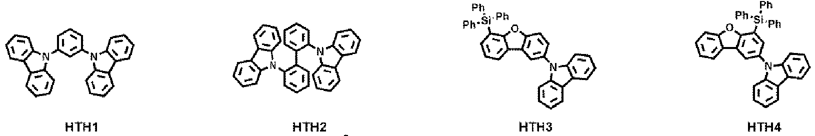 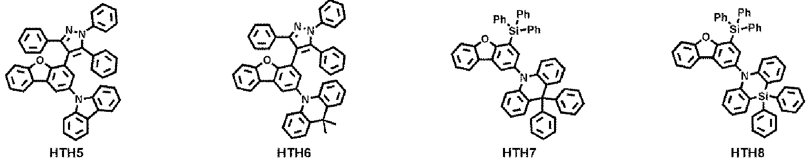 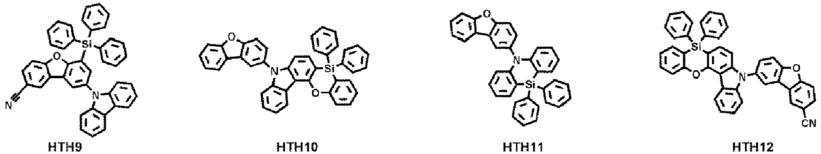 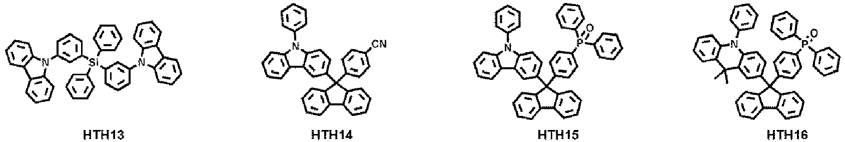 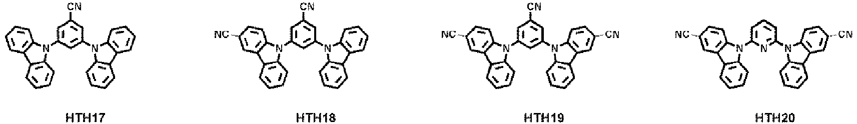 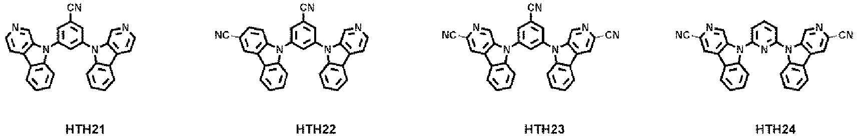 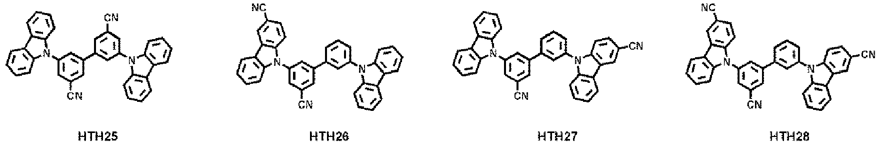 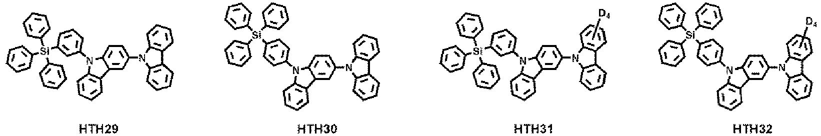 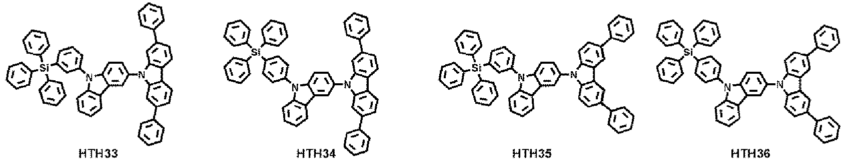 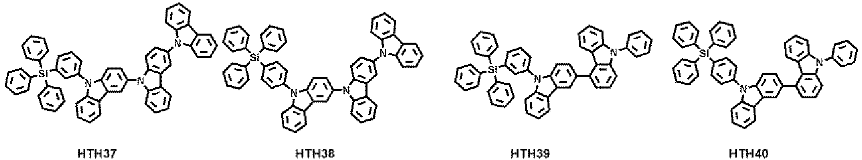 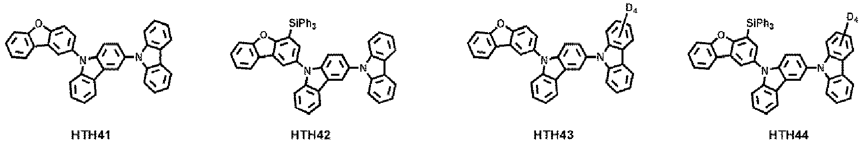 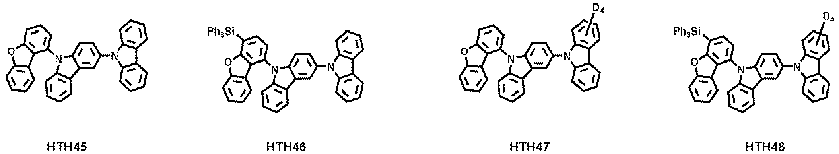 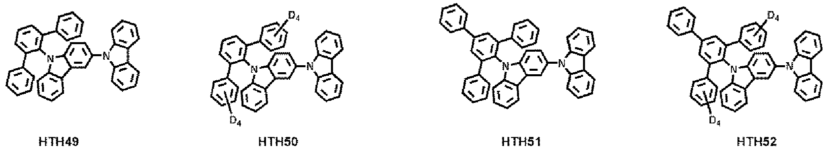 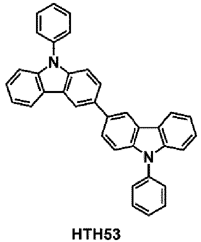 wherein, in Compounds HTH1 to HTH53, "Ph" represents a phenyl group, "D₅" represents substitution with five deuterium atoms, and "D₄" represents substitution with four deuterium atoms. For example, a group represented by 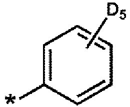 may be identical to a group represented by

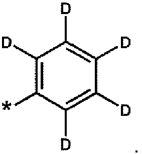

### Second compound

In an embodiment, the second compound may include a π electron-deficient nitrogen-containing C₁-C₆₀ cyclic group.

In an embodiment, the second compound may include a pyridine group, a pyrimidine group, a pyrazine group, a pyridazine group, a triazine group, or any combination thereof.

In an embodiment, the second compound may include a compound represented by Formula 2: 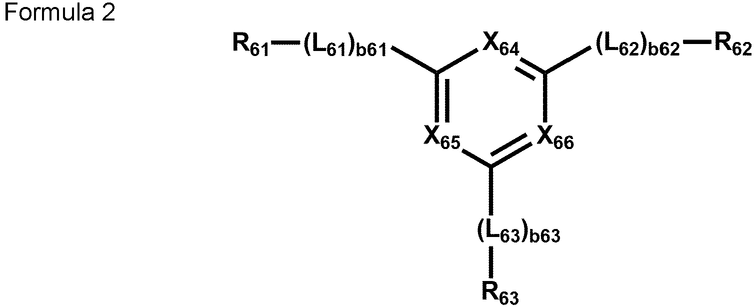 wherein, in Formula 2,
L₆₁ to L₆₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b61 to b63 may each independently be an integer from 1 to 5,
X₆₄ may be N or C(R₆₄), X₆₅ may be N or C(R₆₅), X₆₆ may be N or C(R₆₆), and at least one selected from X₆₄ to X₆₆ may be N,
R₆₁ to R₆₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃),-Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
R₁₀ₐ and Q₁ to Q₃ may each be the same as described herein.

In an embodiment, L₆₁ to L₆₃ may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzotiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁),-Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁),-S(=O)₂(Q₃₁), -P(=O)(Q₃₁)(Q₃₂), or any combination thereof, and
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In an embodiment, in Formula 2, a bond between L₆₁ and R₆₁, a bond between L₆₂ and R₆₂, a bond between L₆₃ and R₆₃, a bond between at least two L₆₁(s), a bond between at least two L₆₂(s), a bond between at least two L₆₃(s), a bond between L₆₁ and a carbon atom between X₆₄ and X₆₅ in Formula 2, a bond between L₆₂ and a carbon atom between X₆₄ and X₆₆ in Formula 2, and a bond between L₆₃ and a carbon atom between X₆₅ and X₆₆ in Formula 2 may each be a "carbon-carbon single bond".

In an embodiment, in Formula 2, X₆₄ may be N or C(R₆₄), X₆₅ may be N or C(R₆₅), X₆₆ may be N or C(R₆₆), and X₆₄ to X₆₆ may be N. R₆₄ to R₆₆ may each be the same as described herein. For example, two or three of X₆₄ to X₆₆ may each be N.

In an embodiment, R₆₁ to R₆₆ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃),-N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 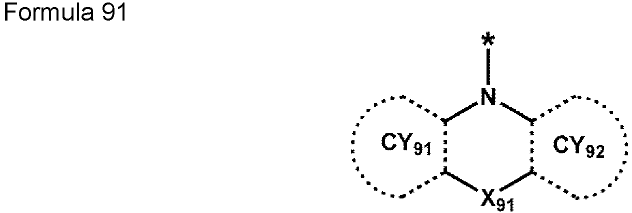
wherein, in Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R91a)(R91b),
R₉₁, R₉₁ₐ, and R_{91b} may respectively be the same as described in connection with R₈₂, R₈₂ₐ, and R_{82b},
R₁₀ₐ may be the same as described herein, and
* indicates a binding site to a neighboring atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, R₆₁ to R₆₆ may each independently be hydrogen, deuterium, -F, a cyano group, a nitro group, -CH₃, -CD₃, -CD₂H, -CDH₂,-CF₃, -CF₂H, -CFH₂, a group represented by one selected from Formulae 9-1 to 9-19, a group represented by one selected from Formulae 10-1 to 10-249, -C(Q₁)(Q₂)(Q₃), -Si(Q₁)(Q₂)(Q₃), -N(Q₁)(Q₂), or -P(=O)(Q₁)(Q₂) (wherein Q₁ to Q₃ are each the same as described herein): 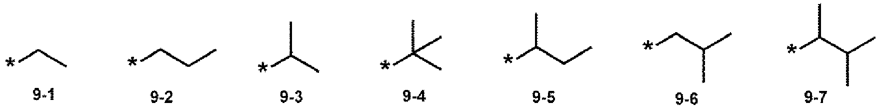 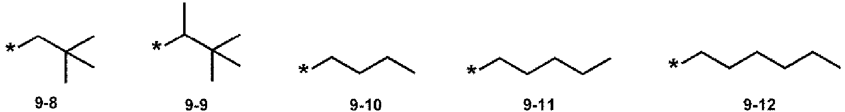 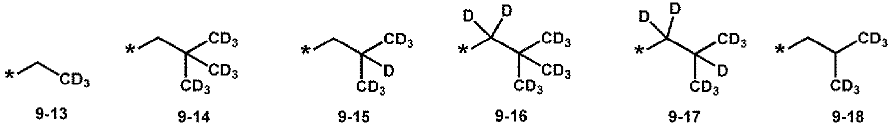 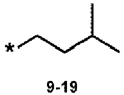 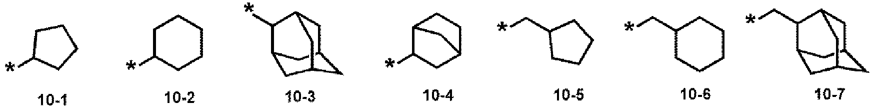 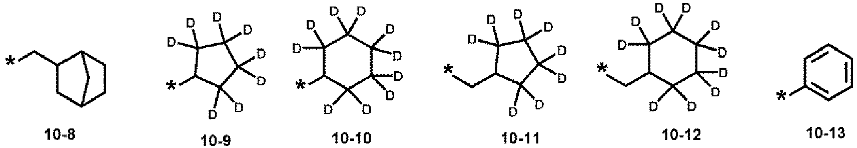 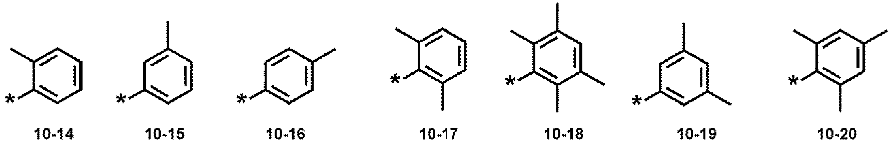 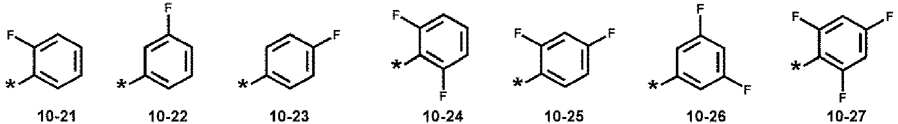 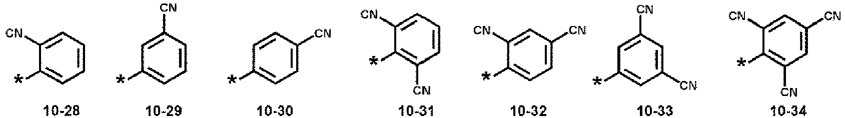 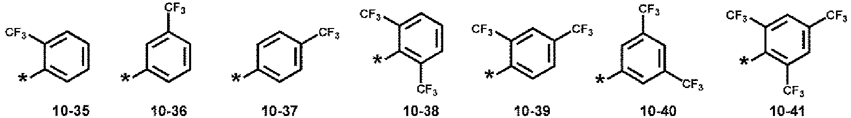 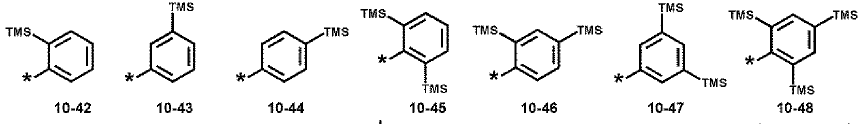 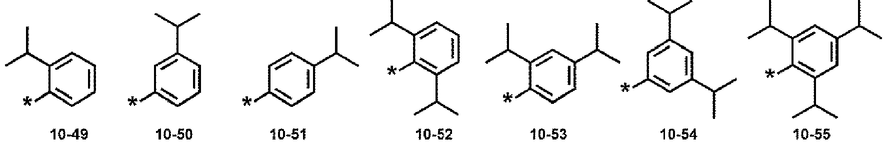 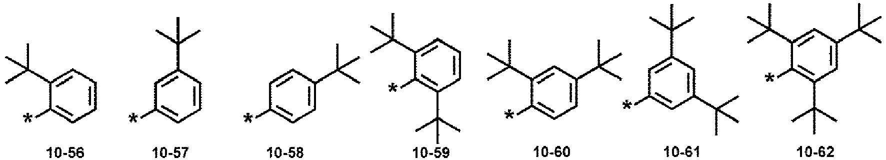 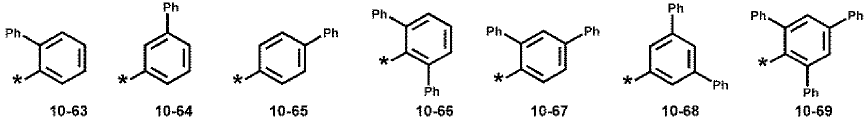 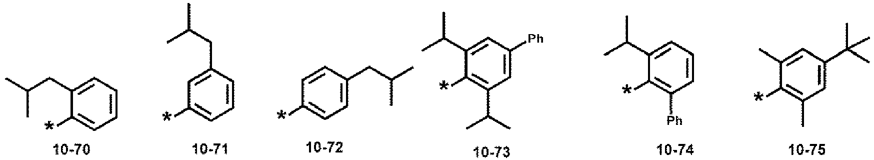 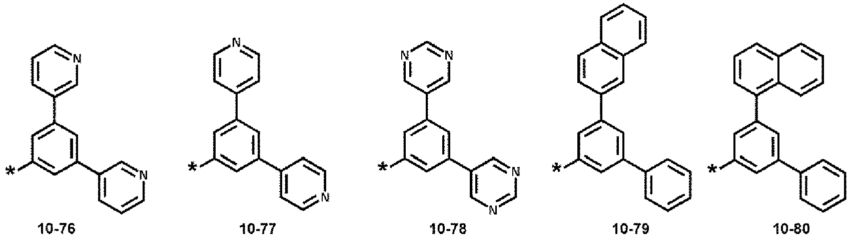 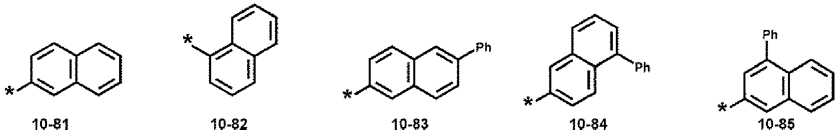 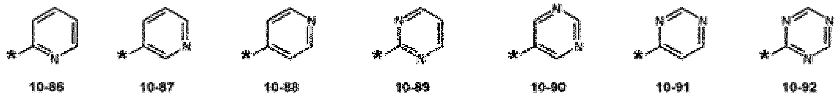 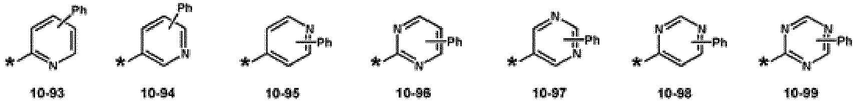 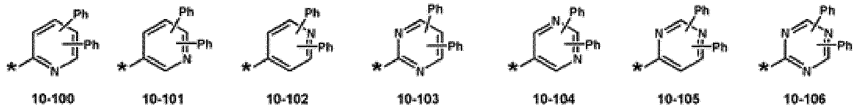 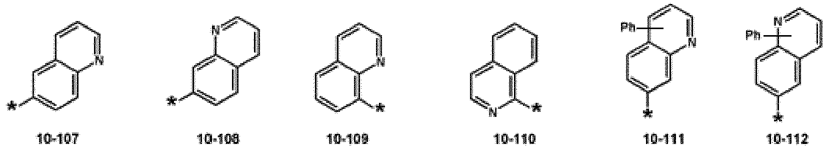 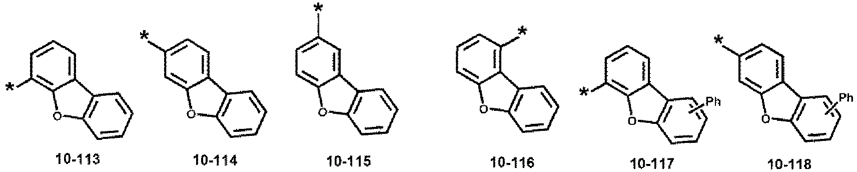 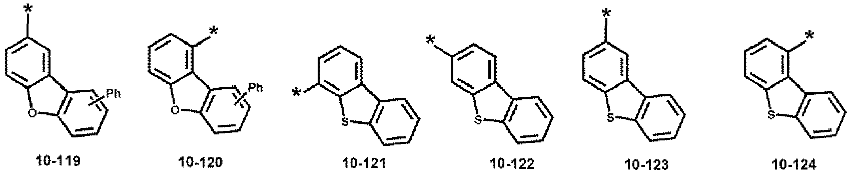 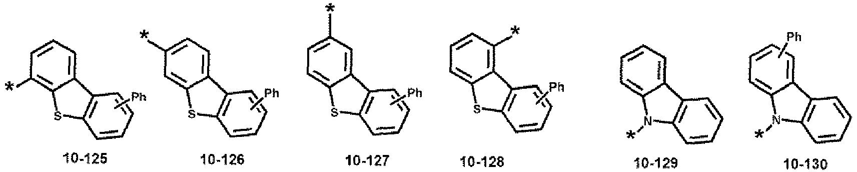 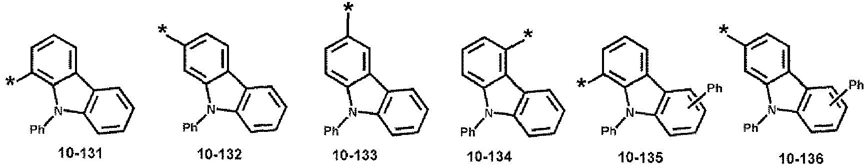 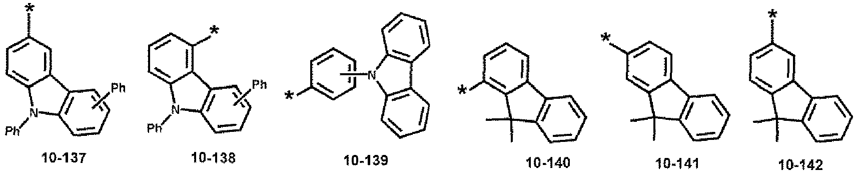 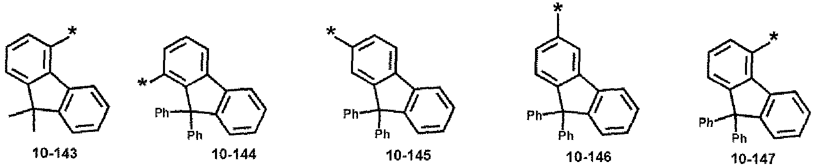 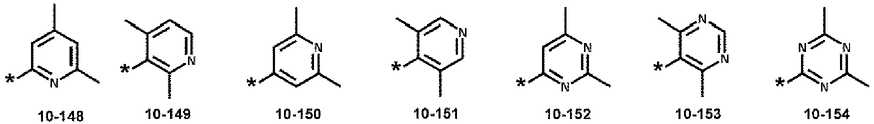 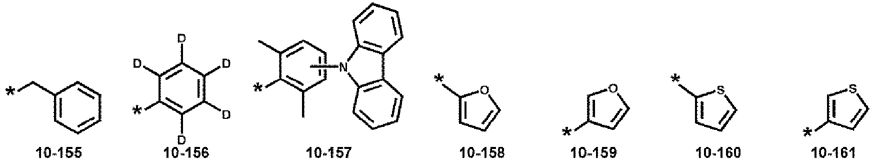 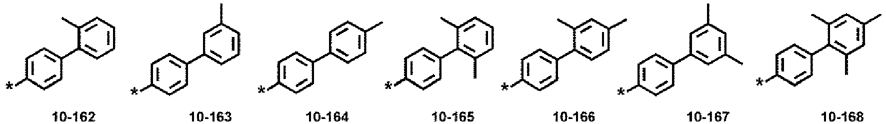 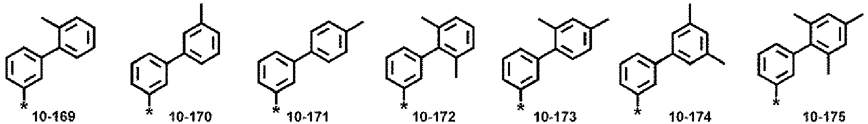 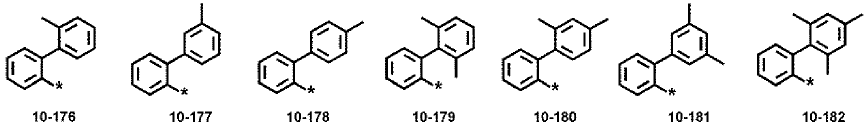 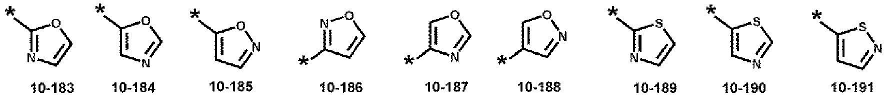 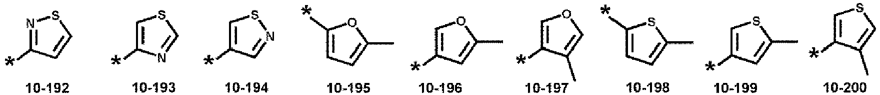 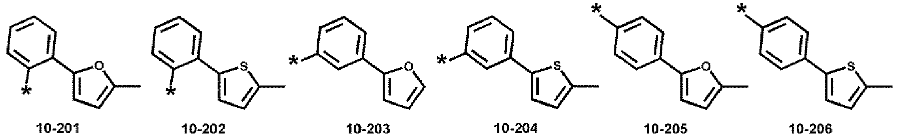 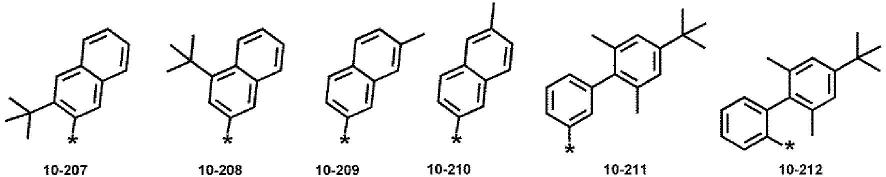 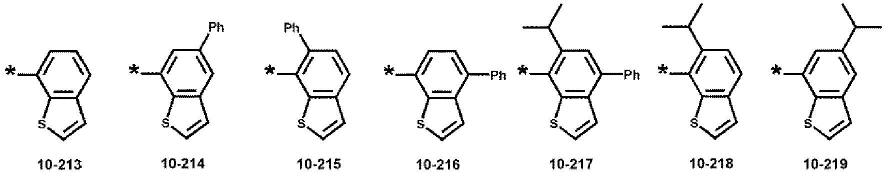 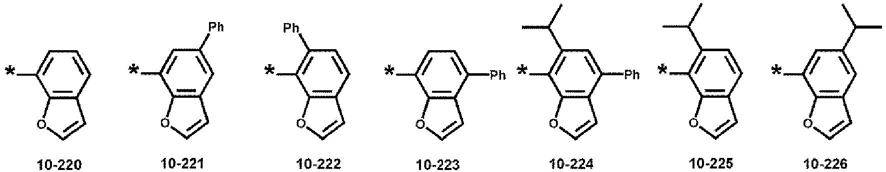 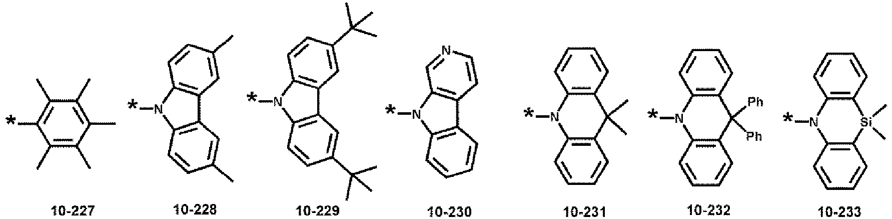 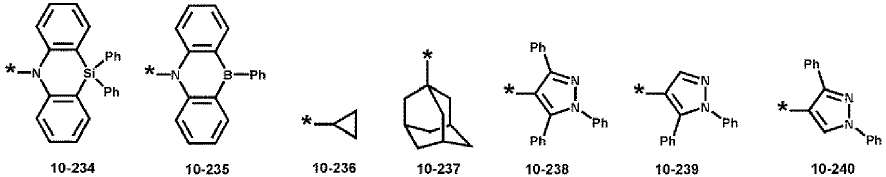 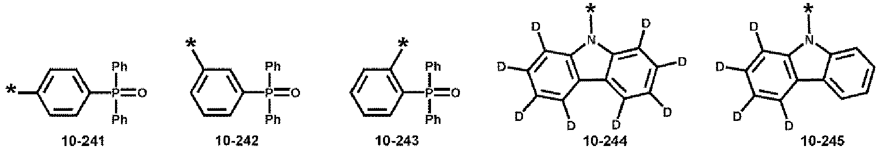 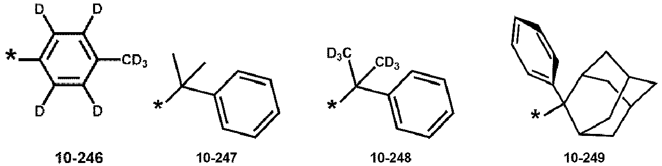 wherein, in Formulae 9-1 to 9-19 and 10-1 to 10-249, * indicates a binding site to a neighboring atom, "Ph" represents a phenyl group, and "TMS" represents a trimethylsilyl group.

In Formula 2, b61 to b63 may respectively indicate the number of L₆₁(s) to the number of L₆₃(s), and b61 to b63 may each independently be an integer from 1 to 5. When b61 is 2 or more, two or more of L₆₁(s) may be identical to or different from each other, when b62 is 2 or more, two or more of L₆₂(s) may be identical to or different from each other, and when b63 is 2 or more, two or more of L₆₃(s) may be identical to or different from each other. For example, b61 to b63 may each independently be 1 or 2.

In an embodiment, in Formula 2, a group represented by *-(L₆₁)_{b61}-R₆₁ and a group represented by *-(L₆₂)_{b62}-R₆₂ may each not be a phenyl group.

In an embodiment, in Formula 2, the group represented by *-(L₆₁)_{b61}-R₆₁ and the group represented by *-(L₆₂)_{b62}-R₆₂ may be identical to each other.

In one or more embodiments, in Formula 2, the group represented by *-(L₆₁)_{b61}-R₆₁ and the group represented by *-(L₆₂)_{b62}-R₆₂ may be different from each other.

In one or more embodiments, in Formula 2, b61 and b62 may each independently be 1, 2, or 3, L₆₁ and L₆₂ may each independently be a benzene group, a pyridine group, a pyrimidine group, a pyridazine group, a pyrazine group, or a triazine group, each unsubstituted or substituted with at least one R₁₀ₐ.

For example, in Formula 2, R₆₁ and R₆₂ may each independently be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), or - Si(Q₁)(Q₂)(Q₃), and
Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment,
the group represented by *-(L₆₁)_{b61}-R₆₁ in Formula 2 may be a group represented by one selected from Formulae CY51-1 to CY51-26,
the group represented by *-(L₆₂)_{b62}-R₆₂ in Formula 2 may be a group represented by one selected from Formulae CY52-1 to CY52-26, and/or
a group represented by *-(L₆₃)_{b63}-R₆₃ in Formula 2 may be a group represented by one selected from Formulae CY53-1 to CY53-27, -C(Q₁)(Q₂)(Q₃), or -Si(Q₁)(Q₂)(Q₃): 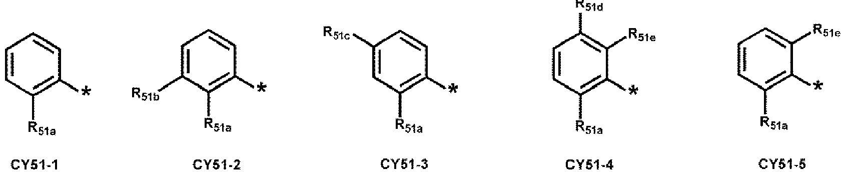 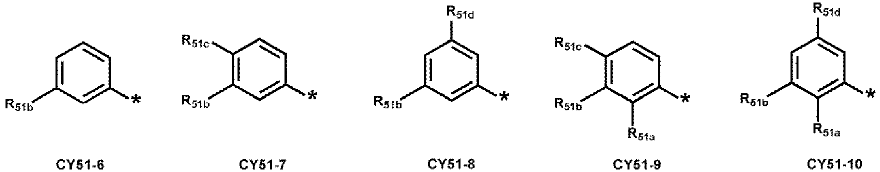 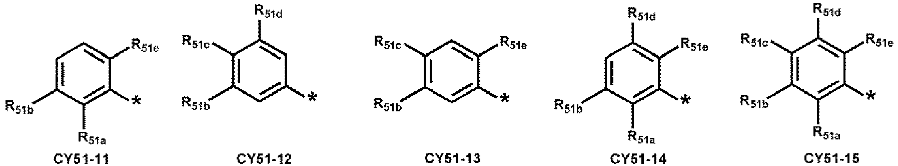 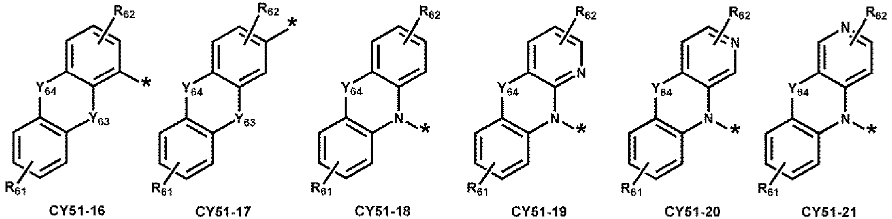 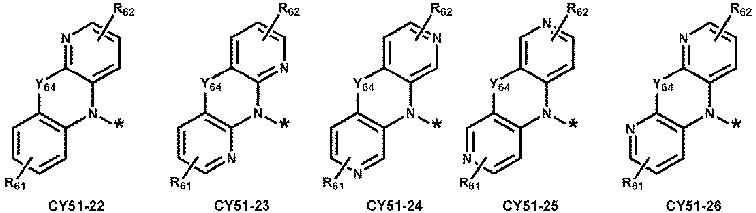 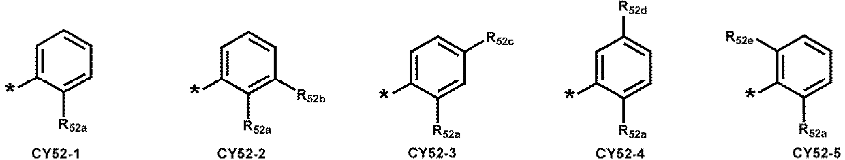 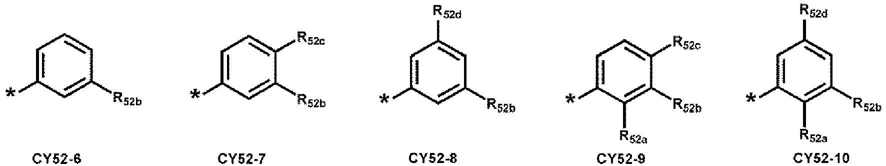 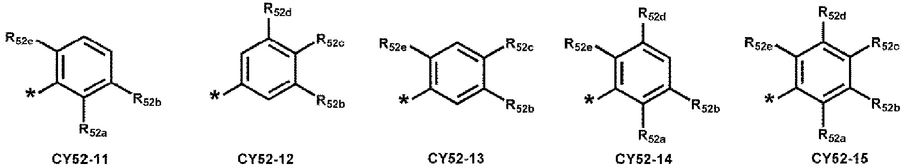 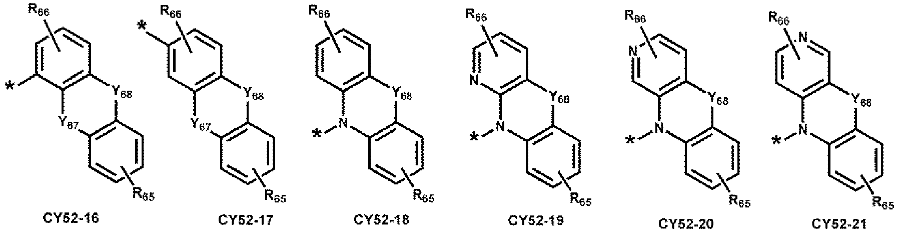 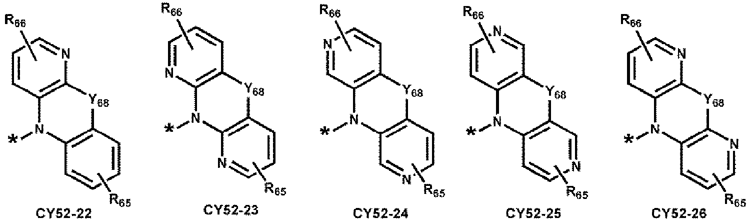 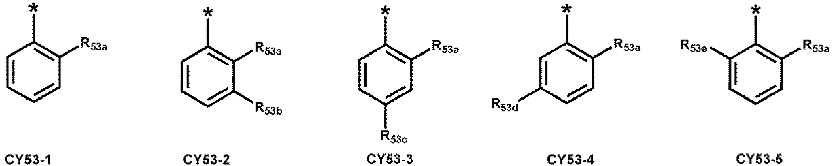 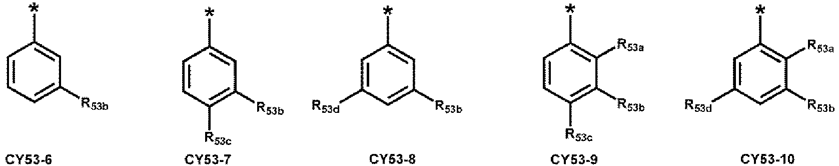 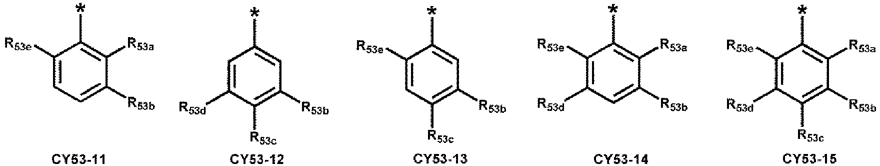 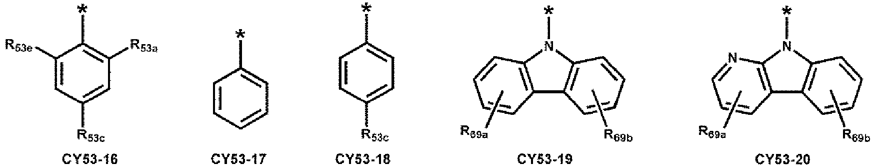 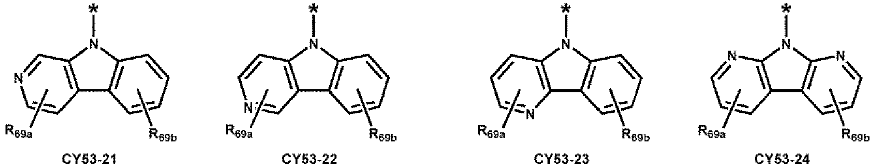 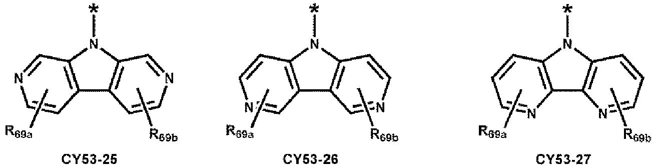
wherein, in Formulae CY51-1 to CY51-26, CY52-1 to CY52-26, and CY53-1 to CY53-27,
Y₆₃ may be a single bond, O, S, N(R₆₃), B(R₆₃), C(R₆₃ₐ)(R_{63b}), or Si(R63a)(R63b),
Y₆₄ may be a single bond, O, S, N(R₆₄), B(R₆₄), C(R₆₄ₐ)(R_{64b}), or Si(R₆₄ₐ)(R_{64b}),
Y₆₇ may be a single bond, O, S, N(R₆₇), B(R₆₇), C(R₆₇ₐ)(R_{67b}), or Si(R₆₇ₐ)(R_{67b}),
Y₆₈ may be a single bond, O, S, N(R₆₈), B(R₆₈), C(R₆₈ₐ)(R_{68b}), or Si(R₈₆ₐ)(R_{86b}),
each of Y₆₃ and Y₆₄ in Formulae CY51-16 and CY51-17 may not be a single bond at the same time,
each of Y₆₇ and Y₆₈ in Formulae CY52-16 and CY52-17 may not be a single bond at the same time,
R₅₁ₐ to R₅₁ₑ, R₆₁ to R₆₄, R₆₃ₐ, R_{63b}, R₆₄ₐ, and R_{64b} may each be the same as described in connection with R₆₁, wherein R₅₁ₐ to R₅₁ₑ may each not be hydrogen,
R₅₂ₐ to R₅₂ₑ, R₆₅ to R₆₈, R₆₇ₐ, R_{67b}, R₆₈ₐ, and R_{68b} may each be the same as described in connection with R₆₂, wherein R₅₂ₐ to R₅₂ₑ may each not be hydrogen,
R₅₃ₐ to R₅₃ₑ, R₆₉ₐ, and R_{69b} may each be the same as described in connection with R₆₃, wherein R₅₃ₐ to R₅₃ₑ may each not be hydrogen, and
* indicates a binding site to a neighboring atom.

For example,
R₅₁ₐ to R₅₁ₑ and R₅₂ₐ to R₅₂ₑ in Formulae CY51-1 to CY51-26 and CY52-1 to CY 52-26 may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
-C(Q₁)(Q₂)(Q₃) or -Si(Q₁)(Q₂)(Q₃), and
Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In Formulae CY51-16 and CY51-17, i) Y₆₃ may be O or S and Y₆₄ may be Si(R₆₄ₐ)(R_{64b}), or ii) Y₆₃ may be Si(R₆₃ₐ)(R_{63b}) and Y₆₄ may be O or S, and
in Formulae CY52-16 and CY52-17, i) Y₆₇ may be O or S and Y₆₈ may be Si(R₆₈ₐ)(R_{68b}), or ii) Y₆₇ may be Si(R₆₇ₐ)(R_{67b}) and Y₆₈ may be O or S.

In an embodiment, the second compound may include at least one selected from Compounds ETH1 to ETH85:

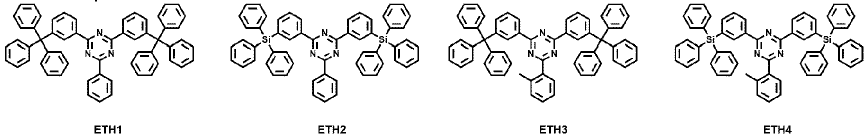

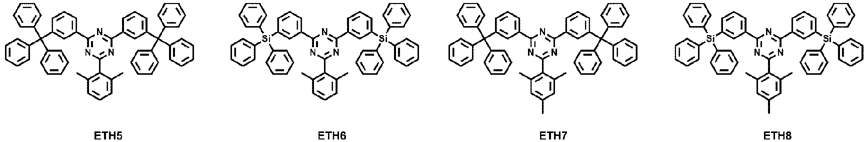

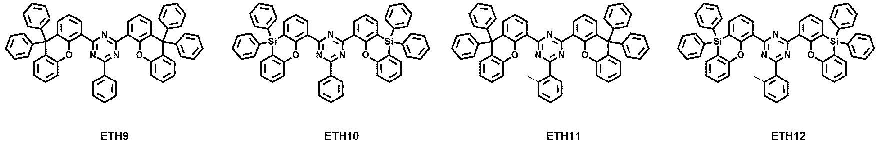

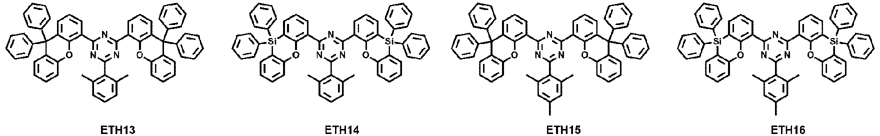

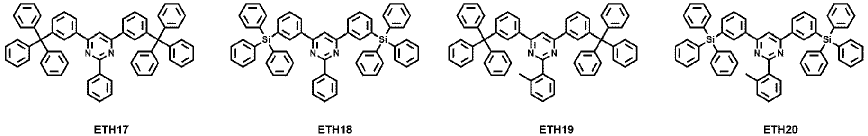

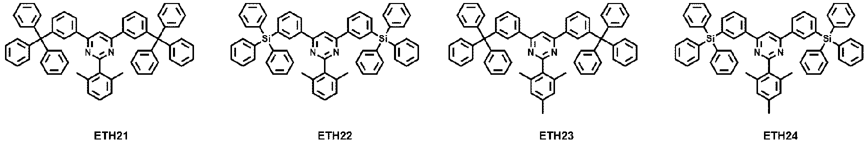

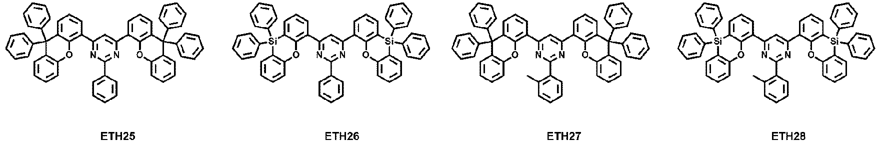

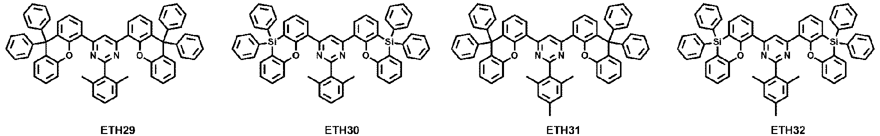

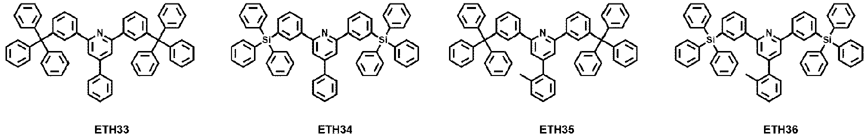

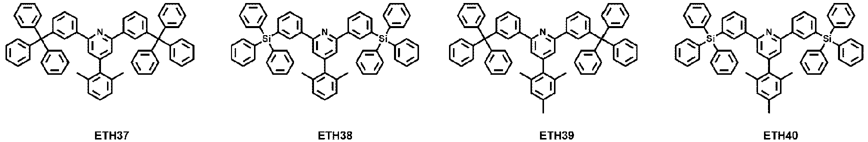

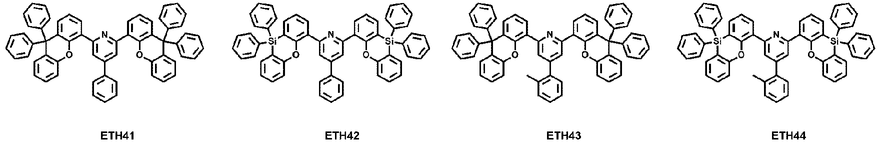

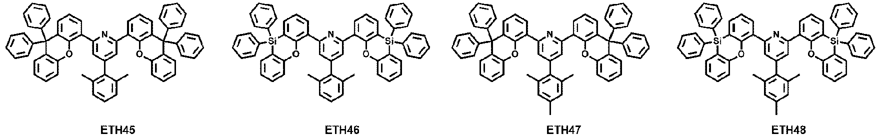

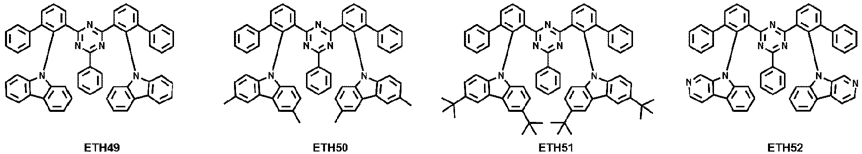

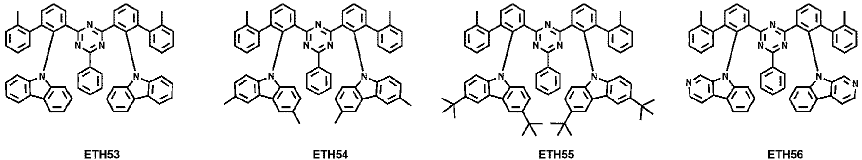

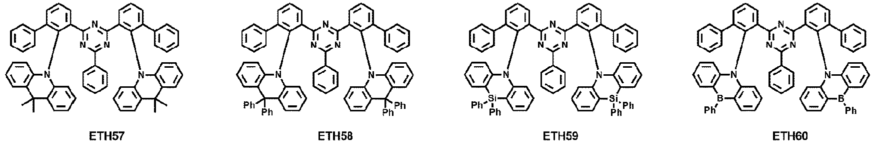

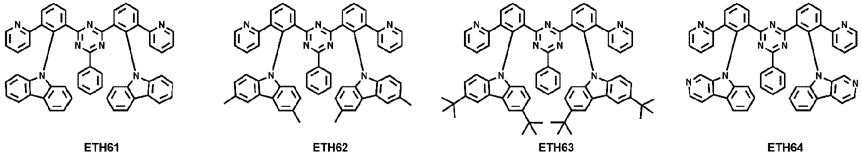

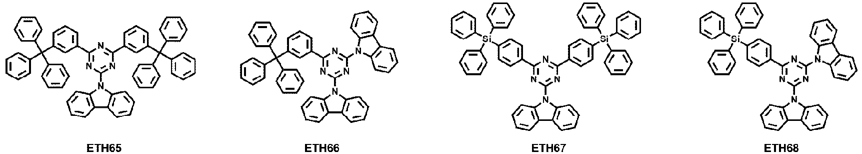

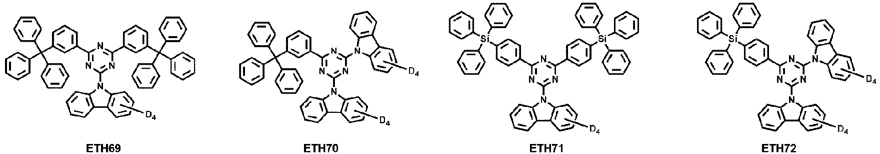

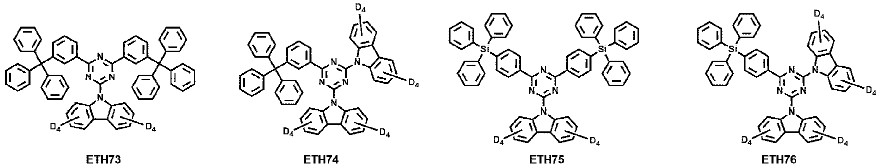

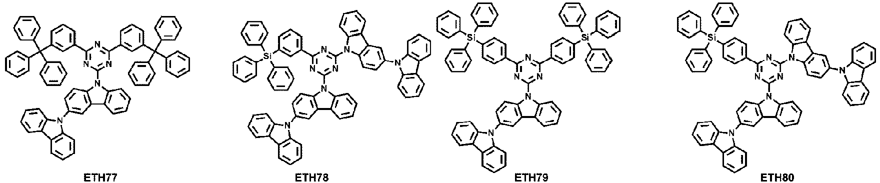

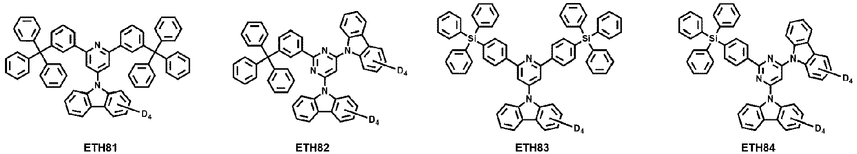

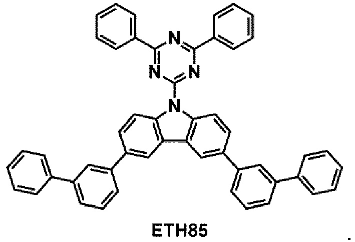

### Third compound

In an embodiment, the third compound may include a triphenylene group.

In an embodiment, the third compound may include a compound represented by Formula 4: 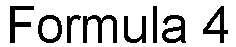 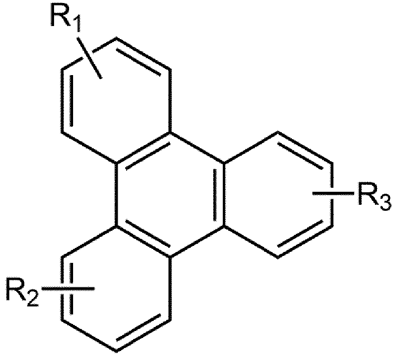 wherein, in Formula 4, R₁ to R₃ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃),-N(Q₁)(Q₂), -B(Q₁)(Q₂), -C(=O)(Q₁), -S(=O)₂(Q₁), or -P(=O)(Q₁)(Q₂). R₁₀ₐ and Q₁ to Q₃ may each be the same as described herein.

For example, R₁ to R₃ may each independently be: hydrogen, deuterium, -F,-Cl, -Br, -I, a hydroxyl group, a cyano group, a nitro group, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -CI, - Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁),-S(=O)₂(Q₃₁), -P(=O)(Q₃₁)(Q₃₂), or any combination thereof; or
-Si(Q₁)(Q₂)(Q₃), -N(Q₁)(Q₂), -B(Q₁)(Q₂), -C(=O)(Q₁), -S(=O)₂(Q₁), or-P(=O)(Q₁)(Q₂), and
Q₁ to Q₃ and Q₃₁ to Q₃₃ may each independently be: -CH₃, -CD₃, -CD₂H,-CDH₂, -CH₂CH₃, -CH₂CD₃, -CH₂CD₂H, -CH₂CDH₂, -CHDCH₃, -CHDCD₂H,-CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with at least one selected from deuterium, a C₁-C₁₀ alkyl group, a phenyl group, a biphenyl group, a pyridinyl group, a pyrimidinyl group, a pyridazinyl group, a pyrazinyl group, and a triazinyl group.

In one or more embodiments, R₁ to R₃ may each independently be hydrogen, deuterium, -F, -Cl, -Br, -I, a cyano group, a C₆-C₆₀ aryl group unsubstituted or substituted with at least one R₁₀ₐ, a C₁-C₆₀ heteroaryl group unsubstituted or substituted with at least one R₁₀ₐ, a monovalent non-aromatic condensed polycyclic group unsubstituted or substituted with at least one R₁₀ₐ, or a monovalent non-aromatic condensed heteropolycyclic group unsubstituted or substituted with at least one R₁₀ₐ.

In one or more embodiments, at least one selected from R₁ to R₃ may be a C₆-C₆₀ aryl group unsubstituted or substituted with at least one R₁₀ₐ, a C₁-C₆₀ heteroaryl group unsubstituted or substituted with at least one R₁₀ₐ, a monovalent non-aromatic condensed polycyclic group unsubstituted or substituted with at least one R₁₀ₐ, or a monovalent non-aromatic condensed heteropolycyclic group unsubstituted or substituted with at least one R₁₀ₐ.

In an embodiment, the third compound may include Compound WBG1:

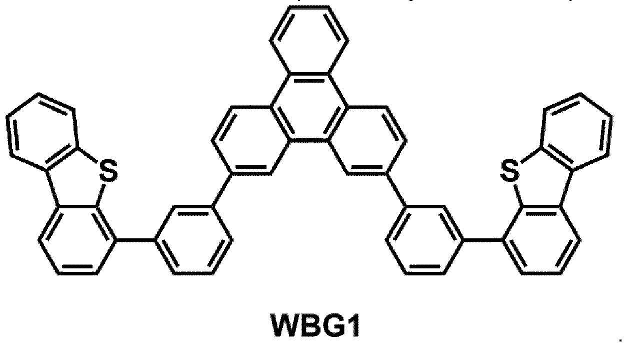

### First organometallic compound and second organometallic compound

The first organometallic compound and the second organometallic compound may be different from each other.

The first organometallic compound and the second organometallic compound may each independently include at least one transition metal.

In an embodiment, the transition metal may be iridium (Ir), platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

In an embodiment, the first organometallic compound and the second organometallic compound may include the same transition metal.

For example, the first organometallic compound and the second organometallic compound may each include Ir or Pt.

In one or more embodiments, the first organometallic compound and the second organometallic compound may include transition metals that are different from each other.

For example, one selected from the first organometallic compound and the second organometallic compound may include Ir, and the other one may include Pt. In some embodiments, the first organometallic compound may include Ir, and the second organometallic compound may include Pt; or the first organometallic compound may include Pt, and the second organometallic compound may include Ir.

In an embodiment, a maximum emission wavelength of the first organometallic compound may be greater than a maximum emission wavelength of the second organometallic compound.

In an embodiment, the absolute value of the HOMO energy level (eV) of the first organometallic compound may be greater than the absolute value of the HOMO energy level (eV) of the second organometallic compound.

In an embodiment, the T1 energy level (eV) of the first organometallic compound may be greater than the T1 energy level (eV) of the second organometallic compound.

In an embodiment, a difference between an absolute value of the HOMO energy level (eV) of the first organometallic compound and an absolute value of the HOMO energy level (eV) of the second organometallic compound may be 0.05 eV or more (e.g., 0.05 eV to 1.0 eV), 0.075 eV or more (e.g., 0.075 eV to 1.0 eV), or 0.1 eV or more (e.g., 0.1 eV to 1.0 eV).

In an embodiment, an amount of the first organometallic compound may be greater than an amount of the second organometallic compound, based on weight.

In an embodiment, the amount of the first organometallic compound may be 7 wt% or more, 8 wt% or more, 9 wt% or more, or 10 wt% or more, based on 100 wt% of the total weight of the emission layer.

In an embodiment, the amount of the second organometallic compound may be 5 wt% or less, 4 wt% or less, or 3 wt% or less, based on 100 wt% of the total weight of the emission layer.

In an embodiment, the first organometallic compound and the second organometallic compound may each emit phosphorescent light.

In an embodiment, the first organometallic compound and the second organometallic compound may each independently include a monodenate ligand, a bidentate ligand, a tridentate ligand, a tetradentate ligand, a pentadentate ligand, a hexadentate ligand, or any combination thereof.

In an embodiment, the first organometallic compound and the second organometallic compound may each be electrically neutral.

In an embodiment, the first organometallic compound and the second organometallic compound may each independently include a compound represented by Formula 401:

Formula 401 M(L₄₀₁)_{xc1}(L₄₀₂)_{xc2}

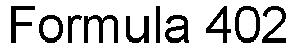

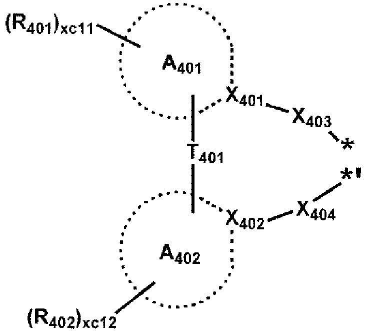

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁(s) may be identical to or different from each other,
L₄₀₂ may be an organic ligand, and xc2 may be 0, 1, 2, 3, or 4, wherein, when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordinate bond, which may also be referred to as coordinate covalent bond or dative bond), O, S, N(Q₄₁₃), B(Q₄₁₃), P(Q₄₁₃), C(Q₄₁₃)(Q₄₁₄), or Si(Q₄₁₃)(Q₄₁₄),
R₄₀₁ and R₄₀₂ may each independently be hydrogen, deuterium, -F, -Cl, -Br,-I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), - B(Q₄₀₁)(Q₄₀₂), -C(=O)(Q₄₀₁), -S(=O)₂(Q₄₀₁), or -P(=O)(Q₄₀₁)(Q₄₀₂),
Q₄₁₁ to Q₄₁₄ and Q₄₀₁ to Q₄₀₃ may each independently be: hydrogen; deuterium; -F; -Cl; -Br; -I; a hydroxyl group; a cyano group; a nitro group; a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, a cyano group, or any combination thereof; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof,
xc11 and xc12 may each independently be an integer from 0 to 10, and
* and *' in Formula 402 each indicate a binding site to M in Formula 401.

For example, in Formula 402, i) X₄₀₁ may be nitrogen, and X₄₀₂ may be carbon, or ii) X₄₀₁ and X₄₀₂ may each be nitrogen.

In one or more embodiments, when xc1 in Formula 401 is 2 or more, two ring A₄₀₁(s) in two or more of L₄₀₁(s) may optionally be linked to each other via T₄₀₂, which is a linking group, and two ring A₄₀₂(s) may be optionally be linked to each other via T₄₀₃, which is a linking group (see Compounds PD1 to PD4 and PD7). T₄₀₂ and T₄₀₃ may each be the same as described in connection with T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, - CN group, a phosphorus group (for example, a phosphine group, a phosphite group, etc.), or any combination thereof.

In an embodiment, the first organometallic compound and the second organometallic compound may each independently include one selected from Compounds PD1 to PD42, or any combination thereof:

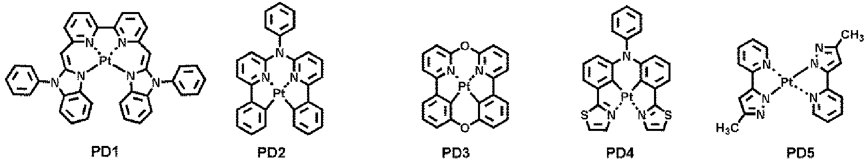

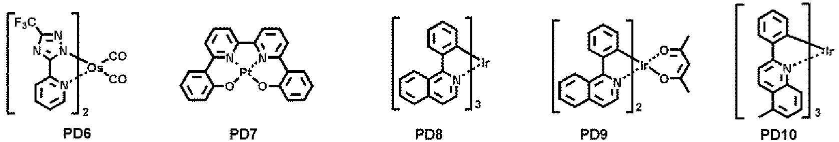

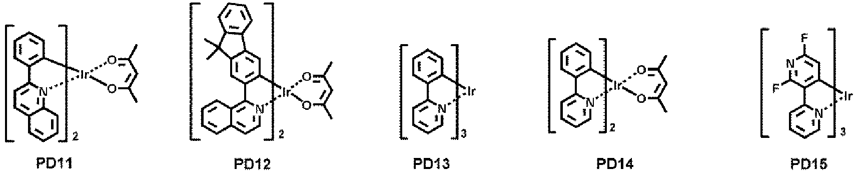

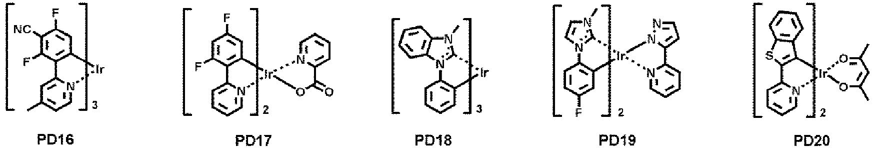

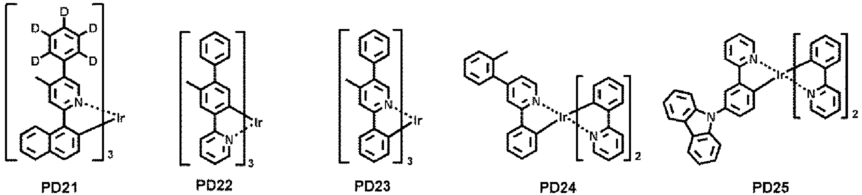

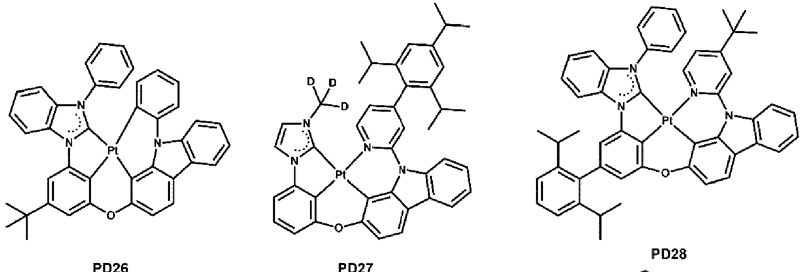

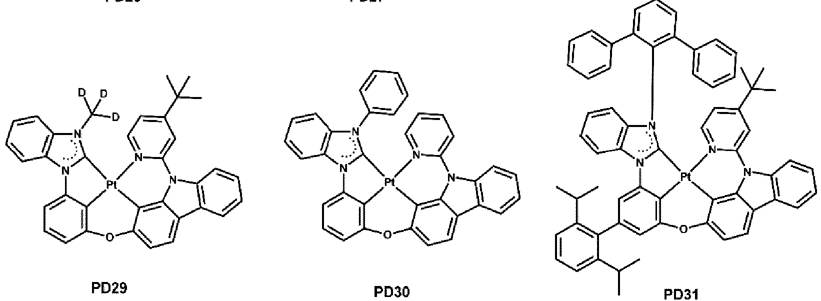

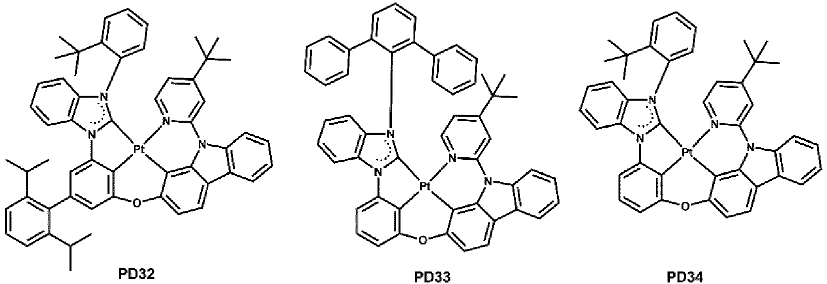

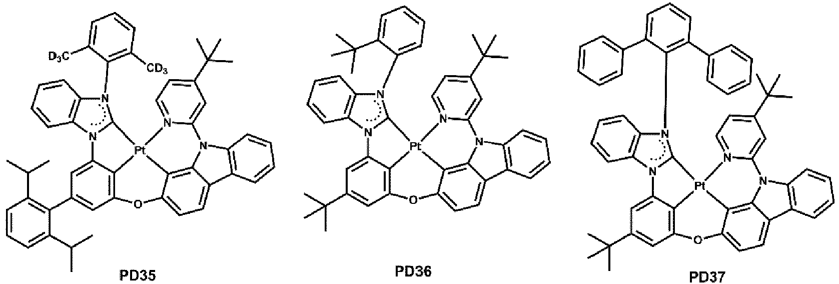

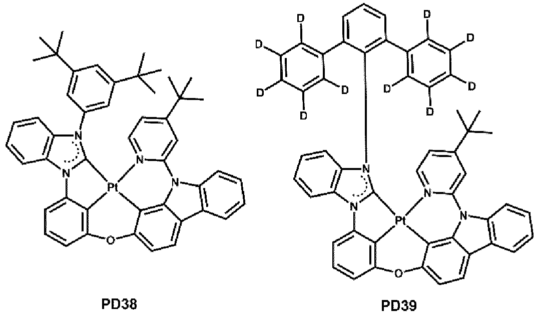

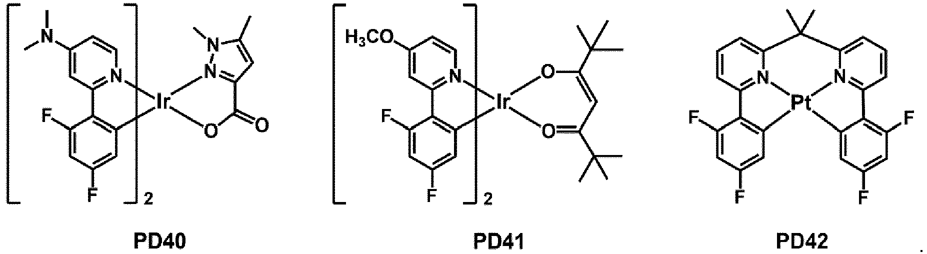

The emission layer of the light-emitting device according to embodiments of the present disclosure includes the first compound to the third compound, the first organometallic compound, and the second organometallic compound.

One selected from the first compound to the third compound (for example, the first compound) is a hole transport host, another one selected from the first compound to the third compound (for example, the second compound) is an electron transport host, and the remaining one selected from the first compound to the third compound (for example, the third compound) is a host having a wide band gap. Thus, in the light-emitting device, by applying the host having a wide band gap to the emission layer, excess carriers in the emission layer may be adjusted (e.g., reduced), and a triplet-polaron quenching phenomenon may be reduced.

In addition, in the light-emitting device, by applying the first organometallic compound and the second organometallic compound to the emission layer at the same time, carriers in the emission layer may be finely adjusted (e.g., balanced), and thus, energy may be efficiently transferred, and the triplet-polaron quenching phenomenon may be reduced.

Accordingly, by including the first compound to the third compound, the first organometallic compound, and the second organometallic compound in the emission layer, the light-emitting device according to embodiments of the present disclosure may have excellent efficiency and lifespan characteristics.

In an embodiment,
the first electrode of the light-emitting device may be an anode,
the second electrode of the light-emitting device may be a cathode,
the interlayer may further include a hole transport region between the first electrode and the emission layer and an electron transport region between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, an electron injection layer, or any combination thereof.

The emission layer in the interlayer of the light-emitting device includes a host and a dopant, the host includes the first compound to the third compound, and the dopant includes the first organometallic compound and the second organometallic compound. That is, the first compound to the third compound may each act as a host, and the first organometallic compound and the second organometallic compound may each act as a dopant. The emission layer may emit red light, green light, blue light, and/or white light. For example, the emission layer may emit blue light. The blue light may have a maximum emission wavelength in a range of, for example, about 400 nm to about 490 nm.

In one or more embodiments, the light-emitting device may include a capping layer outside the first electrode or outside the second electrode.

The term "interlayer," as used herein, refers to a single layer and/or all of a plurality of layers between a first electrode and a second electrode in a light-emitting device.

Another aspect of embodiments of the present disclosure provides an electronic apparatus including the light-emitting device as described above. The electronic apparatus may further include a thin-film transistor. For example, the electronic apparatus may further include a thin-film transistor including a source electrode and a drain electrode, and the first electrode of the light-emitting device may be electrically connected to the source electrode or the drain electrode. The electronic apparatus may further include a color filter, a color conversion layer, a touch screen layer, a polarizing layer, or any combination thereof. More details for the electronic apparatus are the same as described herein.

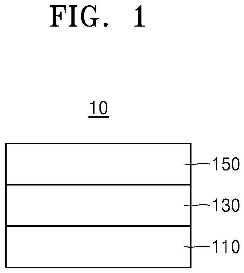

### Description of FIG. 1

FIG. 1 is a schematic cross-sectional view of a light-emitting device 10 according to an embodiment. The light-emitting device 10 includes a first electrode 110, an interlayer 130, and a second electrode 150.

Hereinafter, the structure of the light-emitting device 10 according to an embodiment and a method of manufacturing the light-emitting device 10 will be described with reference to FIG. 1.

### First electrode 110

In FIG. 1, a substrate may be additionally under the first electrode 110 or on the second electrode 150. As the substrate, a glass substrate and/or a plastic substrate may be used. In one or more embodiments, the substrate may be a flexible substrate, and may include plastics having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, the material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, the material for forming the first electrode 110 may be indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, the material for forming the first electrode 110 may be magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layered structure consisting of a single layer or a multi-layered structure including a plurality of layers. For example, the first electrode 110 may have a three-layered structure of ITO/Ag/ITO.

### Interlayer 130

The interlayer 130 is on the first electrode 110. The interlayer 130 includes an emission layer.

The interlayer 130 may further include a hole transport region between the first electrode 110 and the emission layer and an electron transport region between the emission layer and the second electrode 150.

The interlayer 130 may further include, in addition to various suitable organic materials, a metal-containing compound, such as an organometallic compound, an inorganic material, such as a quantum dot, and/or the like.

In one or more embodiments, the interlayer 130 may include, i) two or more emitting units sequentially stacked between the first electrode 110 and the second electrode 150, and ii) a charge generation layer between the two or more emitting units. When the interlayer 130 includes the emitting units and the charge generation layer as described above, the light-emitting device 10 may be a tandem light-emitting device.

### Hole transport region in interlayer 130

The hole transport region may have i) a single-layered structure consisting of a single layer consisting of a single material, ii) a single-layered structure consisting of a single layer consisting of a plurality of different materials, or iii) a multi-layered structure including a plurality of layers including different materials.

The hole transport region may include a hole injection layer, a hole transport layer, an emission auxiliary layer, an electron blocking layer, or any combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure being stacked sequentially from the first electrode 110.

The hole transport region may include a compound represented by Formula 201, a compound represented by Formula 202, or any combination thereof: 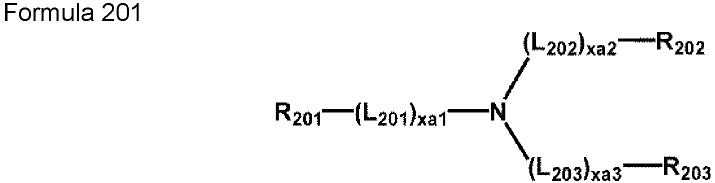 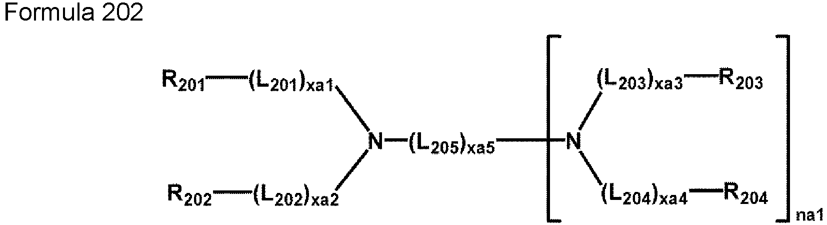 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (for example, a carbazole group, etc.) unsubstituted or substituted with at least one R₁₀ₐ (for example, Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₆-C₆₀ polycyclic group unsubstituted or substituted with at least one R₁₀ₐ, and
na1 may be an integer from 1 to 4.

For example, each of Formulae 201 and 202 may include at least one selected from groups represented by Formulae CY201 to CY217: 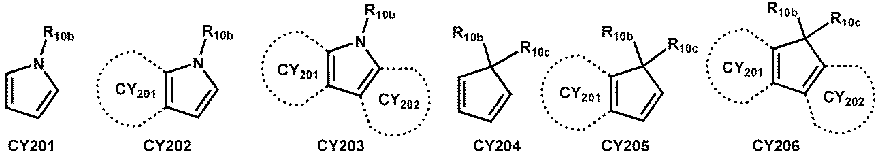 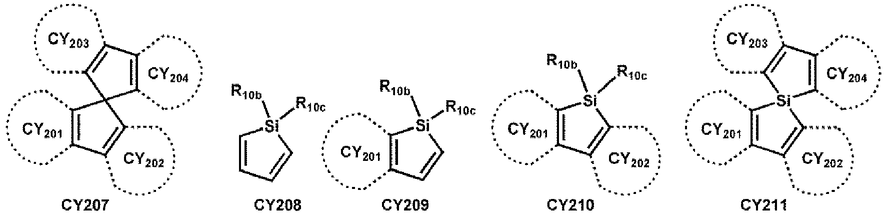 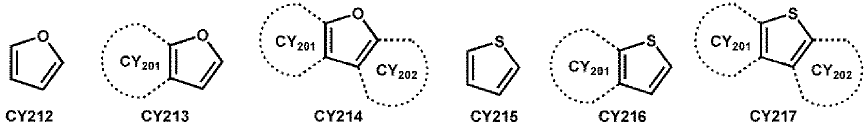 wherein, in Formulae CY201 to CY217, R_{10b} and R_{10c} may each be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described herein.

In an embodiment, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from groups represented by Formulae CY201 to CY203.

In one or more embodiments, Formula 201 may include at least one selected from groups represented by Formulae CY201 to CY203 and at least one selected from groups represented by Formulae CY204 to CY217.

In one or more embodiments, in Formula 201, xa1 may be 1, R₂₀₁ may be a group represented by one selected from Formulae CY201 to CY203, xa2 may be 0, and R₂₀₂ may be a group represented by one selected from Formulae CY204 to CY207.

In one or more embodiments, each of Formulae 201 and 202 may not include a group represented by one selected from Formulae CY201 to CY203.

In one or more embodiments, each of Formulae 201 and 202 may not include a group represented by one selected from Formulae CY201 to CY203, and may include at least one selected from groups represented by Formulae CY204 to CY217.

In one or more embodiments, each of Formulae 201 and 202 may not include a group represented by one selected from Formulae CY201 to CY217.

For example, the hole transport region may include one selected from Compounds HT1 to HT46, m-MTDATA, TDATA, 2-TNATA, N,N'-Bis(naphthalen-1-yl)-N,N'-bis(phenyl)-2,2'-dimethylbenzidine (α-NPD), NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

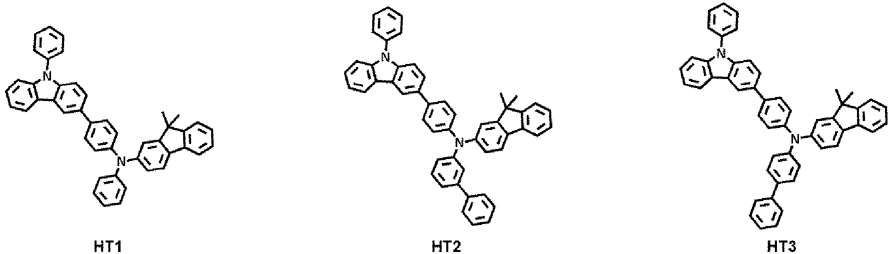

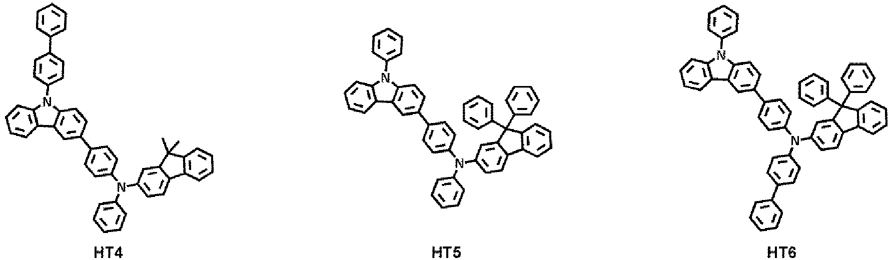

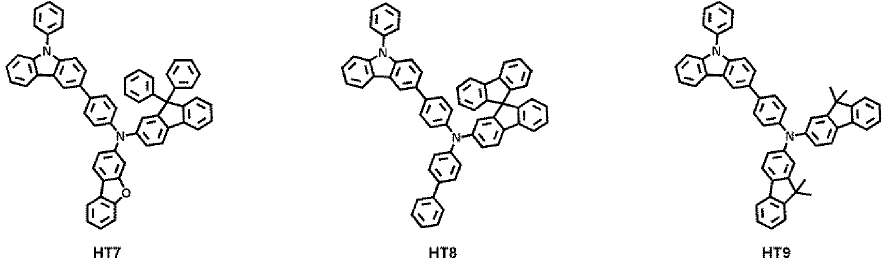

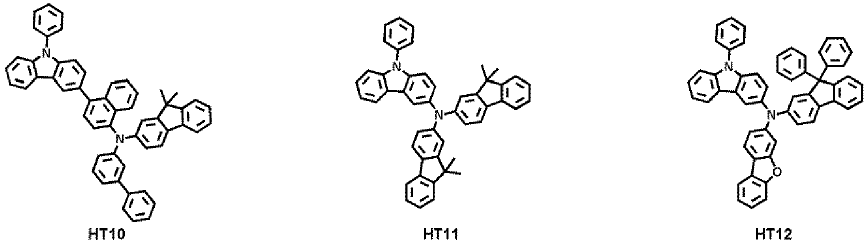

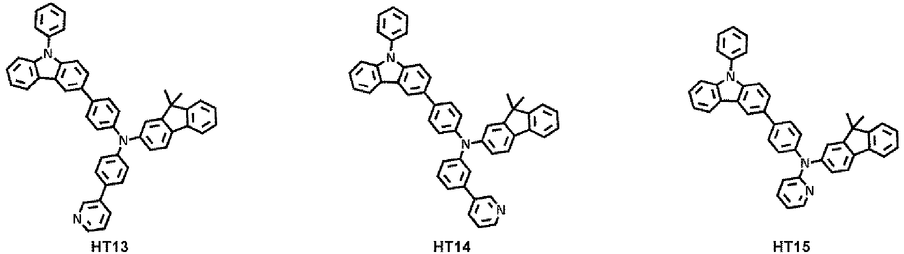

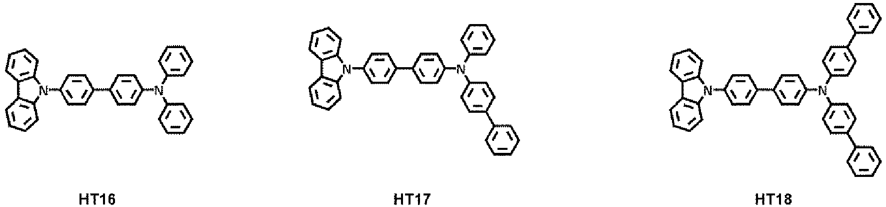

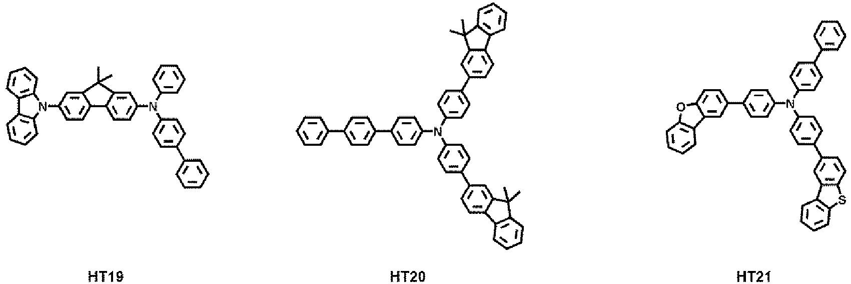

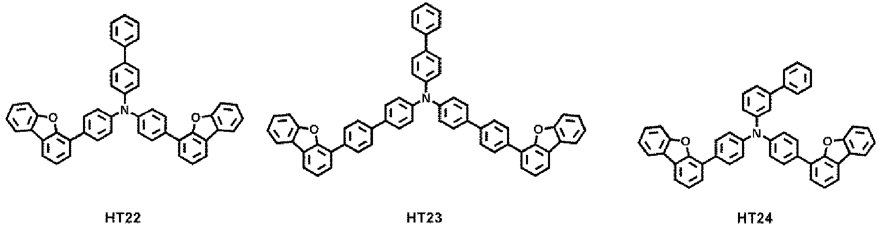

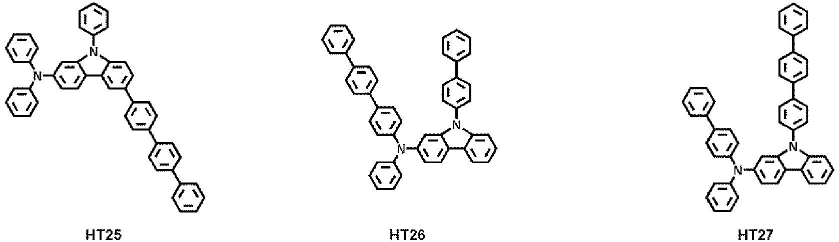

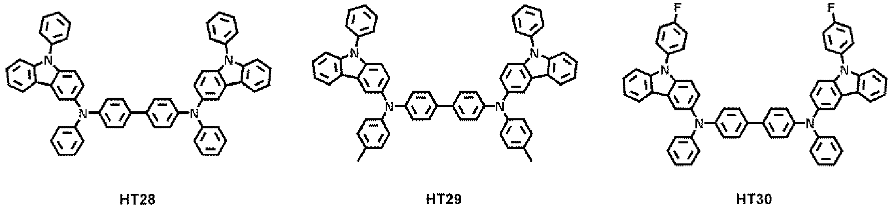

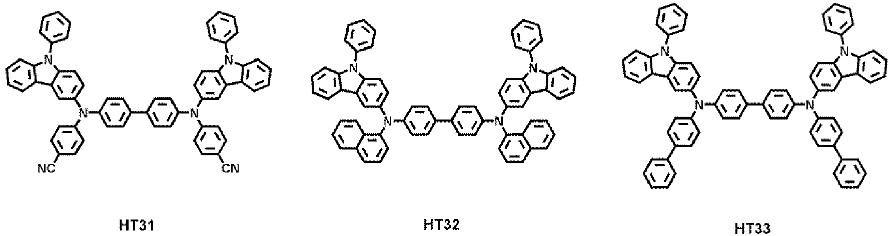

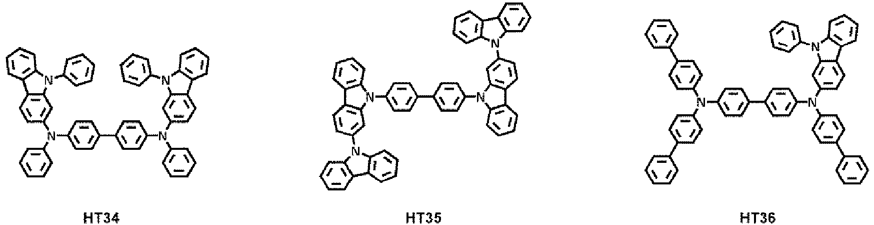

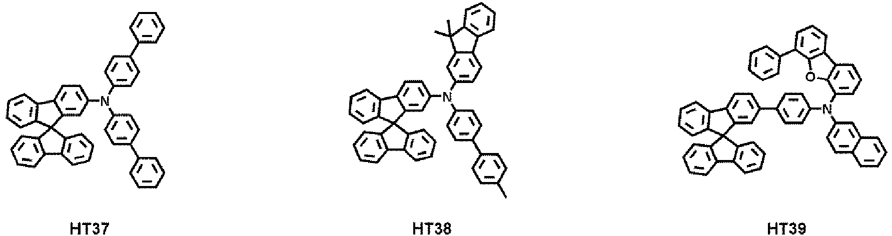

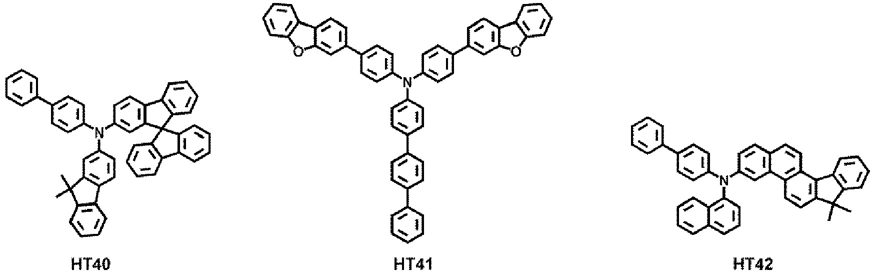

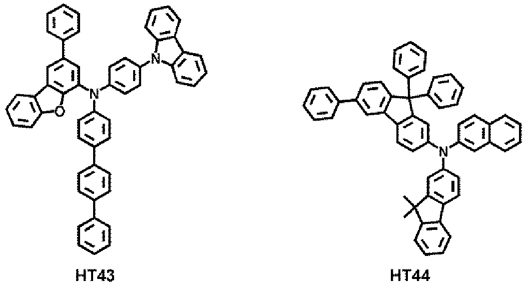

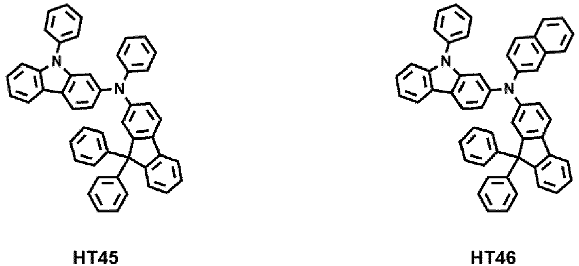

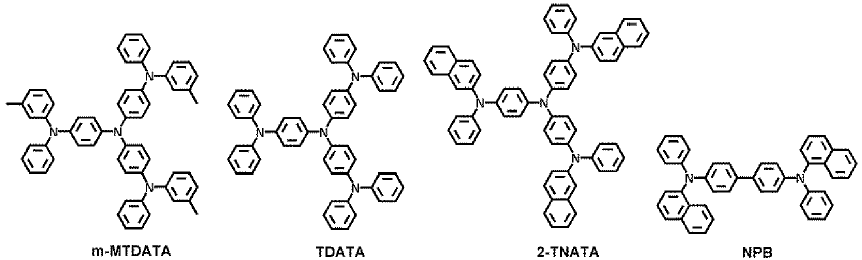

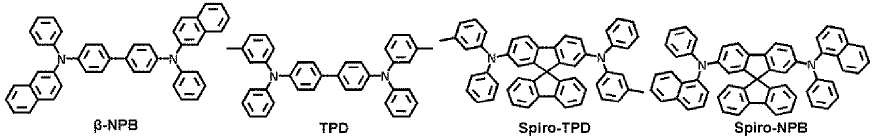

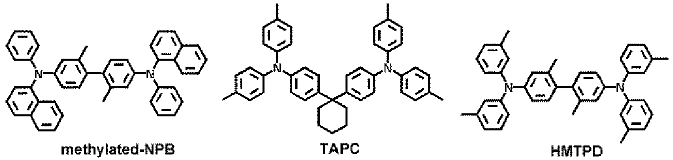

In an embodiment, the hole injection layer and electron bloking layer may comprise a compound represented by Formula 203. 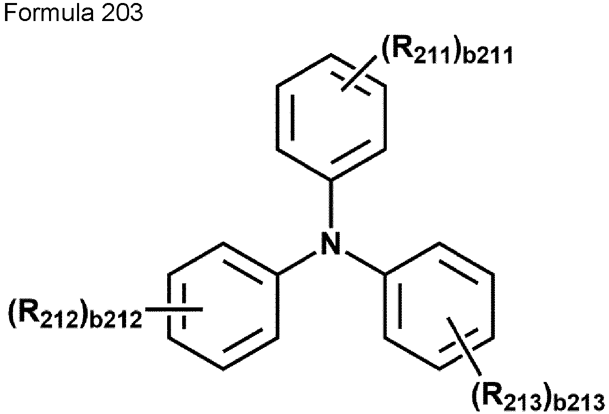 wherein, in formula 203,
R₂₁₁ to R₃₁₂ may each independently be hydrogen, deuterium, -F, -Cl, -Br, -I, a cyano group, a C₁-C₆₀ alkyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, R₁₀ₐ may be understood by referring to the description of R₁₀ₐ provided herein, and
b211 to b213 may each independently be an integer from 0 to 5.

In an embodiment, when the hole injection layer and the electron blocking layer each comprise the compound represented by formula 203, the compound represented by formula 203 comprised in the hole injection layer and , the compound represented by formula 203 comprised the electron blocking layer may be identical to each other.

In one or more embodiment, when the hole injection layer and the electron blocking layer each comprise the compound represented by formula 203, the compound represented by formula 203 comprised in the hole injection layer and , the compound represented by formula 203 comprised the electron blocking layer may be different from each other.

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within the ranges described above, suitable or satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the leakage of electrons from an emission layer to a hole transport region. Materials that may be included in the hole transport region may be included in the emission auxiliary layer and the electron blocking layer.

### p-dopant

The hole transport region may further include, in addition to the materials as described above, a charge generation material for improving conductive properties (e.g., electrically conductive properties). The charge generation material may be uniformly or non-uniformly dispersed in the hole transport region (for example, in the form of a single layer consisting of a charge generation material).

The charge generation material may be, for example, a p-dopant.

For example, a LUMO energy level of the p-dopant may be -3.5 eV or less.

In an embodiment, the p-dopant may include a quinone derivative, a cyano group-containing compound, a compound containing element EL1 and element EL2, or any combination thereof.

Examples of the quinone derivative may include TCNQ and F4-TCNQ.

Examples of the cyano group-containing compound may include HAT-CN and a compound represented by Formula 221: 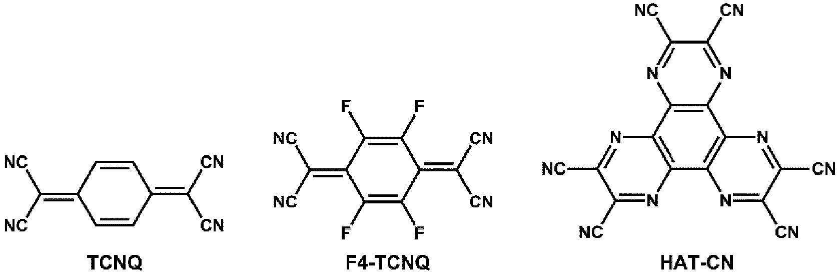 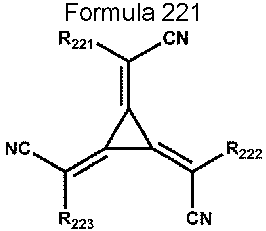 wherein, in Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, - Br, -I, or any combination thereof; or any combination thereof.

In the compound containing element EL1 and element EL2, element EL1 may be metal, metalloid, or any combination thereof, and element EL2 may be non-metal, metalloid, or any combination thereof.

Examples of the metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid may include silicon (Si), antimony (Sb), and tellurium (Te).

Examples of the non-metal may include oxygen (O) and halogen (for example, F, Cl, Br, I, etc.).

For example, the compound containing element EL1 and element EL2 may include metal oxide, metal halide (for example, metal fluoride, metal chloride, metal bromide, metal iodide, etc.), metalloid halide (for example, metalloid fluoride, metalloid chloride, metalloid bromide, metalloid iodide, etc.), metal telluride, or any combination thereof.

Examples of the metal oxide may include tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoO₃, Mo₂O₅, etc.), and rhenium oxide (for example, ReO₃, etc.).

Examples of the metal halide may include alkali metal halide, alkaline earth metal halide, transition metal halide, post-transition metal halide, and lanthanide metal halide.

Examples of the alkali metal halide may include LiF, NaF, KF, RbF, CsF, LiCl, NaCl, KCI, RbCl, CsCl, LiBr, NaBr, KBr, RbBr, CsBr, Lil, Nal, KI, Rbl, and CsI.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of the transition metal halide may include titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, Nbl₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, AgI, etc.), and gold halide (for example, AuF, AuCl, AuBr, Aul, etc.).

Examples of the post-transition metal halide may include zinc halide (for example, ZnF₂, ZnCl₂, ZnBr₂, ZnI₂, etc.), indium halide (for example, InI₃, etc.), and tin halide (for example, SnI₂, etc.).

Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, and SmI₃.

Examples of the metalloid halide may include antimony halide (for example, SbCls, etc.).

Examples of the metal telluride may include alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, , ReTeHfTe₂, V₂Te₃, Nb₂Te₃, Ta₂Te₃, Cr₂Te₃, Mo₂Te₃, W₂Te₃, MnTe, TcTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a subpixel. In one or more embodiments, the emission layer may have a stacked structure of two or more layers of a red emission layer, a green emission layer, and a blue emission layer, in which the two or more layers contact (e.g., physically contact) each other or are separated (e.g., spaced apart) from each other to emit white light. In one or more embodiments, the emission layer may include two or more materials selected from a red light-emitting material, a green light-emitting material, and a blue light-emitting material, in which the two or more materials are mixed together with each other in a single layer to emit white light.

The emission layer includes a host and a dopant. The dopant includes a phosphorescent dopant, a fluorescent dopant, or any combination thereof.

An amount of the dopant in the emission layer may be in a range of about 0.01 part by weight to about 15 parts by weight based on 100 parts by weight of the host.

In one or more embodiments, the emission layer may include a quantum dot.

The emission layer may include a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within the range described above, excellent light-emission characteristics may be obtained without a substantial increase in driving voltage.

### Host

The host may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), - N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be the same as described in connection with Q₁.

For example, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or any combination thereof: 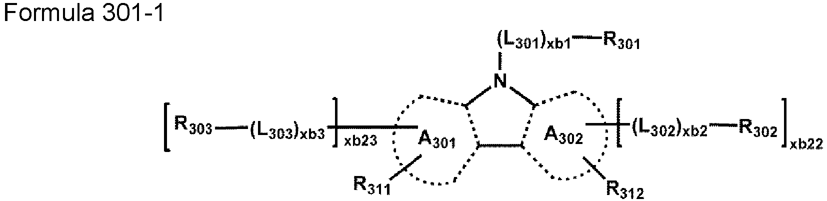 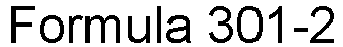 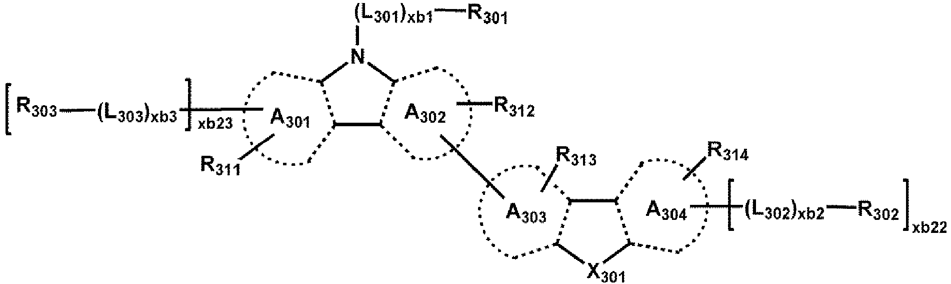 wherein, in Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each be the same as described in connection with R₃₀₁.

In one or more embodiments, the host may include an alkali earth metal complex, a post-transition metal complex, or any combination thereof. For example, the host may include a Be complex (for example, Compound H55), an Mg complex, a Zn complex, or any combination thereof.

In one or more embodiments, the host may include one selected from Compounds H1 to H124, 9,10-di(2-naphthyl)anthracene (I), 2-methyl-9,10-bis(naphthalen-2-yl)anthracene (MADN), 9,10-di-(2-naphthyl)-2-t-butyl-anthracene (TBADN),",4'-bis(N-carbazolyl)",1'-biphenyl (CBP), 1,3-di-9-carbazolylbenzene (mCP), 1,3,5-tri(carbazol-9-yl)benzene (TCP), or any combination thereof:

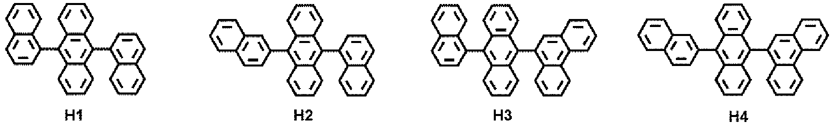

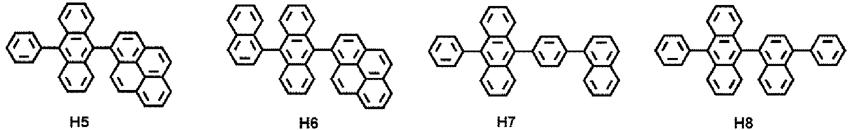

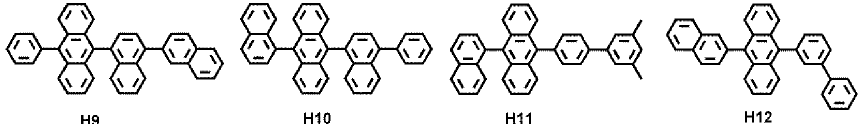

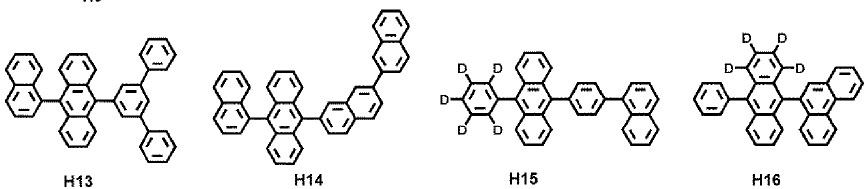

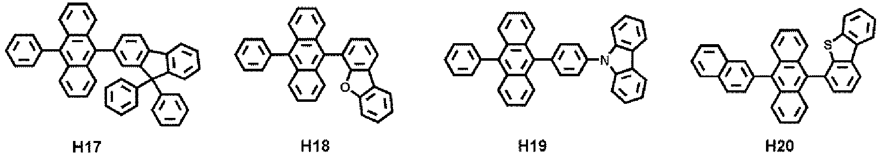

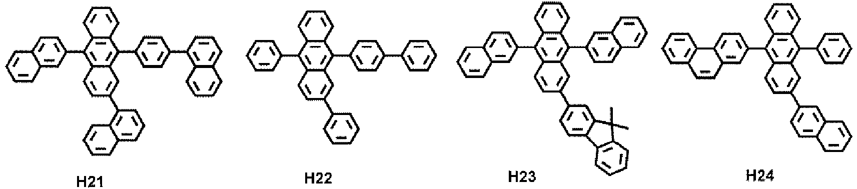

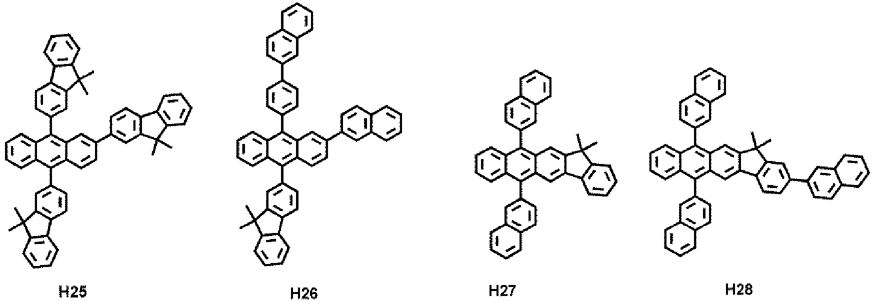

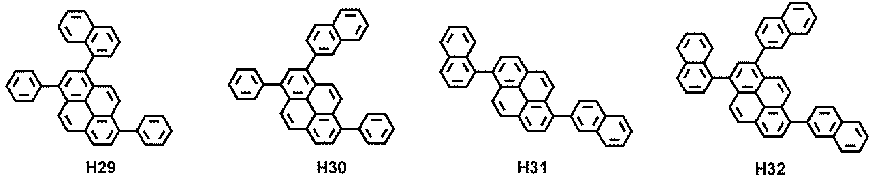

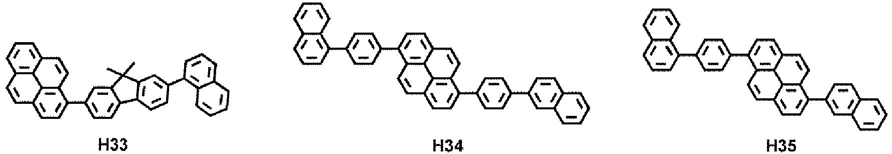

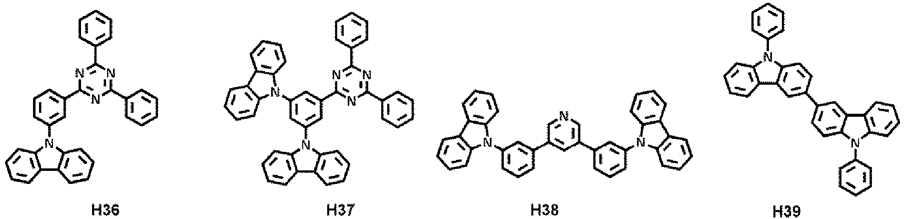

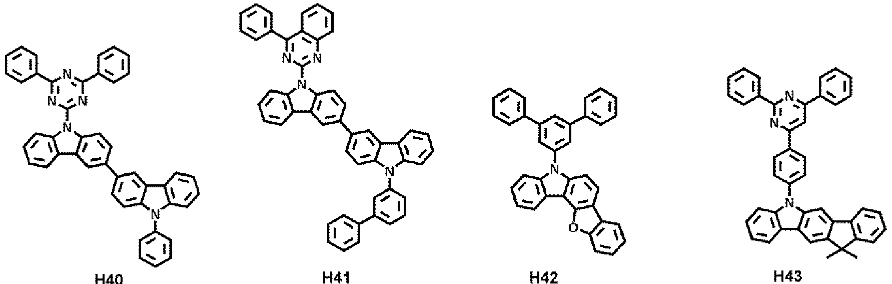

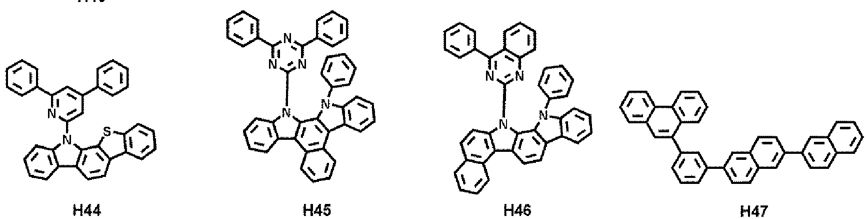

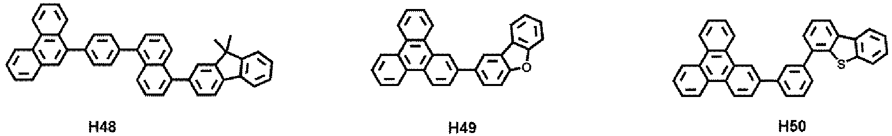

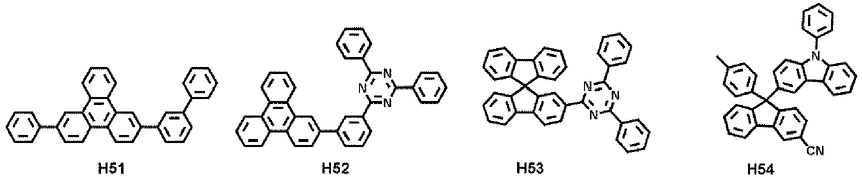

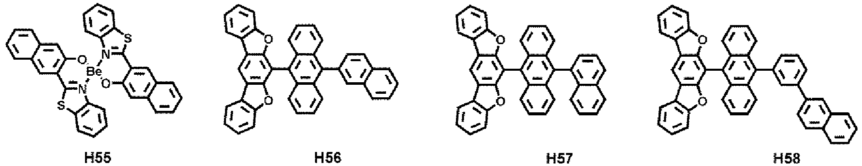

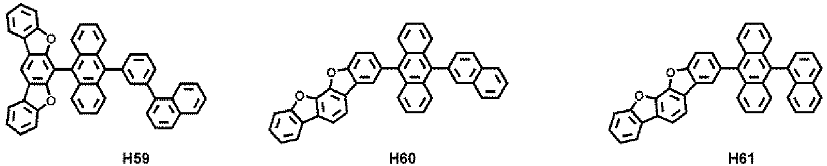

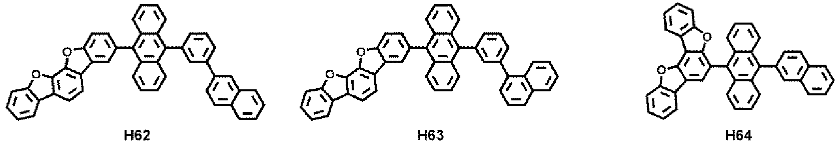

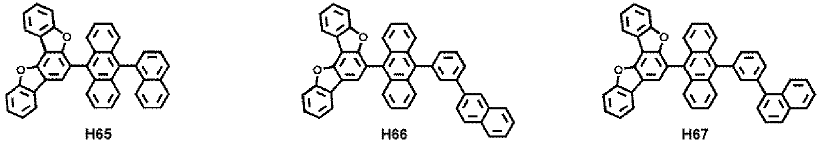

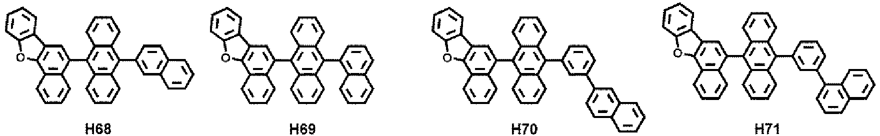

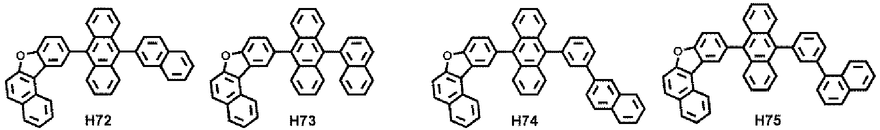

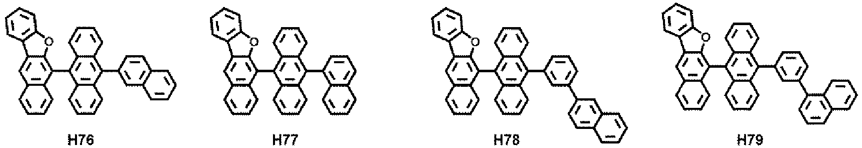

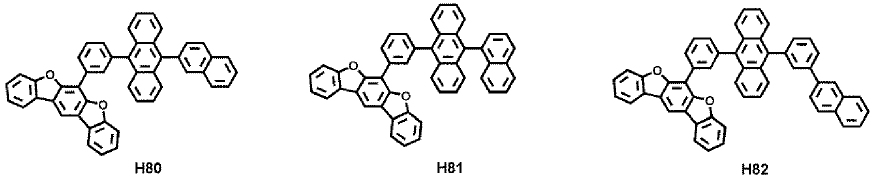

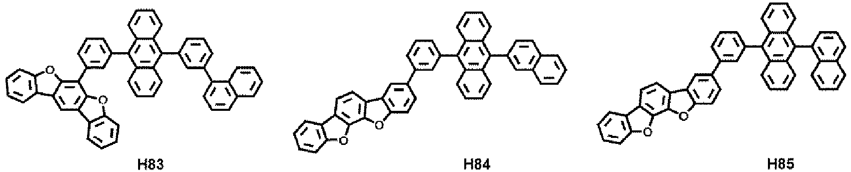

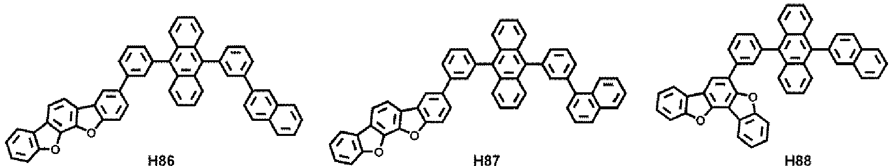

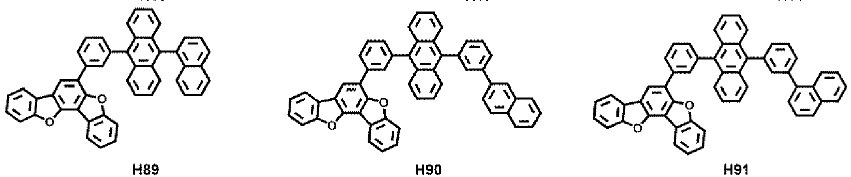

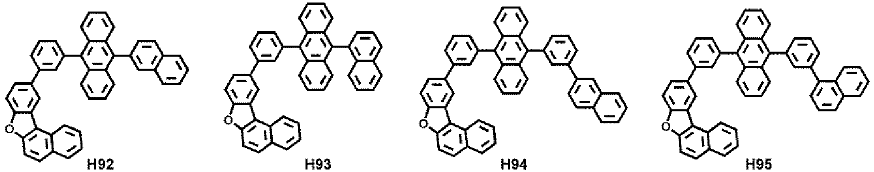

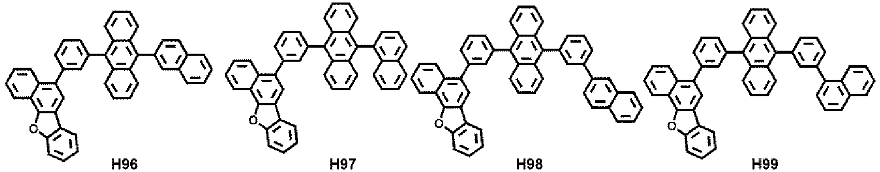

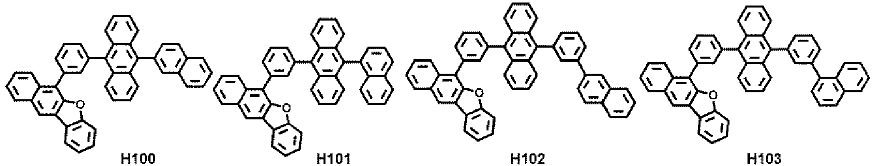

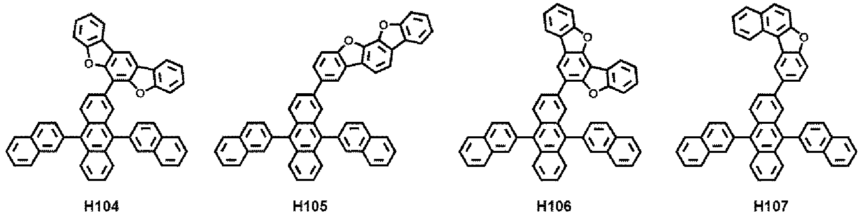

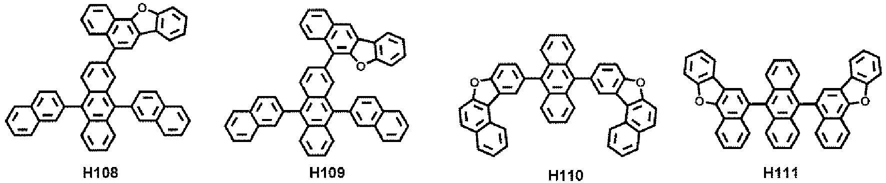

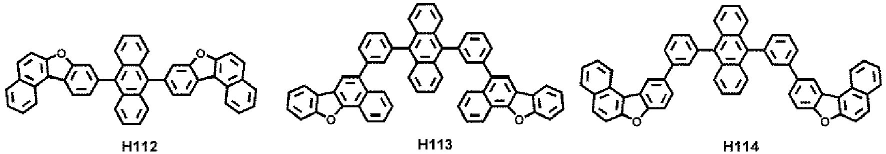

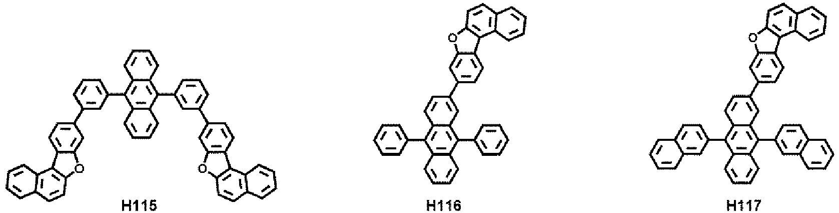

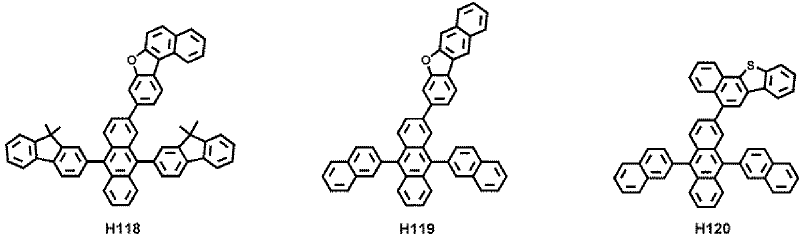

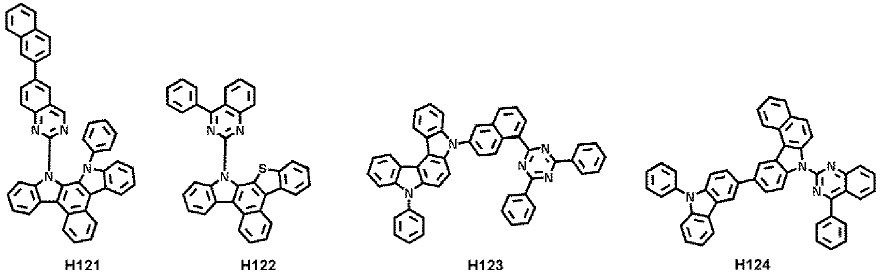

### Phosphorescent dopant

The phosphorescent dopant includes at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

For example, the phosphorescent dopant may include an organometallic compound represented by Formula 401:

Formula 401 M(L₄₀₁)_{xc1}(L₄₀₂)_{xc2}

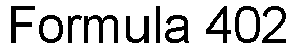

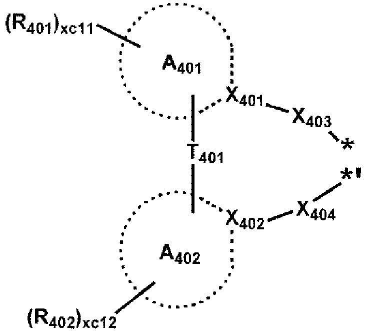

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁(s) may be identical to or different from each other,
L₄₀₂ may be an organic ligand, and xc2 may be 0, 1, 2, 3, or 4, wherein, when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordinate bond, which may also be referred to as a coordinate covalent bond or a dative bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), - B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described in connection with Q₁,
xc11 and xc12 may each independently be an integer from 0 to 10, and'*'and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 401 is 2 or more, two ring A₄₀₁(s) in two or more of L₄₀₁(s) may be optionally linked to each other via T₄₀₂, which is a linking group, and two ring A₄₀₂(s) may be optionally linked to each other via T₄₀₃, which is a linking group (see Compounds PD1 to PD4 and PD7). T₄₀₂ and T₄₀₃ may each be the same as described in connection with T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, - CN group, a phosphorus group (for example, a phosphine group, a phosphite group, etc.), or any combination thereof.

The phosphorescent dopant may include, for example, one selected from Compounds PD1 to PD42, or any combination thereof:

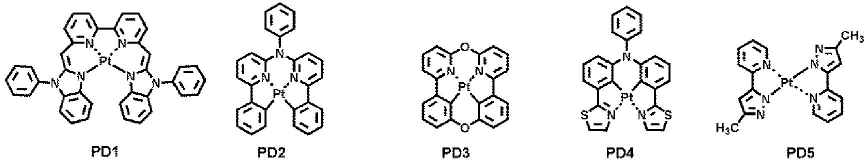

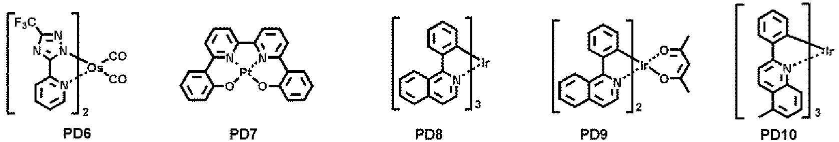

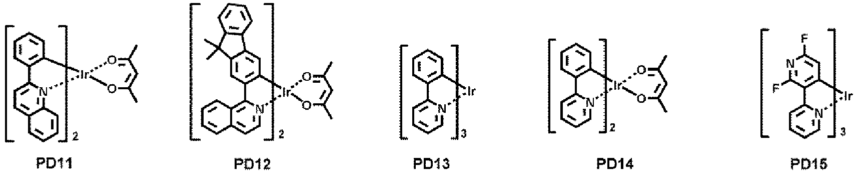

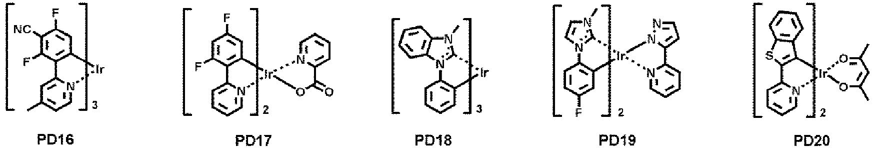

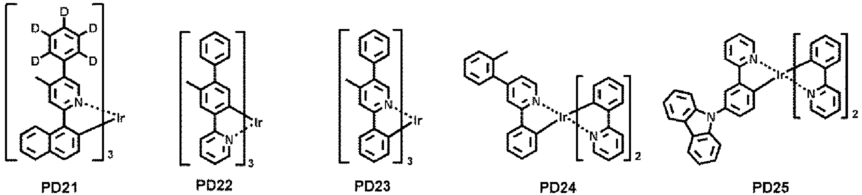

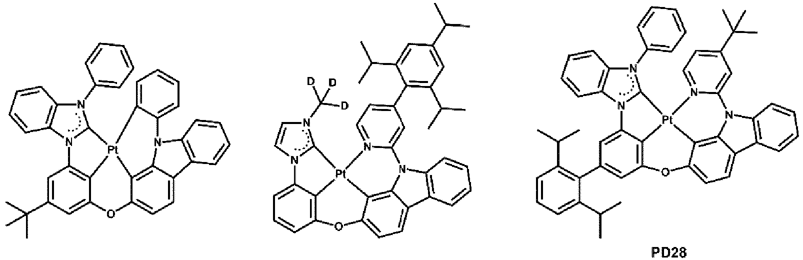

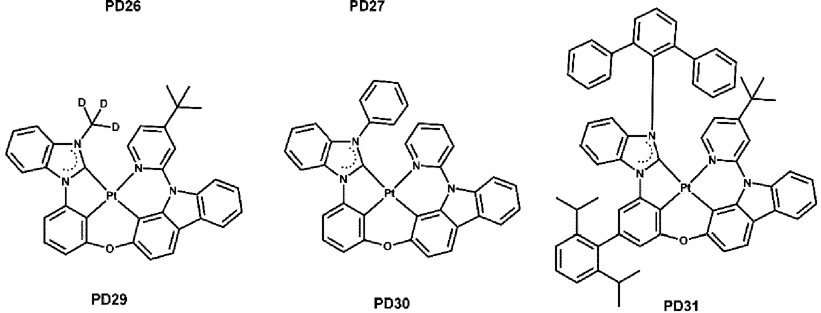

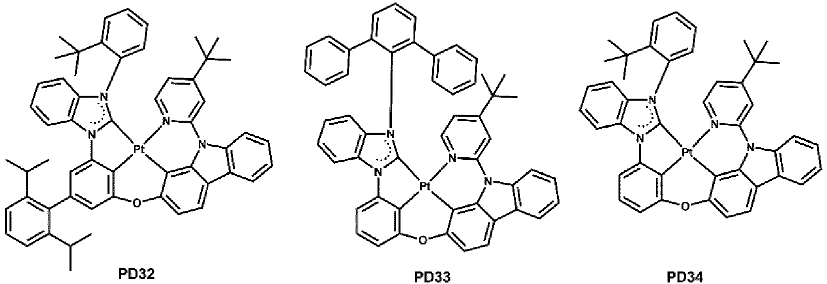

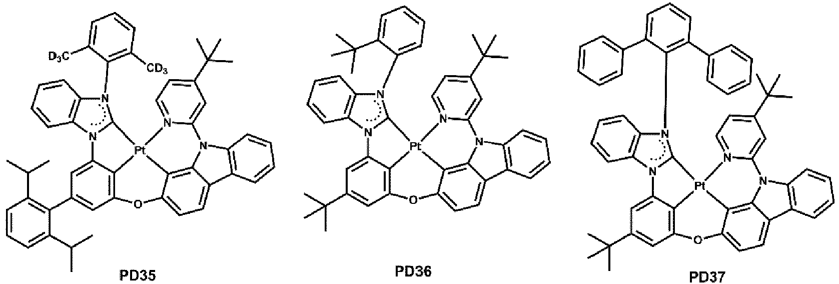

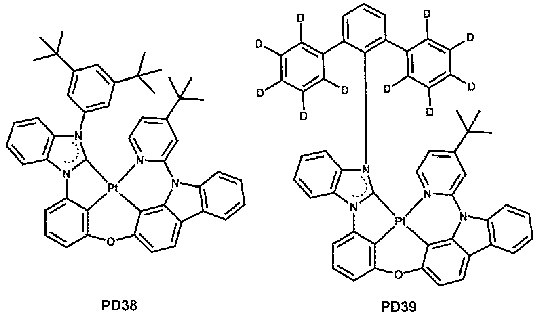

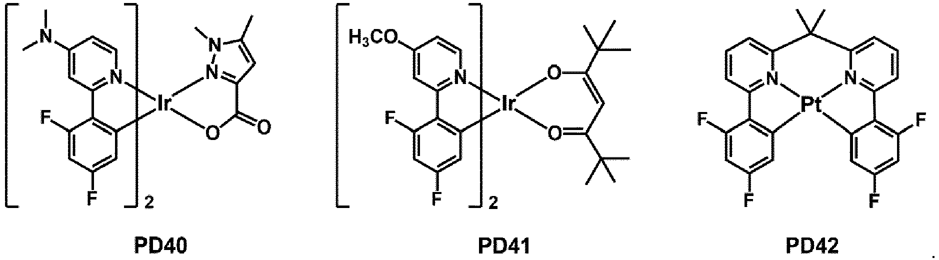

### Fluorescent dopant

The fluorescent dopant may include an amine group-containing compound, a styryl group-containing compound, or any combination thereof.

For example, the fluorescent dopant may include a compound represented by Formula 501: 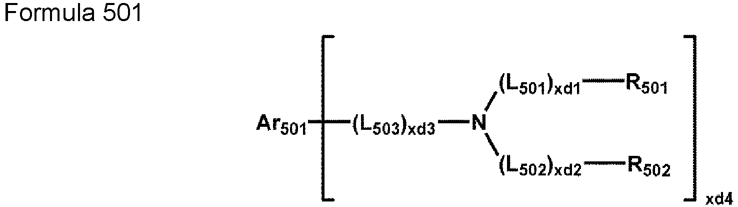 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, a pyrene group, etc.) in which three or more monocyclic groups are condensed together.

In one or more embodiments, xd4 in Formula 501 may be 2.

For example, the fluorescent dopant may include one selected from Compounds FD1 to FD36, DPVBi, DPAVBi, or any combination thereof:

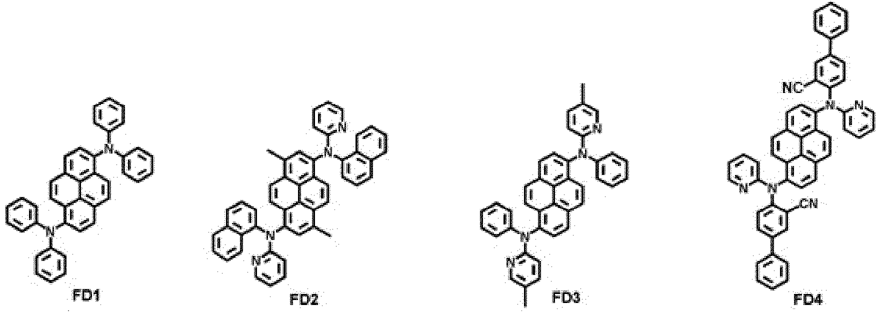

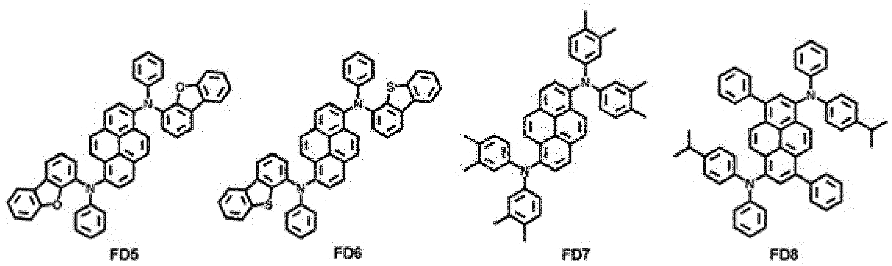

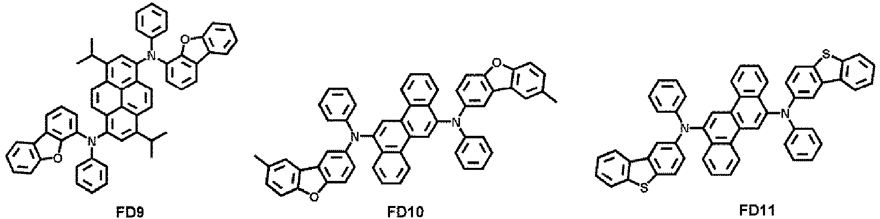

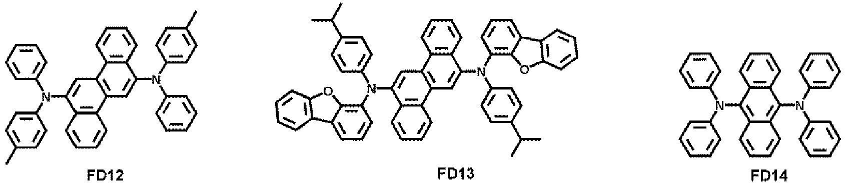

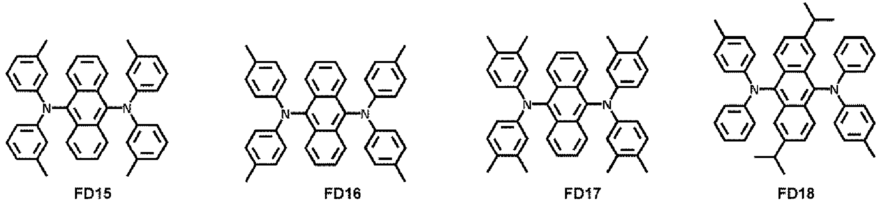

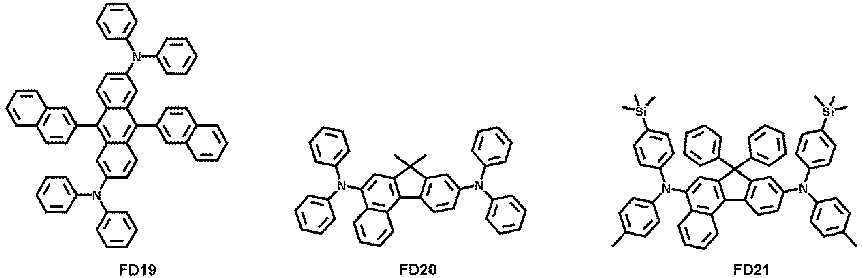

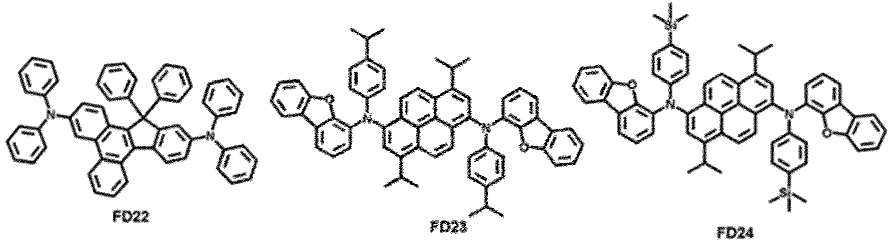

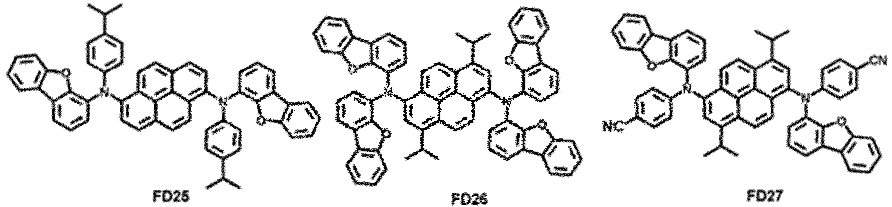

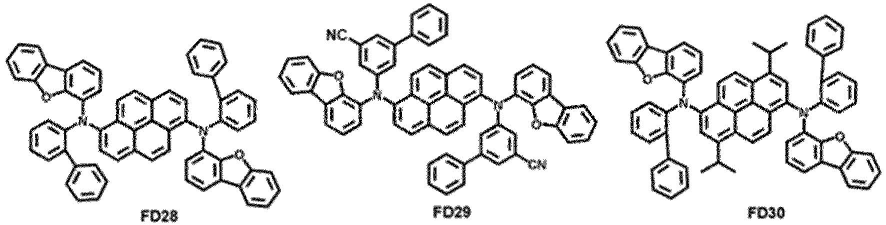

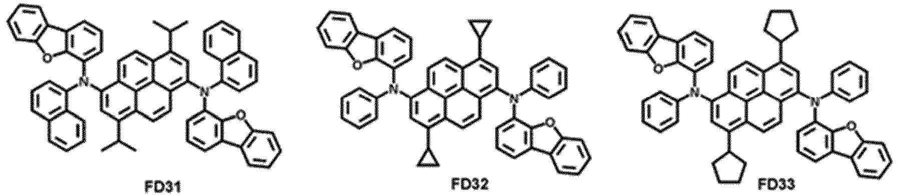

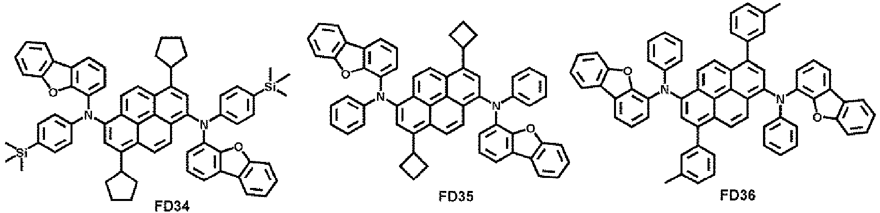

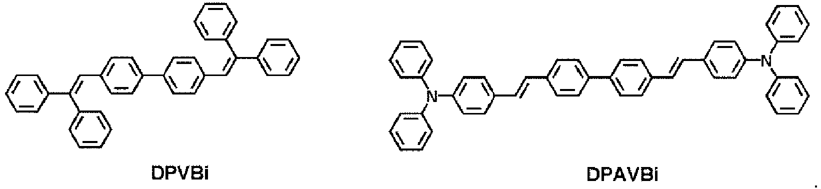

### Delayed fluorescence material

The emission layer may include a delayed fluorescence material.

In the present specification, the delayed fluorescence material may be selected from compounds capable of emitting delayed fluorescent light based on a delayed fluorescence emission mechanism.

The delayed fluorescence material included in the emission layer may act as a host or a dopant depending on the type (or kind) of other materials included in the emission layer.

In an embodiment, a difference between a triplet energy level (eV) of the delayed fluorescence material and a singlet energy level (eV) of the delayed fluorescence material may be equal to or greater than 0 eV and equal to or less than 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

For example, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, a π electron-deficient nitrogen-containing C₁-C₆₀ cyclic group, etc.), and ii) a material including a C₈-C₆₀ polycyclic group in which two or more cyclic groups are condensed together while sharing boron (B).

Examples of the delayed fluorescence material may include at least one selected from Compounds DF1 to DF9:

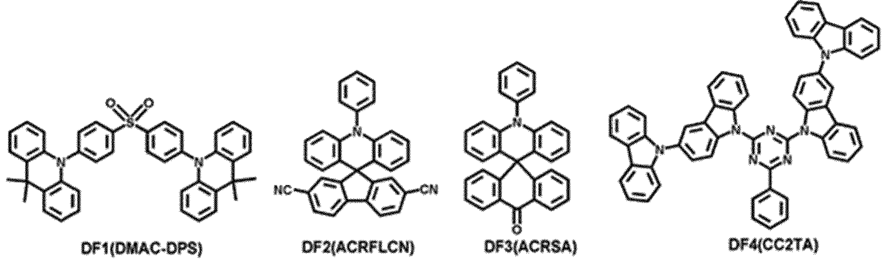

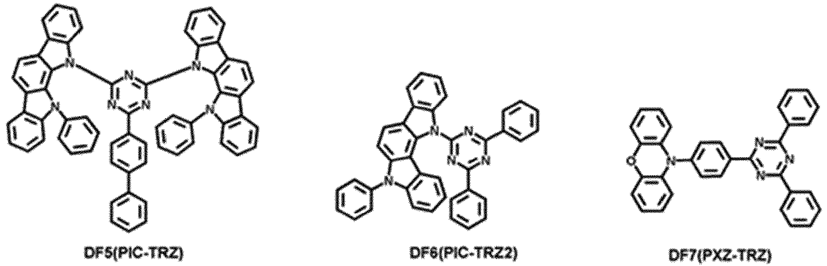

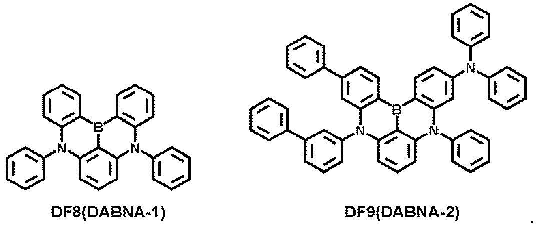

### Quantum dot

The emission layer may include a quantum dot.

The term "quantum dot," as used herein, refers to a crystal of a semiconductor compound, and may include any suitable material capable of emitting light of various suitable emission wavelengths according to the size of the crystal.

A diameter of the quantum dot may be, for example, in a range of about 1 nm to about 10 nm.

The quantum dot may be synthesized by a wet chemical process, a metal organic chemical vapor deposition process, a molecular beam epitaxy process, and/or any suitable process similar thereto.

The wet chemical process is a method including mixing together a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles may be controlled through a process which is more easily performed than vapor deposition methods, such as metal organic chemical vapor deposition (MOCVD) or molecular beam epitaxy (MBE), and which has low costs.

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound may include: a binary compound, such as CdS, CdSe, CdTe, ZnS, ZnSe, ZnTe, ZnO, HgS, HgSe, HgTe, MgSe, and/or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound, such as CdZnSeS, CdZnSeTe, CdZnSTe, CdHgSeS, CdHgSeTe, CdHgSTe, HgZnSeS, HgZnSeTe, and/or HgZnSTe; or any combination thereof.

Examples of the Group III-V semiconductor compound may include: a binary compound, such as GaN, GaP, GaAs, GaSb, AIN, AlP, AlAs, AlSb, InN, InP, InAs, and/or InSb; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, and/or InPSb; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and/or InAlPSb; or any combination thereof. In an embodiment, the Group III-V semiconductor compound may further include a Group II element. Examples of the Group III-V semiconductor compound further including a Group II element may include InZnP, InGaZnP, and InAlZnP.

Examples of the Group III-VI semiconductor compound may include: a binary compound, such as GaS, GaSe, Ga₂Se₃, GaTe, InS, InSe, In₂S₃, In₂Se₃, and/or InTe; a ternary compound, such as InGaS₃ and/or InGaSe₃; or any combination thereof.

Examples of the Group I-III-VI semiconductor compound may include: a ternary compound, such as AgInS, AgInS₂, CuInS, CuInS₂, CuGaO₂, AgGaO₂, and/or AgAlO₂; or any combination thereof.

Examples of the Group IV-VI semiconductor compound may include: a binary compound, such as SnS, SnSe, SnTe, PbS, PbSe, and/or PbTe; a ternary compound, such as SnSeS, SnSeTe, SnSTe, PbSeS, PbSeTe, PbSTe, SnPbS, SnPbSe, and/or SnPbTe; a quaternary compound, such as SnPbSSe, SnPbSeTe, and/or SnPbSTe; or any combination thereof.

The Group IV element or compound may include: a single element, such as Si or Ge; a binary compound, such as SiC and/or SiGe; or any combination thereof.

Each element included in a multi-element compound, such as the binary compound, the ternary compound, and the quaternary compound, may be present at a uniform concentration or non-uniform concentration in a particle.

The quantum dot may have a single structure in which the concentration of each element in the quantum dot is uniform (e.g., substantially uniform), or a core-shell dual structure. For example, a material included in the core and a material included in the shell may be different from each other.

The shell of the quantum dot may act as a protective layer that prevents or reduces chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases along a direction toward the center of the core.

Examples of the shell of the quantum dot may include an oxide of metal, metalloid, and/or non-metal, a semiconductor compound, or any combination thereof. Examples of the oxide of metal, metalloid, and/or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO; a ternary compound, such as MgAl₂O₄, CoFe₂O₄, NiFe₂O₄, and/or CoMn₂O₄; or any combination thereof. Examples of the semiconductor compound may include, as described herein, a Group II-VI semiconductor compound; a Group III-V semiconductor compound; a Group III-VI semiconductor compound; a Group I-III-VI semiconductor compound; a Group IV-VI semiconductor compound; or any combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of an emission wavelength spectrum of the quantum dot may be about 45 nm or less, for example, about 40 nm or less, for example, about 30 nm or less, and within these ranges, color purity and/or color reproducibility may be improved. In addition, because the light emitted through the quantum dot is emitted in all directions (e.g., substantially all directions), the viewing angle of light may be improved.

In addition, the quantum dot may be in the form of spherical, pyramidal, multi-arm, and/or cubic nanoparticles, nanotubes, nanowires, nanofibers, and/or nanoplate particles.

Because the energy band gap may be adjusted by controlling the size of the quantum dot, light having various suitable wavelength bands may be obtained from an emission layer including the quantum dot. Accordingly, by using quantum dots of different sizes, a light-emitting device that emits light of various suitable wavelengths may be implemented. In more detail, the size of the quantum dot may be selected to emit red, green and/or blue light. In addition, the size of the quantum dot may be configured to emit white light by combination of light of various suitable colors.

### Electron transport region in interlayer 130

The electron transport region may have i) a single-layered structure consisting of a single layer consisting of a single material, ii) a single-layered structure consisting of a single layer consisting of a plurality of different materials, or iii) a multi-layered structure including a plurality of layers including different materials.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from the emission layer.

The electron transport region (for example, the buffer layer, the hole blocking layer, the electron control layer, or the electron transport layer in the electron transport region) may include a metal-free compound including at least one π electron-deficient nitrogen-containing C₁-C₆₀ cyclic group.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one selected from Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁(s) may be linked to each other via a single bond.

In one or more embodiments, Ar₆₀₁ in Formula 601 may be a substituted or unsubstituted anthracene group.

In one or more embodiments, the electron transport region may include a compound represented by Formula 601-1: 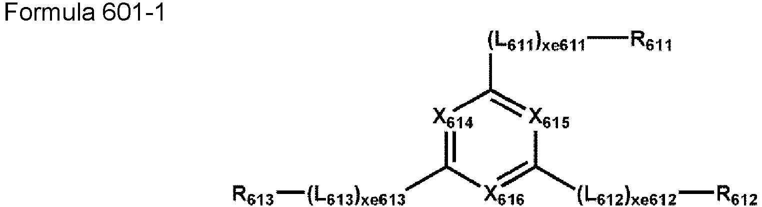 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each be the same as described in connection with L₆₀₁,
xe611 to xe613 may each be the same as described in connection with xe1,
R₆₁₁ to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include one selected from Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

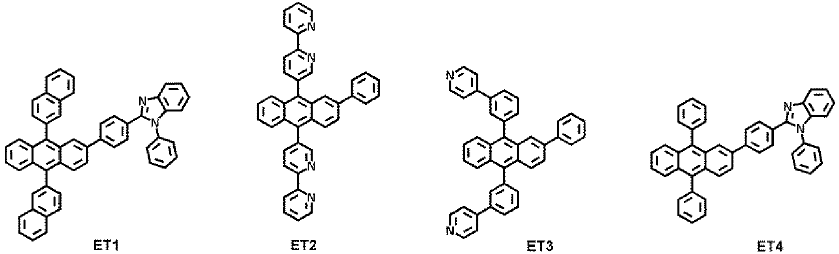

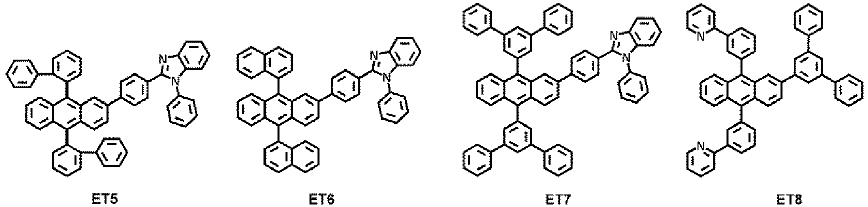

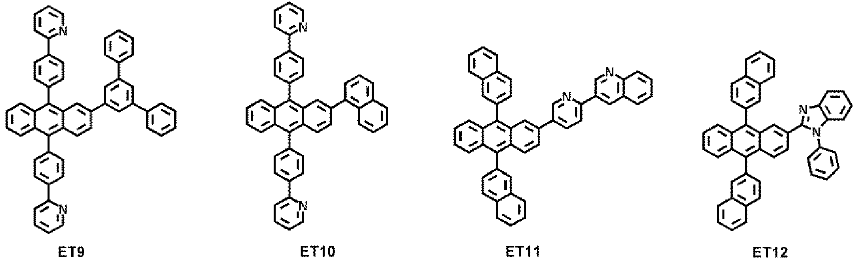

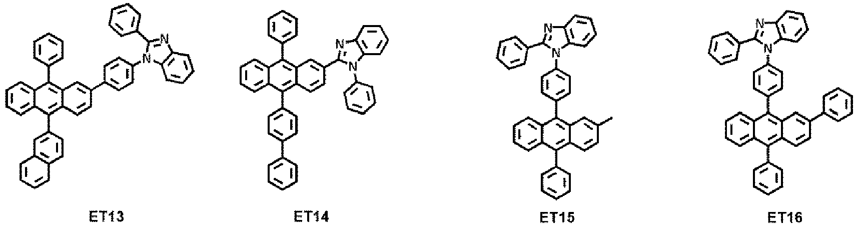

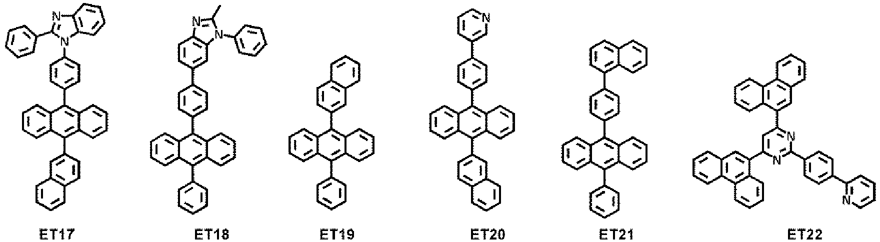

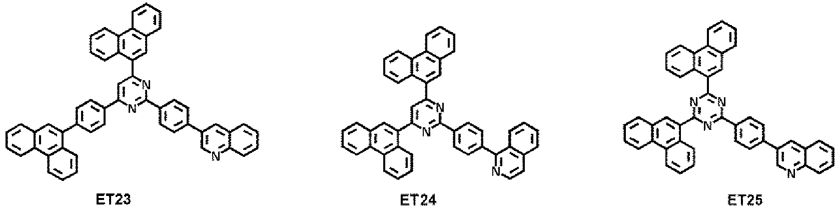

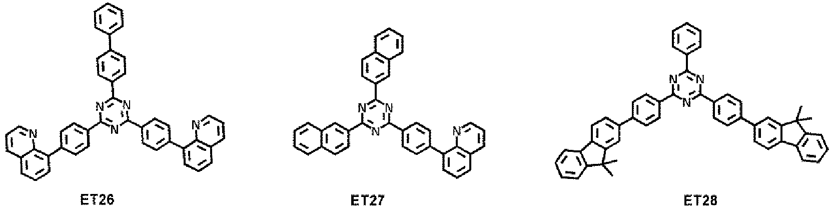

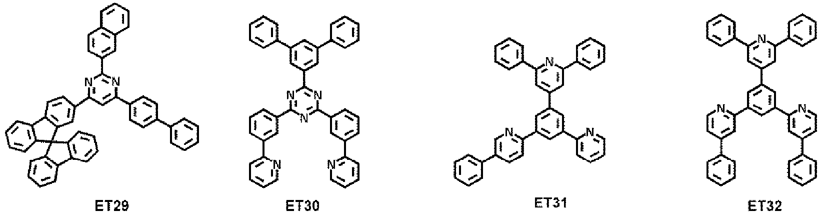

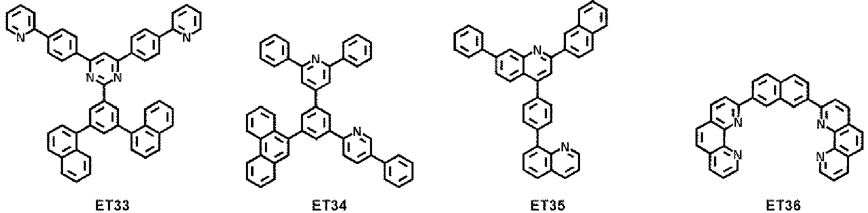

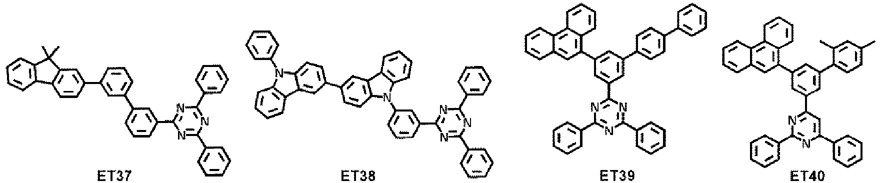

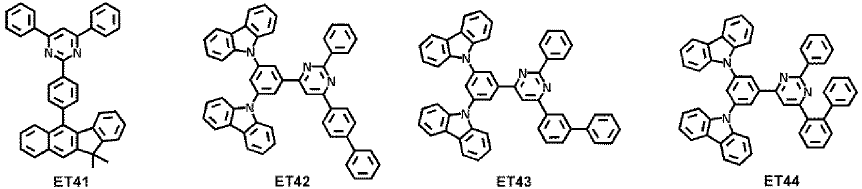

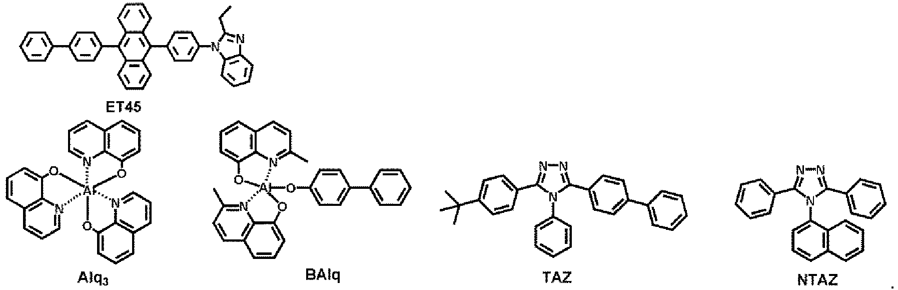

In an embodiment, the hole bloking layer may comprise a compound represented by Formula 602. 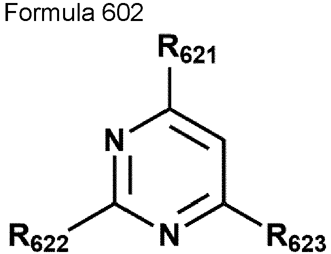 wherein, in formula 602,
R₆₂₁ to R₆₂₃ may each independently be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₂₁)(Q₆₂₂)(Q₆₂₃), -C(=O)(Q₆₂₁), - S(=O)₂(Q₆₂₁), or -P(=O)(Q₆₂₁)(Q₆₂₂),
Q₆₂₁ to Q₆₂₃ may each be the same as described in connection with Q₁.

For example, at least one selected from R₆₂₁ to R₆₂₃ may each independently be a π electron-deficient nitrogen-containing C₁-C₆₀ cyclic group unsubstituted or substituted with at least one R₁₀ₐ.

In an embodiment, the hole bloking layer may comprise a compound represented by Formula 603. 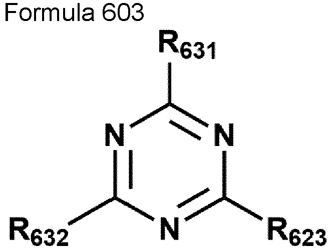 wherein, in formula 603,
R₆₃₁ to R₆₃₃ may each independently be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₃₁)(Q₆₃₂)(Q₆₃₃), -C(=O)(Q₆₃₁), - S(=O)₂(Q₆₃₁), or -P(=O)(Q₆₃₁)(Q₆₃₂),
Q₆₃₁ to Q₆₃₃ may each be the same as described in connection with Q₁.

For example, at least one selected from R₆₃₁ to R₆₃₃ may each independently be a π electron-deficient nitrogen-containing C₁-C₆₀ cyclic group unsubstituted or substituted with at least one R₁₀ₐ.

A thickness of the electron transport region may be in a range of about 100 Å to about 5,000 Å, for example, about 160 Å to about 4,000 Å. When the electron transport region includes a buffer layer, a hole blocking layer, an electron control layer, an electron transport layer, or any combination thereof, a thickness of the buffer layer, the hole blocking layer, or the electron control layer may each independently be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are within the ranges described above, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

For example, the metal-containing material may include a Li complex. The Li complex may include, for example, Compound ET-D1 (LiQ) or ET-D2:

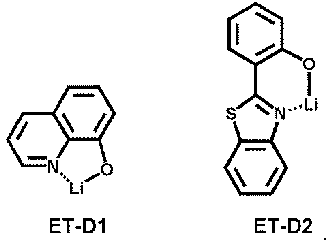

The electron transport region may include an electron injection layer to facilitate the injection of electrons from the second electrode 150. The electron injection layer may be in direct contact (e.g., physical contact) with the second electrode 150.

The electron injection layer may have i) a single-layered structure consisting of a single layer consisting of a single material, ii) a single-layered structure consisting of a single layer consisting of a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, iodides, etc.), and/or tellurides of the alkali metal, the alkaline earth metal, and/or the rare earth metal, or any combination thereof.

The alkali metal-containing compound may include: alkali metal oxide, such as Li₂O, Cs₂O, and/or K₂O; alkali metal halide, such as LiF, NaF, CsF, KF, Lil, Nal, CsI, and/or KI; or any combination thereof. The alkaline earth metal-containing compound may include an alkaline earth metal compound, such as BaO, SrO, CaO, BaₓSr₁₋ₓO (wherein x is a real number satisfying the condition of 0<x<1), and/or BaₓCa₁₋ₓO (wherein x is a real number satisfying the condition of 0<x<1). The rare earth metal-containing compound may include YbF₃, ScF₃, Sc₂O₃, Y₂O₃, Ce₂O₃, GdF₃, TbF₃, Ybl₃, SCl₃, TbI₃, or any combination thereof. In one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one selected from ions of the alkali metal, the alkaline earth metal, and the rare earth metal and ii), as a ligand linked to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, the compound represented by Formula 601).

In an embodiment, the electron injection layer may include (e.g., consist of) i) an alkali metal-containing compound (for example, alkali metal halide), or ii) a) an alkali metal-containing compound (for example, alkali metal halide); and b) an alkali metal, an alkaline earth metal, a rare earth metal, or any combination thereof. For example, the electron injection layer may be a KI:Yb co-deposited layer, a RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 1 Å to about 100 Å, for example, about 3 Å to about 90 Å. When the thickness of the electron injection layer is within the range described above, suitable or satisfactory electron injection characteristics may be obtained without a substantial increase in driving voltage.

### Second electrode 150

The second electrode 150 is on the interlayer 130 as described above. The second electrode 150 may be a cathode, which is an electron injection electrode, and a material for forming the second electrode 150 may include a metal, an alloy, an electrically conductive compound, or any combination thereof, each having a low-work function.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be outside the first electrode 110, and/or a second capping layer may be outside the second electrode 150. In more detail, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110, which is a semi-transmissive electrode or a transmissive electrode, and the first capping layer. Light generated in the emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external luminescence efficiency according to the principle of constructive interference. Accordingly, the light extraction efficiency of the light-emitting device 10 may be increased, so that the luminescence efficiency of the light-emitting device 10 may be improved.

Each of the first capping layer and the second capping layer may include a material having a refractive index of 1.6 or more (at a wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, Cl, Br, I, or any combination thereof. In an embodiment, at least one selected from the first capping layer and the second capping layer may each independently include an amine group-containing compound.

For example, at least one selected from the first capping layer and the second capping layer may each independently include a compound represented by Formula 201, a compound represented by Formula 202, or any combination thereof.

In one or more embodiments, at least one selected from the first capping layer and the second capping layer may each independently include one selected from Compounds HT28 to HT33, one selected from Compounds CP1 to CP6, β-NPB, or any combination thereof:

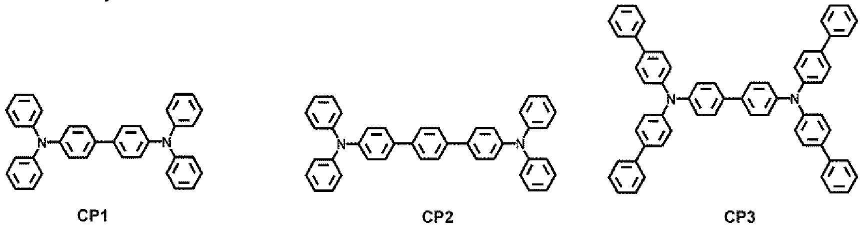

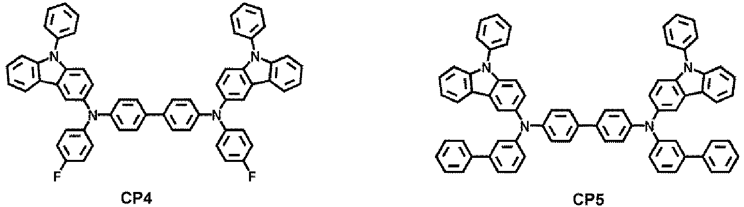

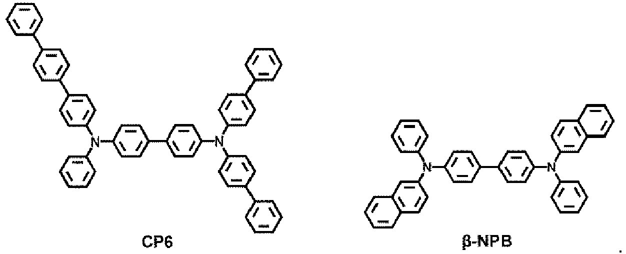

### Film

The first compound, the second compound, the third compound, the first organometallic compound, and the second organometallic compound may be included in various suitable films. Accordingly, another aspect of embodiments of the present disclosure provides a film including the first compound, the second compound, the third compound, the first organometallic compound, the second organometallic compound, or any combination thereof. The film may be, for example, an optical member (or, a light-controlling member) (for example, a color filter, a color-conversion member, a capping layer, a light extraction efficiency improvement layer, a selective light-absorbing layer, a polarizing layer, a quantum dot-containing layer, etc.), a light-blocking member (for example, a light reflection layer, a light-absorbing layer, etc.), and/or a protection member (for example, an insulating layer, a dielectric material layer, etc.).

### Electronic apparatus

The light-emitting device may be included in various suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be in at least one traveling direction of light emitted from the light-emitting device. For example, the light emitted from the light-emitting device may be blue light or white light. Further details for the light-emitting device are the same as described herein. In an embodiment, the color conversion layer may include a quantum dot. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be among the subpixel areas to define each of the subpixel areas.

The color filter may further include a plurality of color filter areas and light-shielding patterns among the color filter areas, and the color conversion layer may include a plurality of color conversion areas and light-shielding patterns among the color conversion areas.

The color filter areas (or the color conversion areas) may include a first area that emits a first color light, a second area that emits a second color light, and/or a third area that emits a third color light, and the first color light, the second color light, and/or the third color light may have different maximum emission wavelengths. For example, the first color light may be red light, the second color light may be green light, and the third color light may be blue light. For example, the color filter areas (or the color conversion areas) may include quantum dots. In more detail, the first area may include red quantum dots, the second area may include green quantum dots, and the third area may not include quantum dots. Further details on the quantum dots may be the same as described herein. The first area, the second area, and/or the third area may each further include a scatterer (e.g., a light scatterer).

For example, the light-emitting device may emit a first light, the first area may absorb the first light to emit a first-first color light, the second area may absorb the first light to emit a second-first color light, and the third area may absorb the first light to emit a third-first color light. In this regard, the first-first color light, the second-first color light, and the third-first color light may have different maximum emission wavelengths. In more detail, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, and one selected from the source electrode and the drain electrode may be electrically connected to one selected from the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be between the color filter and/or the color conversion layer and the light-emitting device. The sealing portion allows light from the light-emitting device to be extracted to the outside, and concurrently (e.g., simultaneously) prevents or reduces penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin-film encapsulating layer, the electronic apparatus may be flexible.

Various suitable functional layers may be additionally on the sealing portion, in addition to the color filter and/or the color conversion layer, according to the use of the electronic apparatus. The functional layers may include a touch screen layer, a polarizing layer, and/or the like. The touch screen layer may be a pressure-sensitive touch screen layer, a capacitive touch screen layer, and/or an infrared touch screen layer.

The authentication apparatus may further include, in addition to the light-emitting device as described above, a biometric information collector. The authentication apparatus may be, for example, a biometric authentication apparatus that authenticates an individual by using biometric information of a living body (for example, fingertips, pupils, etc.).

The electronic apparatus may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various suitable measuring instruments, meters (for example, meters for a vehicle, an aircraft, and/or a vessel), projectors, and/or the like.

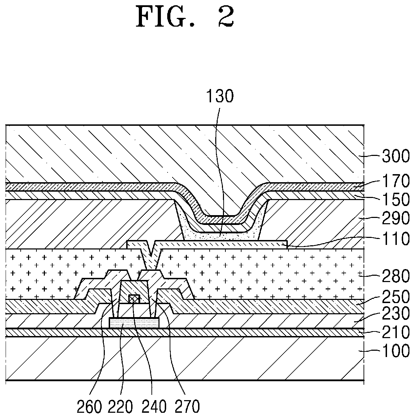

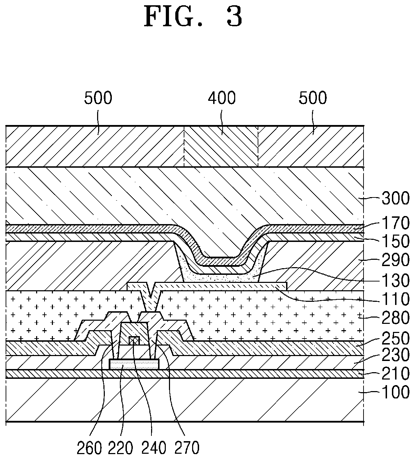

### Description of FIGS. 2 and 3

FIG. 2 is a cross-sectional view of a light-emitting apparatus according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

The TFT may be on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270 to provide insulation therebetween.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact (e.g., physical contact) with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or a combination thereof. A light-emitting device is provided on the passivation layer 280. The light-emitting device includes a first electrode 110, an interlayer 130, and a second electrode 150.

The first electrode 110 may be on the passivation layer 280. The passivation layer 280 may expose a portion of the drain electrode 270 without fully covering the drain electrode 270, and the first electrode 110 may be connected to the exposed portion of the drain electrode 270.

A pixel-defining layer 290 including an insulating material may be on the first electrode 110. The pixel-defining layer 290 may expose a certain region of the first electrode 110, and the interlayer 130 may be formed in the exposed region of the first electrode 110. The pixel-defining layer 290 may be a polyimide and/or polyacrylic organic film. In some embodiments, at least some layers of the interlayer 130 may extend beyond the upper portion of the pixel-defining layer 290 to be in the form of a common layer.

The second electrode 150 may be on the interlayer 130, and a capping layer 170 may be additionally on the second electrode 150. The capping layer 170 may cover the second electrode 150.

The encapsulation portion 300 may be on the capping layer 170. The encapsulation portion 300 may be on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, etc.), an epoxy-based resin (for example, aliphatic glycidyl ether (AGE), etc.), or any combination thereof; or a combination of the inorganic film and the organic film.

FIG. 3 is a cross-sectional view of a light-emitting apparatus according to another embodiment.

The light-emitting apparatus of FIG. 3 is the same as the light-emitting apparatus of FIG. 2, except that a light-shielding pattern 500 and a functional region 400 are additionally on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

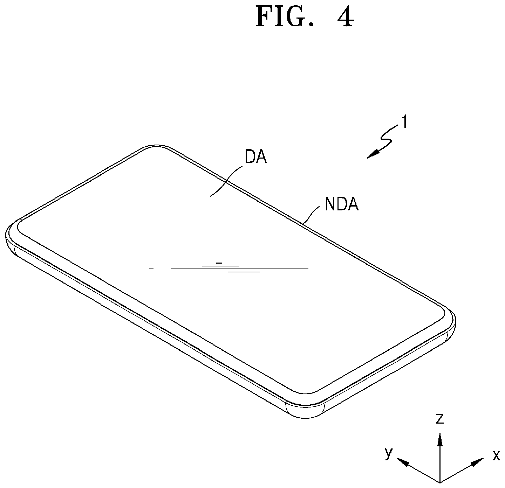

### Description of FIG. 4

FIG. 4 is a schematic perspective view of an electronic apparatus 1 including a light-emitting device, according to an embodiment. The electronic apparatus 1 may be a device for displaying a moving image and/or a still image, and may be any suitable product, for example, a television, a laptop, a monitor, a billboard, and/or an internet of things (IOT) device, as well as a portable electronic device, such as a mobile phone, a smart phone, a tablet personal computer (PC), a mobile communication terminal, an electronic notebook, an electronic book, a portable multimedia player (PMP), a navigation device, and/or an ultra mobile PC (UMPC), and/or a part thereof. In addition, the electronic apparatus 1 may be a wearable device, such as a smart watch, a watch phone, a glasses-type display, and/or a head mounted display (HMD), and/or a part thereof. However, embodiments of the present disclosure are not limited thereto. For example, the electronic apparatus 1 may be an instrument panel of a vehicle, a center information display (CID) on a center fascia and/or a dashboard of a vehicle, a room mirror display that replaces a side mirror of a vehicle, an entertainment display for a rear seat of a vehicle and/or a display on a rear surface of a front seat, a head up display (HUD) installed at a front of a vehicle and/or projected on a front window glass, and/or a computer generated hologram augmented reality head up display (CGH AR HUD). For convenience of explanation, FIG. 4 shows a case where the electronic apparatus 1 is a smart phone.

The electronic apparatus 1 may include a display area DA and a non-display area NDA outside the display area DA. The electronic apparatus 1 may realize an image through an array of a plurality of pixels that are two-dimensionally in the display area DA.

The non-display area NDA may be an area in which an image is not displayed, and may entirely surround the display area DA. A driver for providing electrical signals or power to display devices in the display area DA may be in the non-display area NDA. A pad, which is an area to which an electronic device and/or a printed circuit board may be electrically connected, may be in the non-display area NDA.

The electronic apparatus 1 may have different lengths in the x-axis direction and in the y-axis direction. For example, as shown in FIG. 4, the length in the x-axis direction may be shorter than the length in the y-axis direction. As another example, the length in the x-axis direction may be the same as the length in the y-axis direction. As another example, the length in the x-axis direction may be longer than the length in the y-axis direction.

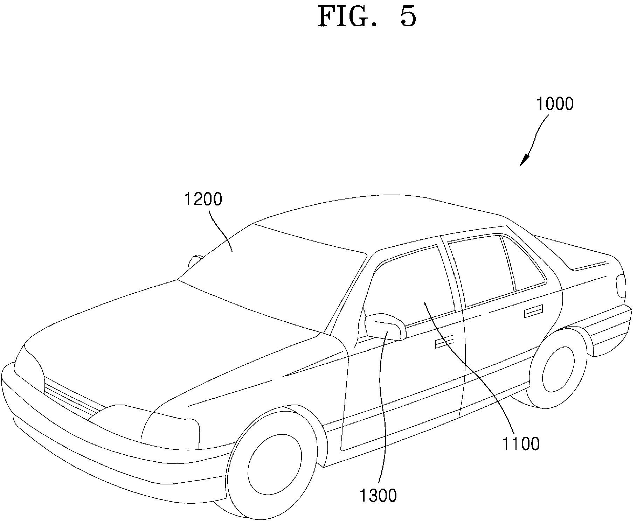

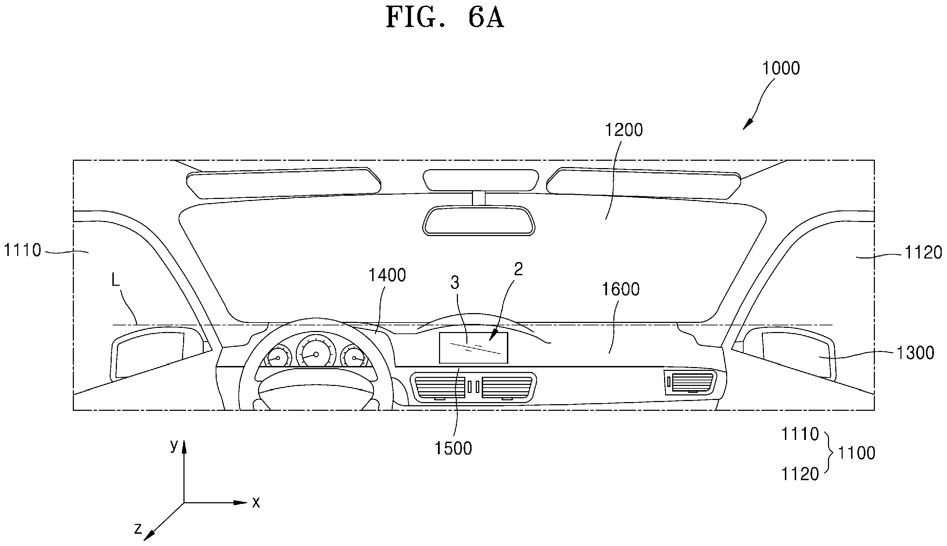

### Description of FIGS. 5 and 6A to 6C

FIG. 5 is a schematic view showing an exterior of a vehicle 1000 as an electronic apparatus including a light-emitting device, according to an embodiment. FIGS. 6A to 6C are each a schematic view showing an interior of the vehicle 1000, according to various embodiments.

Referring to FIGS. 5 and 6A to 6C, the vehicle 1000 may refer to various suitable apparatuses for moving an object to be transported, such as a human, an object, and/or an animal, from a departure point to a destination. The vehicle 1000 may include a vehicle traveling on a road and/or a track, a vessel moving over the sea or river, and an airplane flying in the sky using the action of air.

The vehicle 1000 may travel on a road and/or track. The vehicle 1000 may move in a certain direction according to rotation of at least one wheel. For example, the vehicle 1000 may include a three-wheeled or four-wheeled vehicle, a construction machine, a two-wheeled vehicle, a motorbike, a bicycle, and a train running on a track.

The vehicle 1000 may include a body having an interior and an exterior, and a chassis in which mechanical apparatuses necessary for driving are installed as the remaining parts except for the body. The exterior of the body may include a front panel, a bonnet, a roof panel, a rear panel, a trunk, and a pillar provided at a boundary between doors. The chassis of the vehicle 1000 may include a power generating apparatus, a power transmitting apparatus, a driving apparatus, a steering apparatus, a braking apparatus, a suspension apparatus, a transmission apparatus, a fuel apparatus, front and rear left and right wheels, and the like.

The vehicle 1000 may include a side window glass 1100, a front window glass 1200, a side mirror 1300, a cluster 1400, a center fascia 1500, a passenger seat dashboard 1600, and a display apparatus 2.

The side window glass 1100 and the front window glass 1200 may be partitioned by a pillar between the side window glass 1100 and the front window glass 1200.

The side window glass 1100 may be installed on a side surface of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be adjacent to the cluster 1400. In an embodiment, the second side window glass 1120 may be adjacent to the passenger seat dashboard 1600.

In an embodiment, the side window glasses 1100 may be apart from each other in the x direction or the -x direction. For example, the first side window glass 1110 and the second side window glass 1120 may be spaced apart from each other in the x direction or the -x direction. In other words, an imaginary straight line L connecting the side window glasses 1100 to each other may extend in the x direction or the -x direction. For example, the imaginary straight line L connecting the first side window glass 1110 to the second side window glass 1120 may extend in the x direction or the -x direction.

The front window glass 1200 may be installed at a front of the vehicle 1000. The front window glass 1200 may be between the side window glasses 1100 facing each other.

The side mirror 1300 may provide a rear view of the vehicle 1000. The side mirror 1300 may be installed on the exterior of the body. In an embodiment, a plurality of side mirrors 1300 may be provided. One of the plurality of side mirrors 1300 may be outside the first side window glass 1110. Another one of the plurality of side mirrors 1300 may be outside the second side window glass 1120.

The cluster 1400 may be at a front of a steering wheel. The cluster 1400 may include a tachometer, a speedometer, a coolant thermometer, a fuel gauge, a direction change indicator light, a high beam indicator light, a warning light, a seat belt warning light, a trip meter, an odometer, a hodometer, an automatic transmission selection lever indicator light, a door open warning light, an engine oil warning light, and/or a low fuel warning light thereon.

The center fascia 1500 may include a control panel on which a plurality of buttons for adjusting an audio apparatus, an air conditioning apparatus, and/or a heater of a seat are located. The center fascia 1500 may be on one side of the cluster 1400.

The passenger seat dashboard 1600 may be spaced apart from the cluster 1400 with the center fascia 1500 therebetween. In an embodiment, the cluster 1400 may be correspond to a driver seat, and the passenger seat dashboard 1600 may be correspond to a passenger seat. In an embodiment, the cluster 1400 may be adjacent to the first side window glass 1110, and the passenger seat dashboard 1600 may be adjacent to the second side window glass 1120.

In an embodiment, the display apparatus 2 may include a display panel 3, and the display panel 3 may display an image. The display apparatus 2 may be inside the vehicle 1000. In an embodiment, the display apparatus 2 may be between the side window glasses 1100 facing each other. The display apparatus 2 may be on at least one of the cluster 1400, the center fascia 1500, and the passenger seat dashboard 1600.

The display apparatus 2 may include an organic light-emitting display apparatus, an inorganic electroluminescent (EL) display apparatus (and/or an inorganic light-emitting display apparatus), a quantum dot display apparatus, and/or the like. Hereinafter, an organic light-emitting display apparatus including the light-emitting device according to an embodiment will be described as an example of the display apparatus 2 according to an embodiment. However, various suitable types (or kind) of display apparatuses as described above may be used in embodiments of the present disclosure.

Referring to FIG. 6A, the display apparatus 2 may be on the center fascia 1500. In an embodiment, the display apparatus 2 may display navigation information. In an embodiment, the display apparatus 2 may display information on audio, video, and/or vehicle settings.

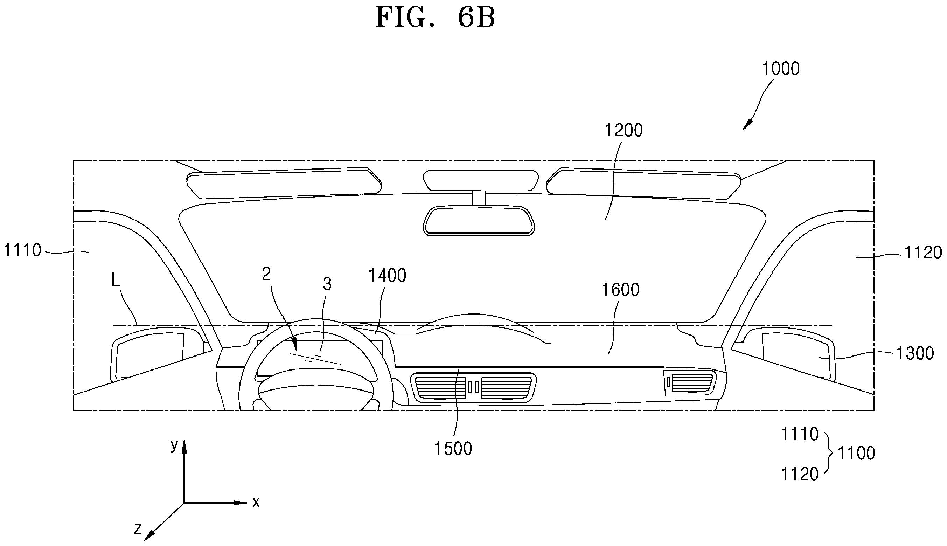

Referring to FIG. 6B, the display apparatus 2 may be on the cluster 1400. In this case, the cluster 1400 may show driving information and/or the like by the display apparatus 2. For example, the cluster 1400 may be digitally implemented. The digital cluster 1400 may display vehicle information and driving information as images. For example, a needle and a gauge of a tachometer and various suitable warning light icons may be displayed by digital signals.

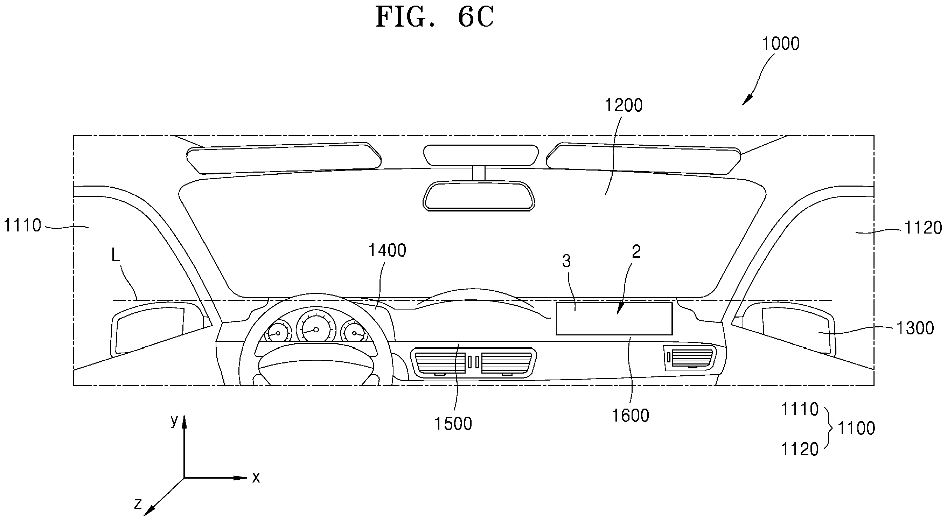

Referring to FIG. 6C, the display apparatus 2 may be on the passenger seat dashboard 1600. The display apparatus 2 may be embedded in the passenger seat dashboard 1600 or on the passenger seat dashboard 1600. In an embodiment, the display apparatus 2 on the passenger seat dashboard 1600 may display an image related to information displayed on the cluster 1400 and/or information displayed on the center fascia 1500. In one or more embodiments, the display apparatus 2 on the passenger seat dashboard 1600 may display information different from information displayed on the cluster 1400 and/or information displayed on the center fascia 1500.

### Manufacturing method

Respective layers included in the hole transport region, the emission layer, and respective layers included in the electron transport region may be formed in a certain region by using various suitable methods such as vacuum deposition, spin coating, casting, Langmuir-Blodgett (LB) deposition, ink-jet printing, laser-printing, laser-induced thermal imaging, and/or the like.

When respective layers included in the hole transport region, the emission layer, and respective layers included in the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group," as used herein, refers to a cyclic group consisting of carbon only as a ring-forming atom and having 3 to 60 carbon atoms, and the term "C₁-C₆₀ heterocyclic group," as used herein, refers to a cyclic group that has 1 to 60 carbon atoms and further has, in addition to carbon, a heteroatom as a ring-forming atom. Each of the C₃-C₆₀ carbocyclic group and the C₁-C₆₀ heterocyclic group may be a monocyclic group consisting of one ring or a polycyclic group consisting of two or more rings that are condensed together. For example, the C₁-C₆₀ heterocyclic group may have 3 to 61 ring-forming atoms.

The term "cyclic group," as used herein, may include both the C₃-C₆₀ carbocyclic group and the C₁-C₆₀ heterocyclic group.

The term "π electron-rich C₃-C₆₀ cyclic group," as used herein, refers to a cyclic group that has 3 to 60 carbon atoms and does not include *-N=*' as a ring-forming moiety. The term "π electron-deficient nitrogen-containing C₁-C₆₀ cyclic group," as used herein, refers to a heterocyclic group that has 1 to 60 carbon atoms and includes *-N=*' as a ring-forming moiety.

For example,
the C₃-C₆₀ carbocyclic group may be i) a T1 group or ii) a condensed cyclic group in which at least two T1 groups are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a condensed cyclic group in which at least two T2 groups are condensed together with each other, or iii) a condensed cyclic group in which at least one T2 group and at least one T1 group are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) a T1 group, ii) a condensed cyclic group in which at least two T1 groups are condensed together with each other, iii) a T3 group, iv) a condensed cyclic group in which at least two T3 groups are condensed together with each other, or v) a condensed cyclic group in which at least one T3 group and at least one T1 group are condensed together with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) a T4 group, ii) a condensed cyclic group in which at least two T4 groups are condensed together with each other, iii) a condensed cyclic group in which at least one T4 group and at least one T1 group are condensed together with each other, iv) a condensed cyclic group in which at least one T4 group and at least one T3 group are condensed together with each other, or v) a condensed cyclic group in which at least one T4 group, at least one T1 group, and at least one T3 group are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the C₃-C₆₀ carbocyclic group, "the C₁-C₆₀ heterocyclic group," "the π electron-rich C₃-C₆₀ cyclic group," or "the π electron-deficient nitrogen-containing C₁-C₆₀ cyclic group," as used herein, refer to a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, or the like, which may be easily understood by one of ordinary skill in the art according to the structure of a formula including the "benzene group."

Examples of the monovalent C₃-C₆₀ carbocyclic group and monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of the divalent C₃-C₆₀ carbocyclic group and the monovalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group," as used herein, refers to a linear or branched aliphatic hydrocarbon monovalent group that has 1 to 60 carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group," as used herein, refers to a divalent group having substantially the same structure as the C₁-C₆₀ alkyl group.

The term "C₂-C₆₀ alkenyl group," as used herein, refers to a monovalent hydrocarbon group having at least one carbon-carbon double bond at a main chain (e.g., in the middle) or at a terminal end (e.g., the terminus) of the C₂-C₆₀ alkyl group, and examples thereof include an ethenyl group, a propenyl group, and a butenyl group. The term "C₂-C₆₀ alkenylene group," as used herein, refers to a divalent group having substantially the same structure as the C₂-C₆₀ alkenyl group.

The term "C₂-C₆₀ alkynyl group," as used herein, refers to a monovalent hydrocarbon group having at least one carbon-carbon triple bond at a main chain (e.g., in the middle) or at a terminal end (e.g., the terminus) of the C₂-C₆₀ alkyl group, and examples thereof include an ethynyl group, and a propynyl group. The term "C₂-C₆₀ alkynylene group," as used herein, refers to a divalent group having substantially the same structure as the C₂-C₆₀ alkynyl group.

The term "C₁-C₆₀ alkoxy group," as used herein, refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group," as used herein, refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent cyclic group of 1 to 10 carbon atoms, further including, in addition to carbon atoms, at least one heteroatom, as ring-forming atoms, and examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group.

The term "C₃-C₁₀ cycloalkenyl group," as used herein refers to a monovalent cyclic group that has 3 to 10 carbon atoms and at least one carbon-carbon double bond in the ring thereof and no aromaticity (e.g., is not aromatic), and examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group," as used herein, refers to a divalent group having substantially the same structure as the C₁-C₁₀ heterocycloalkenyl group.

The term "C₆-C₆₀ aryl group," as used herein, refers to a monovalent group having a carbocyclic aromatic system of 6 to 60 carbon atoms, and the term "C₆-C₆₀ arylene group," as used herein, refers to a divalent group having a carbocyclic aromatic system of 6 to 60 carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed together with each other.

The term "C₁-C₆₀ heteroaryl group," as used herein, refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group," as used herein, refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed together with each other.

The term "monovalent non-aromatic condensed polycyclic group," as used herein, refers to a monovalent group (for example, having 8 to 60 carbon atoms) having two or more rings condensed to each other, only carbon atoms as ring-forming atoms, and no aromaticity in its entire molecular structure (e.g., is not aromatic when considered as a whole). Examples of the monovalent non-aromatic condensed polycyclic group include an indenyl group, a fluorenyl group, a spiro-bifluorenyl group, a benzofluorenyl group, an indenophenanthrenyl group, and an indenoanthracenyl group. The term "divalent non-aromatic condensed polycyclic group," as used herein, refers to a divalent group having substantially the same structure as the monovalent non-aromatic condensed polycyclic group.

The term "monovalent non-aromatic condensed heteropolycyclic group," as used herein, refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure (e.g., is not aromatic when considered as a whole). Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphtho silolyl group, a benzofurodibenzofuranyl group, a benzofurodibenzothiophenyl group, and a benzothienodibenzothiophenyl group. The term "divalent non-aromatic condensed heteropolycyclic group," as used herein, refers to a divalent group having substantially the same structure as the monovalent non-aromatic condensed heteropolycyclic group.

The term "C₆-C₆₀ aryloxy group," as used herein, refers to -OA₁₀₂ (wherein A₁₀₂ is the C₆-C₆₀ aryl group), and the term "C₆-C₆₀ arylthio group," as used herein, refers to -SA₁₀₃ (wherein A₁₀₃ is the C₆-C₆₀ aryl group).

The term "C₇-C₆₀ arylalkyl group," as used herein, refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group," as used herein, refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ," as used herein, refers to:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; hydroxyl group; a cyano group; a nitro group; a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, a cyano group, or any combination thereof; or a C₃-C₆₀ carbocyclic group, a C₁-C₆₀ heterocyclic group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "heteroatom," as used herein, refers to any atom other than a carbon atom. Examples of the heteroatom include O, S, N, P, Si, B, Ge, Se, or any combination thereof.

The term "Ph," as used herein, refers to a phenyl group, the term "Me," as used herein, refers to a methyl group, the term "Et," as used herein, refers to an ethyl group, the term "tert-Bu" or "Bu^{t}," as used herein, refers to a tert-butyl group, and the term "OMe," as used herein, refers to a methoxy group.

The term "biphenyl group," as used herein, refers to "a phenyl group substituted with a phenyl group." In other words, the "biphenyl group" is a substituted phenyl group having a C₆-C₆₀ aryl group as a substituent.

The term "terphenyl group," as used herein, refers to "a phenyl group substituted with a biphenyl group." In other words, the "terphenyl group" is a substituted phenyl group having, as a substituent, a C₆-C₆₀ aryl group substituted with a C₆-C₆₀ aryl group.
* and *', as used herein, unless defined otherwise, each refer to a binding site to a neighboring atom in a corresponding formula or moiety.

Hereinafter, a compound according to embodiments and a light-emitting device according to embodiments will be described in more detail with reference to Synthesis Examples and Examples. The wording "B was used instead of A" used in describing Synthesis Examples means that an identical molar equivalent of B was used in place of A.

### Examples

### Evaluation Example 1

The HOMO and T1 energy levels of each of the host compounds, and the maximum emission wavelength (λmax) and HOMO and T1 energy levels of each of the dopant compounds were evaluated, and the results thereof are shown in Table 1 and Table 2, respectively. The HOMO and T1 energy levels and maximum emission wavelength were evaluated by a DFT method of Gaussian program that is structurally optimized at a level of B3LYP, 6-31G(d,p).

**Table 1**

| | HOMO (eV) | T₁ (eV) |
|---|---|---|
| HTH53 | -4.96 | 3.01 |
| ETH85 | -5.24 | 2.70 |
| WBG1 | -5.65 | 2.76 |

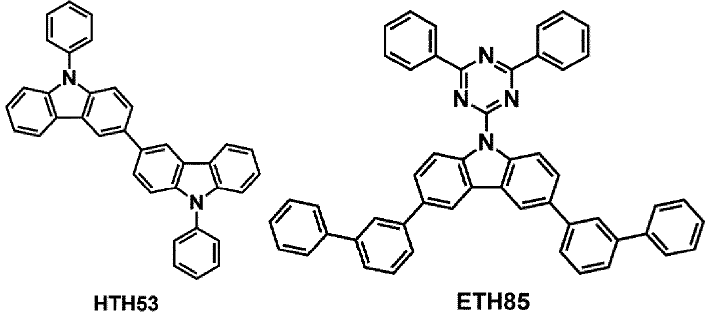

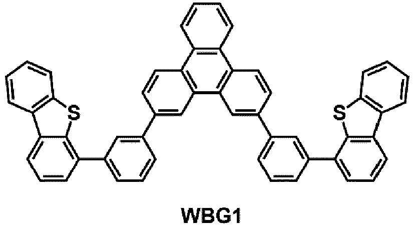

**Table 2**

| | λmax (nm) | HOMO (eV) | T1 (eV) |
|---|---|---|---|
| PD40 | 531 | -4.46 | 2.20 |
| PD41 | 526 | -4.40 | 2.22 |
| PD42 | 521 | -4.60 | 2.31 |

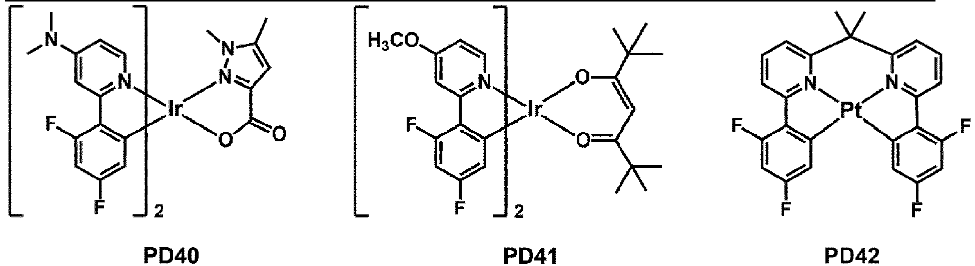

### Example 1

As an anode, a glass substrate (product of Corning Inc.) with a 15 Ω/cm² (1,200 Å) ITO electrode formed thereon was cut to a size of 50 mm x 50 mm x 0.7 mm, sonicated using isopropyl alcohol and pure water each for 5 minutes, and then cleaned by irradiation of ultraviolet rays and exposure of ozone thereto for 30 minutes. Then, the resultant glass substrate was mounted on a vacuum deposition apparatus.

α-NPD was deposited on the anode to form a hole injection layer (HIL) having a thickness of 50 Å, ... was deposited on the hole injection layer to form a hole transport layer (HTL) having a thickness of 1,300 Å, ... was deposited on the hole transport layer to form an electron blocking layer (EBL) having a thickness of 350 Å, and then, Host A and Dopant A were co-deposited thereon to form an emission layer having a thickness of 380 Å. In this regard, Host A and Dopant A are as described in Table 3.

Subsequently, ... was deposited on the emission layer to form a hole blocking layer (HBL) having a thickness of 50 Å, ... was deposited on the hole blocking layer to form an electron transport layer (ETL) having a thickness of 300 Å, Yb was deposited on the electron transport layer to form an electron injection layer having a thickness of 10 Å, and Ag:Mg (9:1) was deposited on the electron injection layer to form a cathode having a thickness of 120 Å, thereby completing the manufacture of an organic light-emitting device having a structure of ITO (1,200 Å) / HIL (50 Å) / HTL (1,300 Å) / EBL(350 Å)/ Host A + Dopant A (380 Å) / HBL (50 Å) / ETL (300 Å) / Yb (10 Å) / Ag:Mg (120 Å).

Each of HTL and EBL is a compound represented by Chemical Formula 203, HBL is a compound represented by Chemical Formula 602, and ETL is a compound represented by Chemical Formula 603. Descriptions of Formulae 203, 602, and 603 are the same as those described herein.

### Examples 2 and 3 and Comparative Examples 1 to 8

Organic light-emitting devices were manufactured in substantially the same manner as in Example 1, except that combinations of compounds as described in Table 4 were each used to form an emission layer.

### Evaluation Example 2

The driving voltage at the current density of 10 mA/cm², efficiency, and lifespan of each of the organic light-emitting devices according to Examples 1 to 3 and Comparative Examples 1 to 8 were measured using Keithley MU 236 and luminance meter PR650, and the results thereof are shown in Table 4. The efficiency and lifespan are expressed as relative values (%) based on Comparative Example 3, the lifespan is a measure of the time taken when the luminance reaches 97% of the initial luminance.

**Table 3**

| | Configuration |
|---|---|
| Host 1 | HTH53 + ETH85 |
| Host A | HTH53 + ETH85 + WBG1 |
| Dopant A | PD40 + PD41 |
| Dopant B | PD40 + PD42 |
| Dopant C | PD41 + PD42 |
| CE1 | CH1 + CH2 + CH3 + CPD1 |

(In Table 3, the content ratio of each compound in Host A is HTH 53: ETH85: WBG1 = 55: 35: 10 based on weight.)

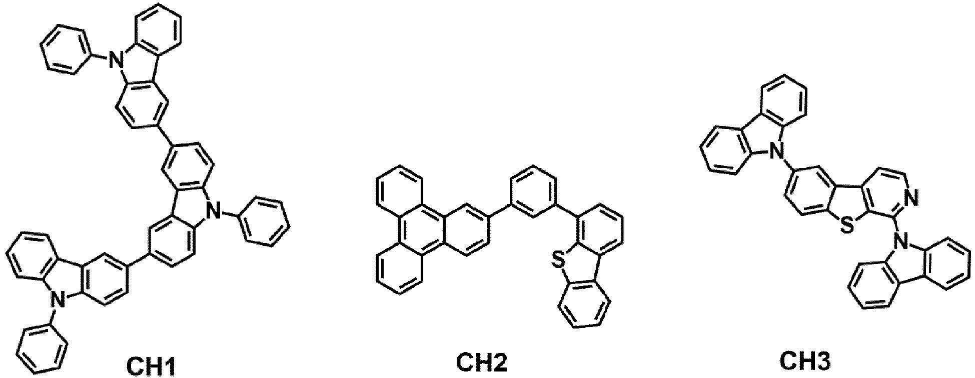

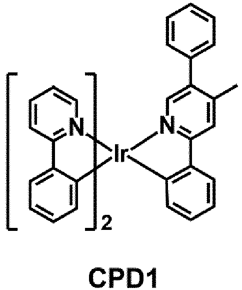

**Table 4**

| | Emission layer compound | Driving voltage (V) | Efficiency (%) | Lifespan (T97, %) |
|---|---|---|---|---|
| Example 1 | Host A + Dopant A | 3.70 | 106 | 100 |
| Example 2 | Host A + Dopant B | 3.30 | 115 | 160 |
| Example 3 | Host A + Dopant C | 3.55 | 109 | 130 |
| Comparative Example 1 | Host 1 + PD40 | 3.40 | 118 | 80 |
| Comparative Example 2 | Host 1 + PD41 | 3.70 | 103 | 85 |
| Comparative Example 3 | Host 1 + PD42 | 3.30 | 100 | 100 |
| Comparative Example 4 | Host A + PD40 | 3.40 | 118 | 90 |
| Comparative Example 5 | Host A + PD41 | 3.80 | 103 | 95 |
| Comparative Example 6 | Host 1 + Dopant A | 3.60 | 104 | 85 |
| Comparative Example 7 | Host 1 + Dopant C | 3.50 | 106 | 100 |
| Comparative Example 8 | CE1 | 6.00 | 70 | 70 |

(In Example 1, the content ratio of the light-emitting layer compound is Host A: PD40:PD41 = 90:5:5, based on weight. In Example 2, the content ratio of the light-emitting layer compound is based on weight, Host A: PD40: PD42 = 85:5:10. In Example 3, the content ratio of the light emitting layer compound is Host A: PD41: PD42 = 85:5:10, based on weight.)

From Table 4, it can be seen that the organic light-emitting devices according to Examples 1 to 3 had excellent efficiency and lifespan characteristics, as compared with the organic light-emitting device according to Comparative Examples 1 to 8.

The light-emitting device according to an embodiment may have excellent efficiency and lifespan characteristics, and a high-quality electronic apparatus may be manufactured by using the light-emitting device.

## Claims

1. A light-emitting device (10) comprising:
a first electrode (110);
a second electrode (150) facing the first electrode (110); and
an interlayer (130) between the first electrode (110) and the second electrode (150) and comprising an emission layer,
wherein the emission layer comprises i) a first compound, a second compound, and a third compound, and
ii) a first organometallic compound and a second organometallic compound,
the first compound to the third compound are different from each other,
the first organometallic compound and the second organometallic compound each independently comprise at least one transition metal,
the first organometallic compound and the second organometallic compound are different from each other, and
a difference between an absolute value of a highest occupied molecular orbital (HOMO) energy level (eV) of the second compound and an absolute value of a HOMO energy level (eV) of the third compound is 0.1 eV or more,
wherein the HOMO energy level is evaluated by a density functional theory (DFT) method using a B3LYP approach with a 6-31G* basis set, and **characterized in that**,
the first compound, the second compound, the third compound, the first organometallic compound and the second organometallic compound are co-deposited.

2. The light-emitting device of claim 1, wherein a band gap energy of the third compound is 4.3 eV or more.

3. The light-emitting device of claim 1 or 2, wherein an absolute value of a HOMO energy level (eV) of the first compound is smaller than the absolute value of the HOMO energy level (eV) of the third compound

4. The light-emitting device of any one of the preceding claims, wherein, based on weight, an amount of the first compound is greater than an amount of the second compound, and
the amount of the second compound is greater than an amount of the third compound.

5. The light-emitting device of any one of the preceding claims, wherein the at least one transition metal is iridium (Ir), platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

6. The light-emitting device of any one of the preceding claims, wherein a maximum emission wavelength of the first organometallic compound is greater than a maximum emission wavelength of the second organometallic compound.

7. The light-emitting device of any one of the preceding claims, wherein an absolute value of a HOMO energy level (eV) of the first organometallic compound is smaller than the absolute value of a HOMO energy level (eV) of the second organometallic compound

8. The light-emitting device of any one of the preceding claims, wherein a T1 energy level (eV) of the first organometallic compound is smaller than a T1 energy level (eV) of the second organometallic compound.

9. The light-emitting device of any one of the preceding claims, wherein a difference between an absolute value of a HOMO energy level (eV) of the first organometallic compound and an absolute value of a HOMO energy level (eV) of the second organometallic compound is 0.05 eV or more.

10. The light-emitting device of any one of the preceding claims, wherein an amount of the first organometallic compound is greater than an amount of the second organometallic compound, based on weight.

11. The light-emitting device of any one of the preceding claims, wherein the first compound comprises a group represented by Formula 3: 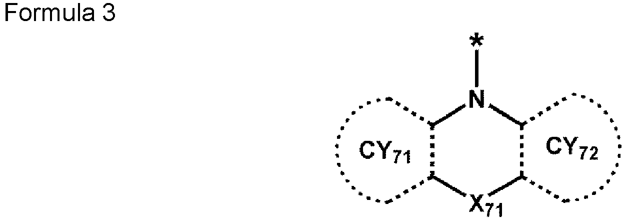
wherein, in Formula 3, ring CY₇₁ and ring CY₇₂ are each independently a π electron-rich C₃-C₆₀ cyclic group or a pyridine group,
X₇₁ in Formula 3 is a single bond or a linking group including O, S, N, B, C, Si, or any combination thereof, and
* in Formula 3 indicates a binding site to a neighboring atom in the first compound.

12. The light-emitting device of any one of the preceding claims, wherein the second compound comprises a π electron-deficient nitrogen-containing C₁-C₆₀ cyclic group, in particular a pyridine group, a pyrimidine group, a pyrazine group, a pyridazine group, a triazine group, or any combination thereof.

13. The light-emitting device of any one of the preceding claims, wherein the third compound comprises a triphenylene group.

14. The light-emitting device of any one of the preceding claims, wherein the first organometallic compound and the second organometallic compound each independently comprise a compound represented by Formula 401:
Formula 401 M(L₄₀₁)_{xc1}(L₄₀₂)_{xc2} 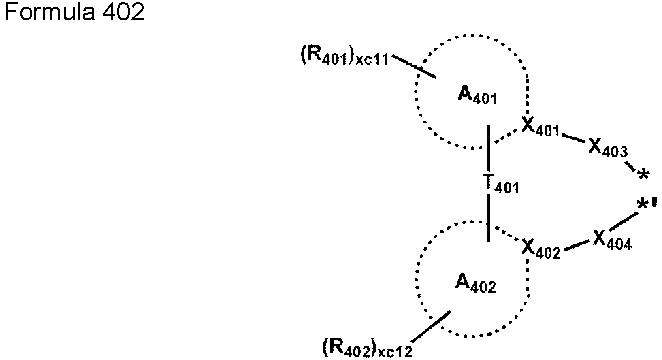
wherein, in Formulae 401 and 402,
M is a transition metal,
L₄₀₁ is a ligand represented by Formula 402, and xc1 is 1, 2, or 3, wherein, when xc1 is 2 or more, two or more of L₄₀₁ are identical to or different from each other,
L₄₀₂ is an organic ligand, and xc2 is 0, 1, 2, 3, or 4, wherein, when xc2 is 2 or more, two or more of L₄₀₂ are identical to or different from each other,
X₄₀₁ and X₄₀₂ are each independently nitrogen or carbon,
ring A₄₀₁ and ring A₄₀₂ are each independently a C₃-C₆₀ carbocyclic group or a C₁-C₆₀ heterocyclic group,
T₄₀₁ is a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*', wherein * and *' in T₄₀₁ each refer to a binding site to a neighboring atom,
X₄₀₃ and X₄₀₄ are each independently a chemical bond, O, S, N(Q₄₁₃), B(Q₄₁₃), P(Q₄₁₃), C(Q₄₁₃)(Q₄₁₄), or Si(Q₄₁₃)(Q₄₁₄),
R₄₀₁ and R₄₀₂ are each independently hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁),-S(=O)₂(Q₄₀₁), or -P(=O)(Q₄₀₁)(Q₄₀₂),
Q₄₁₁ to Q₄₁₄ and Q₄₀₁ to Q₄₀₃ are each independently: hydrogen; deuterium; -F; -Cl; -Br; -I; a hydroxyl group; a cyano group; a nitro group; a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, a cyano group, or any combination thereof; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof,
xc11 and xc12 are each independently an integer from 0 to 10,
* and *' in Formula 402 each indicate a binding site to M in Formula 401, and R₁₀ₐ is deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂),-C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂),-C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂), and
Q₁₁ to Q₁₃, Q₂₁ to Q₂₃, and Q₃₁ to Q₃₃ may each independently be: hydrogen; deuterium; -F; -Cl; -Br; -I; hydroxyl group; a cyano group; a nitro group; a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, a cyano group, or any combination thereof; or a C₃-C₆₀ carbocyclic group, a C₁-C₆₀ heterocyclic group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

15. An electronic apparatus (1) comprising the light-emitting device of any one of the preceding claims.

## Patentansprüche

1. Lichtemittierende Vorrichtung (10), umfassend:
eine erste Elektrode (110);
eine zweite Elektrode (150), die der ersten Elektrode (110) zugewandt ist; und
eine Zwischenschicht (130) zwischen der ersten Elektrode (110) und der zweiten Elektrode (150) und eine Emissionsschicht umfassend,
wobei die Emissionsschicht Folgendes umfasst: i) eine erste Verbindung, eine zweite Verbindung und eine dritte Verbindung, und
ii) eine erste organometallische Verbindung und eine zweite organometallische Verbindung,
sich die erste Verbindung bis dritte Verbindung voneinander unterscheiden,
die erste organometallische Verbindung und die zweite organometallische Verbindung jeweils unabhängig mindestens ein Übergangsmetall umfassen,
sich die erste organometallische Verbindung und die zweite organometallische Verbindung voneinander unterscheiden, und
eine Differenz zwischen einem Absolutwert eines Energieniveaus (eV) eines höchsten besetzten Molekülorbitals (HOMO) der zweiten Verbindung und einem Absolutwert eines HOMO-Energieniveaus (eV) der dritten Verbindung 0,1 eV oder mehr beträgt,
wobei das HOMO-Energieniveau durch ein Dichtefunktionaltheorie(DFT)-Verfahren unter Verwendung eines B3LYP-Ansatzes mit einem 6-31G*-Basissatz beurteilt wird, und **dadurch gekennzeichnet, dass**
die erste Verbindung, die zweite Verbindung, die dritte Verbindung, die erste organometallische Verbindung und die zweite organometallische Verbindung gemeinsam abgeschieden werden.

2. Lichtemittierende Vorrichtung nach Anspruch 1, wobei eine Bandlückenenergie der dritten Verbindung 4,3 eV oder mehr beträgt.

3. Lichtemittierende Vorrichtung nach Anspruch 1 oder 2, wobei ein Absolutwert eines HOMO-Energieniveaus (eV) der ersten Verbindung kleiner ist als der Absolutwert des HOMO-Energieniveaus (eV) der dritten Verbindung.

4. Lichtemittierende Vorrichtung nach einem der vorhergehenden Ansprüche, wobei basierend auf dem Gewicht eine Menge der ersten Verbindung größer ist als eine Menge der zweiten Verbindung, und
die Menge der zweiten Verbindung größer ist als eine Menge der dritten Verbindung.

5. Lichtemittierende Vorrichtung nach einem der vorhergehenden Ansprüche, wobei das mindestens eine Übergangsmetall Iridium (Ir), Platin (Pt), Palladium (Pd), Kupfer (Cu), Silber (Ag), Gold (Au), Rhodium (Rh), Ruthenium (Ru), Osmium (Os), Titan (Ti), Zirconium (Zr), Hafnium (Hf), Europium (Eu), Terbium (Tb) oder Thulium (Tm) ist.

6. Lichtemittierende Vorrichtung nach einem der vorhergehenden Ansprüche, wobei eine maximale Emissionswellenlänge der ersten organometallischen Verbindung größer ist als eine maximale Emissionswellenlänge der zweiten organometallischen Verbindung.

7. Lichtemittierende Vorrichtung nach einem der vorhergehenden Ansprüche, wobei ein Absolutwert eines HOMO-Energieniveaus (eV) der ersten organometallischen Verbindung kleiner ist als der Absolutwert eines HOMO-Energieniveaus (eV) der zweiten organometallischen Verbindung.

8. Lichtemittierende Vorrichtung nach einem der vorhergehenden Ansprüche, wobei ein T1-Energieniveau (eV) der ersten organometallischen Verbindung kleiner ist als ein T1-Energieniveau (eV) der zweiten organometallischen Verbindung.

9. Lichtemittierende Vorrichtung nach einem der vorhergehenden Ansprüche, wobei eine Differenz zwischen einem Absolutwert eines HOMO-Energieniveaus (eV) der ersten organometallischen Verbindung und einem Absolutwert eines HOMO-Energieniveaus (eV) der zweiten organometallischen Verbindung 0,05 eV oder mehr beträgt.

10. Lichtemittierende Vorrichtung nach einem der vorhergehenden Ansprüche, wobei basierend auf dem Gewicht eine Menge der ersten organometallischen Verbindung größer ist als eine Menge der zweiten organometallischen Verbindung.

11. Lichtemittierende Vorrichtung nach einem der vorhergehenden Ansprüche, wobei die erste Verbindung eine durch die Formel 3 dargestellte Gruppe umfasst: 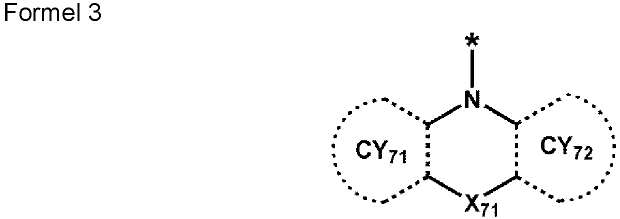
wobei in Formel 3 der Ring CY₇₁ und der Ring CY₇₂ jeweils unabhängig eine π-Elektronen-reiche cyclische C₃-C₆₀-Gruppe oder eine Pyridingruppe sind,
X₇₁ in Formel 3 eine Einfachbindung oder eine Verbindungsgruppe ist, die O, S, N, B, C, Si oder eine beliebige Kombination davon beinhaltet, und
* in Formel 3 eine Bindungsstelle zu einem benachbarten Atom in der ersten Verbindung angibt.

12. Lichtemittierende Vorrichtung nach einem der vorhergehenden Ansprüche, wobei die zweite Verbindung eine π-Elektronen-arme stickstoffhaltige cyclische C₁-C₆₀-Gruppe, insbesondere eine Pyridingruppe, eine Pyrimidingruppe, eine Pyrazingruppe, eine Pyridazingruppe, eine Triazingruppe oder eine beliebige Kombination davon, umfasst.

13. Lichtemittierende Vorrichtung nach einem der vorhergehenden Ansprüche, wobei die dritte Verbindung eine Triphenylengruppe umfasst.

14. Lichtemittierende Vorrichtung nach einem der vorhergehenden Ansprüche, wobei die erste organometallische Verbindung und die zweite organometallische Verbindung jeweils unabhängig eine durch die Formel 401 dargestellte Verbindung umfassen:
Formel 401 M(L₄₀₁)_{xc1}(L₄₀₂)_{xc2} 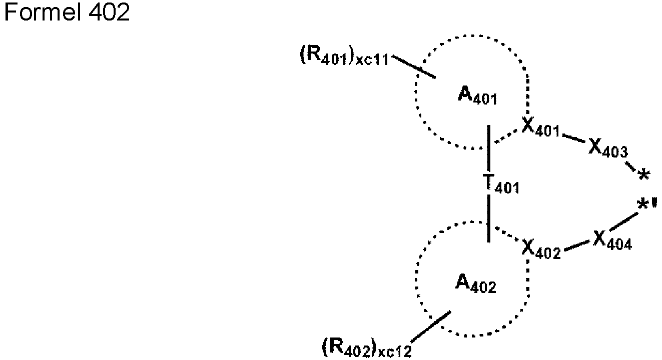
wobei in den Formeln 401 und 402
M ein Übergangsmetall ist,
L₄₀₁ ein Ligand ist, der durch die Formel 402 dargestellt ist, und xc1 1, 2 oder 3 ist, wobei, wenn xc1 2 oder mehr ist, zwei oder mehr von L₄₀₁ identisch sind oder sich voneinander unterscheiden,
L₄₀₂ ein organischer Ligand ist und xc2 0, 1, 2, 3 oder 4 ist, wobei, wenn xc2 2 oder mehr ist, zwei oder mehr von L₄₀₂ identisch sind oder sich voneinander unterscheiden,
X₄₀₁ und X₄₀₂ jeweils unabhängig Stickstoff oder Kohlenstoff sind,
Ring A₄₀₁ und Ring A₄₀₂ jeweils unabhängig eine carbocyclische C₃-C₆₀-Gruppe oder eine heterocyclische C₁-C₆₀-Gruppe sind,
T₄₀₁ eine Einfachbindung, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*' oder *=C=*' ist, wobei sich * und *' in T₄₀₁ jeweils auf eine Bindungsstelle zu einem benachbarten Atom beziehen,
X₄₀₃ und X₄₀₄ jeweils unabhängig eine chemische Bindung, O, S, N(Q₄₁₃), B(Q₄₁₃), P(Q₄₁₃), C(Q₄₁₃)(Q₄₁₄) oder Si(Q₄₁₃)(Q₄₁₄) sind,
R₄₀₁ und R₄₀₂ jeweils unabhängig Wasserstoff, Deuterium, -F, -Cl, -Br, -I, eine Hydroxylgruppe, eine Cyanogruppe, eine Nitrogruppe, eine C₁-C₂₀-Alkylgruppe, unsubstituiert oder substituiert mit mindestens einem R₁₀ₐ, eine C₁-C₂₀-Alkoxygruppe, unsubstituiert oder substituiert mit mindestens einem R₁₀ₐ, eine carbocyclische C₃-C₆₀-Gruppe, unsubstituiert oder substituiert mit mindestens einem R₁₀ₐ, eine heterocyclische C₁-C₆₀-Gruppe, unsubstituiert oder substituiert mit mindestens einem R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁) oder -P(=O)(Q₄₀₁)(Q₄₀₂) sind,
Q₄₁₁ bis Q₄₁₄ und Q₄₀₁ bis Q₄₀₃ jeweils unabhängig sind: Wasserstoff; Deuterium; -F; -Cl; -Br; -I; eine Hydroxylgruppe; eine Cyanogruppe; eine Nitrogruppe; eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, -F, einer Cyanogruppe oder einer Kombination davon; oder eine carbocyclische C₃-C₆₀-Gruppe oder eine heterocyclische C₁-C₆₀-Gruppe, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer beliebigen Kombination davon,
xc11 und xc12 jeweils unabhängig eine ganze Zahl von 0 bis 10 sind,
* und *' in Formel 402 jeweils eine Bindungsstelle an M in Formel 401 angeben, und
R₁₀ₐ Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, -F, -Cl, -Br, -I, einer Hydroxylgruppe, einer Cyanogruppe, einer Nitrogruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, einer C₇-C₆₀-Arylalkylgruppe, einer C₂-C₆₀-Heteroarylalkylgruppe, -Si(Q₁₁)(Q₁₂)(Q₁₃), -N(Q₁₁)(Q₁₂), -B(Q₁₁)(Q₁₂), -C(=O)(Q11), -S(=O)2(Q₁₁), -P(=O)(Q₁₁)(Q₁₂) oder einer beliebigen Kombination davon;
eine carbocyclische C₃-C₆₀-Gruppe, eine heterocyclische C₁-C₆₀-Gruppe, eine C₆-C₆₀-Aryloxygruppe, eine C₆-C₆₀-Arylthiogruppe, eine C₇-C₆₀-Arylalkylgruppe oder eine C₂-C₆₀-Heteroarylalkylgruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, einer C₇-C₆₀-Arylalkylgruppe, einer C₂-C₆₀-Heteroarylalkylgruppe,-Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁),-P(=O)(Q₂₁)(Q₂₂) oder einer beliebigen Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder-P(=O)(Q₃₁)(Q₃₂) ist, und
Q₁₁ bis Q₁₃, Q₂₁ bis Q₂₃ und Q₃₁ bis Q₃₃ jeweils unabhängig sein können: Wasserstoff; Deuterium; -F; -Cl; -Br; -I; eine Hydroxylgruppe; eine Cyanogruppe; eine Nitrogruppe; eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, -F, einer Cyanogruppe oder einer beliebigen Kombination davon; oder eine carbocyclische C₃-C₆₀-Gruppe, eine heterocyclische C₁-C₆₀-Gruppe, eine C₇-C₆₀-Arylalkylgruppe oder eine C₂-C₆₀-Heteroarylalkylgruppe, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer beliebigen Kombination davon.

15. Elektronische Vorrichtung (1), umfassend die lichtemittierende Vorrichtung nach einem der vorhergehenden Ansprüche.

## Revendications

1. Dispositif électroluminescent (10) comprenant :
une première électrode (110) ;
une seconde électrode (150) faisant face à la première électrode (110) ; et
une couche intermédiaire (130) entre la première électrode (110) et la seconde électrode (150) et comprenant une couche d'émission,
dans lequel la couche d'émission comprend i) un premier composé, un deuxième composé et un troisième composé, et
ii) un premier composé organométallique et un second composé organométallique,
le premier composé au troisième composé sont différents les uns des autres,
le premier composé organométallique et le second composé organométallique comprennent chacun indépendamment au moins un métal de transition,
le premier composé organométallique et le second composé organométallique sont différents l'un de l'autre, et
une différence entre une valeur absolue d'un niveau d'énergie (eV) d'orbitale moléculaire occupée la plus élevée (HOMO) du deuxième composé et une valeur absolue d'un niveau d'énergie (eV) HOMO du troisième composé est de 0,1 eV ou plus,
dans lequel le niveau d'énergie HOMO est évalué par un procédé de théorie fonctionnelle de la densité (DFT) utilisant une approche B3LYP avec un ensemble de base 6-31G*, et **caractérisé en ce que** le premier composé, le deuxième composé, le troisième composé, le premier composé organométallique et le second composé organométallique sont co-déposés.

2. Dispositif électroluminescent selon la revendication 1, dans lequel une énergie de bande interdite du troisième composé est de 4,3 eV ou plus.

3. Dispositif électroluminescent selon la revendication 1 ou 2, dans lequel une valeur absolue d'un niveau d'énergie (eV) HOMO du premier composé est inférieure à la valeur absolue du niveau d'énergie (eV) HOMO du troisième composé.

4. Dispositif électroluminescent selon l'une quelconque des revendications précédentes, dans lequel, sur la base du poids, une quantité du premier composé est supérieure à une quantité du deuxième composé, et
la quantité du deuxième composé est supérieure à une quantité du troisième composé.

5. Dispositif électroluminescent selon l'une quelconque des revendications précédentes, dans lequel l'au moins un métal de transition est l'iridium (Ir), le platine (Pt), le palladium (Pd), le cuivre (Cu), l'argent (Ag), l'or (Au), le rhodium (Rh), le ruthénium (Ru), l'osmium (Os), le titane (Ti), le zirconium (Zr), le hafnium (Hf), l'europium (Eu), le terbium (Tb) ou le thulium (Tm).

6. Dispositif électroluminescent selon l'une quelconque des revendications précédentes, dans lequel une longueur d'onde d'émission maximale du premier composé organométallique est supérieure à une longueur d'onde d'émission maximale du second composé organométallique.

7. Dispositif électroluminescent selon l'une quelconque des revendications précédentes, dans lequel une valeur absolue d'un niveau d'énergie (eV) HOMO du premier composé organométallique est inférieure à la valeur absolue d'un niveau d'énergie (eV) HOMO du second composé organométallique.

8. Dispositif électroluminescent selon l'une quelconque des revendications précédentes, dans lequel un niveau d'énergie T1 (eV) du premier composé organométallique est inférieur à un niveau d'énergie (eV) T1 du second composé organométallique.

9. Dispositif électroluminescent selon l'une quelconque des revendications précédentes, dans lequel une différence entre une valeur absolue d'un niveau d'énergie (eV) HOMO du premier composé organométallique et une valeur absolue d'un niveau d'énergie (eV) HOMO du second composé organométallique est de 0,05 eV ou plus.

10. Dispositif électroluminescent selon l'une quelconque des revendications précédentes, dans lequel une quantité du premier composé organométallique est supérieure à une quantité du second composé organométallique, sur la base du poids.

11. Dispositif électroluminescent selon l'une quelconque des revendications précédentes, dans lequel le premier composé comprend un groupe représenté par la formule 3 : 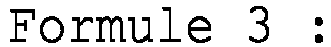 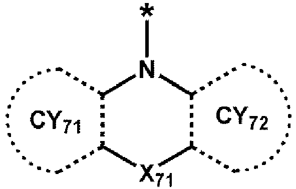
dans lequel, dans la formule 3, le cycle CY₇₁ et le cycle CY₇₂ sont chacun indépendamment un groupe cyclique en C₃-C₆₀ riche en électrons π ou un groupe pyridine,
X₇₁ dans la formule 3 est une liaison unique ou un groupe de liaison comprenant O, S, N, B, C, Si ou toute combinaison de ceux-ci, et
* dans la formule 3 indique un site de liaison à un atome voisin dans le premier composé.

12. Dispositif électroluminescent selon l'une quelconque des revendications précédentes, dans lequel le deuxième composé comprend un groupe cyclique en C₁-C₆₀ contenant de l'azote déficient en électrons n, en particulier un groupe pyridine, un groupe pyrimidine, un groupe pyrazine, un groupe pyridazine, un groupe triazine, ou toute combinaison de ceux-ci.

13. Dispositif électroluminescent selon l'une quelconque des revendications précédentes, dans lequel le troisième composé comprend un groupe triphénylène.

14. Dispositif électroluminescent selon l'une quelconque des revendications précédentes, dans lequel le premier composé organométallique et le second composé organométallique comprennent chacun indépendamment un composé représenté par la formule 401 :
Formule 401 M(L₄₀₁)_{xc1}(L₄₀₂)_{xc2} 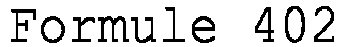 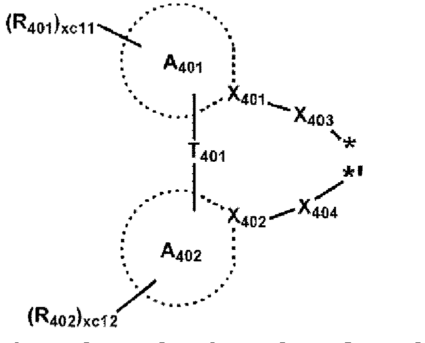
dans lequel, dans les formules 401 et 402,
M est un métal de transition,
L₄₀₁ est un ligand représenté par la formule 402, et xc1 est 1, 2, ou 3, dans lequel, lorsque xc1 est égal à 2 ou plus, deux ou plus de L₄₀₁ sont identiques ou différents les uns des autres,
L₄₀₂ est un ligand organique, et xc2 est 0, 1, 2, 3, ou 4, dans lequel, lorsque xc2 est égal à 2 ou plus, deux ou plusieurs de L₄₀₂ sont identiques ou différents les uns des autres,
X₄₀₁ et X₄₀₂ sont chacun indépendamment de l'azote ou du carbone,
le cycle A₄₀₁ et le cycle A₄₀₂ sont chacun indépendamment un groupe carbocyclique en C₃-C₆₀ ou un groupe hétérocyclique en C₁-C₆₀,
T₄₀₁ est une liaison unique, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', ou *=C=*', dans lequel * et *' dans T₄₀₁ se réfèrent chacun à un site de liaison à un atome voisin,
X₄₀₃ et X₄₀₄ sont chacun indépendamment une liaison chimique, O, S, N(Q ₄₁₃), B(Q₄₁₃), P(Q₄₁₃), C(Q₄₁₃)(Q₄₁₄), ou Si(Q₄₁₃)(Q₄₁₄),
R₄₀₁ et R₄₀₂ sont chacun indépendamment hydrogène, deutérium, -F, -Cl, -Br, -I, un groupe hydroxyle, un groupe cyano, un groupe nitro, un groupe alkyle en C₁-C₂₀ non substitué ou substitué par au moins un R₁₀ₐ, un groupe alcoxy en C₁-C₂₀ non substitué ou substitué par au moins un R₁₀ₐ, un groupe carbocyclique en C₃-C₆₀ non substitué ou substitué par au moins un R₁₀ₐ, un groupe hétérocyclique en C₁-C₆₀ non substitué ou substitué par au moins un R₁₀ₐ,-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), ou -P(=O)(Q₄₀₁)(Q₄₀₂),
Q₄₁₁ à Q₄₁₄ et Q₄₀₁ à Q₄₀₃ sont chacun indépendamment : hydrogène ; deutérium ; -F ; -Cl ; -Br ; -I ; un groupe hydroxyle ; un groupe cyano ; un groupe nitro ; un groupe alkyle en C₁-C₆₀, un groupe alcényle en C₂-C₆₀, un groupe alcynyle en C₂-C₆₀, ou un groupe alcoxy en C₁-C₆₀, chacun non substitué ou substitué par du deutérium, -F, un groupe cyano ou toute combinaison de ceux-ci ; ou un groupe carbocyclique en C₃-C₆₀ ou un groupe hétérocyclique en C₁-C₆₀, chacun non substitué ou substitué par du deutérium, du -F, un groupe cyano, un groupe alkyle en C₁-C₆₀, un groupe alcoxy en C₁-C₆₀, un groupe phényle, un groupe biphényle, ou toute combinaison de ceux-ci,
xc11 et xc12 sont chacun indépendamment un nombre entier de 0 à 10,
* et *' dans la formule 402 indiquent chacun un site de liaison à M dans la formule 401, et
R₁₀ₐ est deutérium, -F, -Cl, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀, ou un groupe alcoxy en C₁-C₆₀, chacun non substitué ou substitué par du deutérium, -F, -Cl, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, un groupe arylalkyle en C₇-C₆₀, un groupe hétéroarylalkyle en C₂-C₆₀, -Si(Q₁₁)(Q₁₂)(Q₁₃),-N(Q₁₁)(Q₁₂), -B(Q₁₁)(Q₁₂), -C(=O) (Q₁₁), -S(=O)2(Q₁₁),-P(=O)(Q₁₁)(Q₁₂), ou toute combinaison de ceux-ci ;
un groupe carbocyclique en C₃-C₆₀, un groupe hétérocyclique en C₁-C₆₀, un groupe aryloxy en C₆-C₆₀, un groupe arylthio en C₆-C₆₀, un groupe arylalkyle en C₇-C₆₀, ou un groupe hétéroarylalkyle en C₂-C₆₀, chacun non substitué ou substitué par du deutérium, -F, -Cl, -Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, un groupe arylalkyle en C₇-C₆₀, un groupe hétéroarylalkyle en C₂-C₆₀,-Si(Q₂₁)(Q₂₂)(Q₂₃), -N(Q₂₁)(Q₂₂), -B(Q₂₁)(Q₂₂), -C(=O)(Q₂₁),-S(=O)₂(Q₂₁), -P(=O)(Q₂₁)(Q₂₂), ou toute combinaison de ceux-ci ; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou-P(=O)(Q₃₁)(Q₃₂), et
Q₁₁ à Q₁₃, Q₂₁ à Q₂₃, et Q₃₁ à Q₃₃ peuvent chacun être indépendamment : hydrogène ; deutérium ; -F ; -Cl ; -Br ; - I ; un groupe hydroxyle ; un groupe cyano ; un groupe nitro ; un groupe alkyle en C₁-C₆₀, un groupe alcényle en C₂-C₆₀, un groupe alcynyle en C₂-C₆₀, ou un groupe alcoxy en C₁-C₆₀, chacun non substitué ou substitué par du deutérium, -F, un groupe cyano, ou toute combinaison de ceux-ci ; ou un groupe carbocyclique en C₃-C₆₀, un groupe hétérocyclique en C₁-C₆₀, un groupe arylalkyle en C₇-C₆₀ ou un groupe hétéroarylalkyle en C₂-C₆₀, chacun non substitué ou substitué par du deutérium, -F, un groupe cyano, un groupe alkyle en C₁-C₆₀, un groupe alcoxy en C₁-C₆₀, un groupe phényle, un groupe biphényle, ou toute combinaison de ceux-ci.

15. Appareil électronique (1) comprenant le dispositif électroluminescent selon l'une quelconque des revendications précédentes.
